# EUROPEAN PATENT SPECIFICATION

(11) **EP 4 395 497 B1**
(45) Date of publication and mention of the grant of the patent: **25.11.2026**
(21) Application number: 23219657.6
(22) Date of filing: 22.12.2023
(51) Int. Cl.: H10K 50/11, H10K 50/15, H10K 101/10, H10K 101/30, H10K 101/40, H10K 85/30, H10K 85/40, H10K 85/60

(54) **LIGHT-EMITTING DEVICE, ELECTRONIC DEVICE INCLUDING THE SAME, AND ELECTRONIC APPARATUS INCLUDING THE LIGHT-EMITTING DEVICE**
LICHTEMITTIERENDE VORRICHTUNG, ELEKTRONISCHE VORRICHTUNG DAMIT UND ELEKTRONISCHE VORRICHTUNG MIT DER LICHTEMITTIERENDEN VORRICHTUNG
DISPOSITIF ÉLECTROLUMINESCENT, DISPOSITIF ÉLECTRONIQUE LE COMPRENANT ET APPAREIL ÉLECTRONIQUE COMPRENANT LE DISPOSITIF ÉLECTROLUMINESCENT

(30) Priority: 30.12.2022 KR 20220191074; 21.12.2023 KR 20230187956
(43) Date of publication of application: 03.07.2024
(73) Proprietor: Samsung Display Co., Ltd., Yongin-si, Gyeonggi-do 17113 (KR)
(72) Inventor: Kim, Gyeongheon, 17113 Giheung-gu, Yongin-si, Gyeonggi-do (KR); Jang, Eunhwa, 17113 Giheung-gu, Yongin-si, Gyeonggi-do (KR); Kim, Sohae, 17113 Giheung-gu, Yongin-si, Gyeonggi-do (KR); Kim, Jihye, 17113 Giheung-gu, Yongin-si, Gyeonggi-do (KR); Park, Saerom, 17113 Giheung-gu, Yongin-si, Gyeonggi-do (KR); Yoo, Dongsun, 17113 Giheung-gu, Yongin-si, Gyeonggi-do (KR); Cho, Jintaek, 17113 Giheung-gu, Yongin-si, Gyeonggi-do (KR)
(74) Representative: Dr. Weitzel & Partner

(56) References cited:
- EP-B1- 2 435 399
- US-B2- 10 388 900
- US-B2- 11 072 623
- US-B2- 11 145 837
- XU JING ET AL: "The Effects of Different Solvents and Excitation Wavelength on the Photophysical Properties of Two Novel Ir(III) Complexes Based on Phenylcinnoline Ligand", vol. 23, no. 5, 9 May 2013 (2013-05-09), New York, pages 865 - 875, XP055795873, ISSN: 1053-0509, Retrieved from the Internet <URL:http://link.springer.com/article/10.1007/s10895-013-1229-3/fulltext.html> DOI: 10.1007/s10895-013-1229-3
- JUNG-HWAN PARK ET AL: "New Bipolar Green Host Materials Containing Benzimidazole-Carbazole Moiety in Phosphorescent OLEDs", BULLETIN OF THE KOREAN CHEMICAL SOCIETY, vol. 32, no. 3, 20 March 2011 (2011-03-20), pages 841 - 846, XP055191890, ISSN: 0253-2964, DOI: 10.5012/bkcs.2011.32.3.841
- NAMDAS EBINAZAR ET AL: "Simple color tuning of phosphorescent dendrimer light emitting diodes", APPLIED PHYSICS LETTERS, AMERICAN INSTITUTE OF PHYSICS, 2 HUNTINGTON QUADRANGLE, MELVILLE, NY 11747, vol. 86, no. 16, 11 April 2005 (2005-04-11), pages 161104 - 161104, XP012065079, ISSN: 0003-6951, DOI: 10.1063/1.1899256
- SUNGWON YOON: "Enhanced deep red to near-infrared (DR-NIR)phosphorescence in cyclometalated iridium(III)complexes", vol. 9, no. 24, 8 November 2022 (2022-11-08), pages 6544 - 6553, XP093166009, ISSN: 2052-1553, Retrieved from the Internet <URL:http://pubs.rsc.org/en/content/articlepdf/2022/QI/D2QI02058K> DOI: 10.1039/D2QI02058K
- JIANG BEI ET AL: "Deep-red iridium(<scp>iii</scp>) complexes cyclometalated by phenanthridine derivatives for highly efficient solution-processed organic light-emitting diodes", JOURNAL OF MATERIALS CHEMISTRY C, vol. 4, no. 16, 1 January 2016 (2016-01-01), GB, pages 3492 - 3498, XP093388688, ISSN: 2050-7526, DOI: 10.1039/c6tc00148c
- ZHANG YOUMING ET AL: "Iridium(III) Complexes with [-2, -1, 0] Charged Ligand Realized Deep-Red/Near-Infrared Phosphorescent Emission", CHEMISTRY - A EUROPEAN JOURNAL, vol. 28, no. 2, 23 November 2021 (2021-11-23), DE, XP093388611, ISSN: 0947-6539, DOI: 10.1002/chem.202103543

## Description

### BACKGROUND

### 1. Field

One or more embodiments of the present invention relate to a light-emitting device, an electronic device including the light emitting device, and an electronic apparatus including the light-emitting device.

### 2. Description of the Related Art

Self-emissive devices (for example, organic light-emitting devices) are light-emitting devices that have relatively wide viewing angles, high contrast ratios, short response times, and excellent or suitable characteristics in terms of luminance, driving voltage, and response speed.

In a light-emitting device, a first electrode is arranged on a substrate, and a hole transport region, an emission layer, an electron transport region, and a second electrode are sequentially arranged on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. These excitons transit (and decay) from an excited state to a ground state, thereby generating light.
US 11 072 623 B2 discloses a light-emitting element including a first organic compound, a second organic compound, and a guest material. The HOMO level of the first organic compound is lower than that of the second organic compound. The HOMO level of the guest material is higher than that of the second organic compound. An energy difference between the LUMO level and the HOMO level of the guest material is larger than an energy difference between the LUMO level of the first organic compound and the HOMO level of the second organic compound. The guest material can convert triplet excitation energy into light emission. The combination of first organic compound and the second organic compound can form an exciplex. The guest material Ir(tpppr)₂(dpm) has a HOMO energy level of -5.57 eV.

Jiang Bei ET AL: "Deep-red iridium( scpiii /scp) complexes cyclometalated by phenanthridine derivatives for highly efficient solution-processed organic light-emitting diodes", Journal of Materials Chemistry C, vol. 4, no. 16, 1 January 2016, pages 3492-3498 discloses an OLED with the following configuration: ITO / PEDOT:PSS / PVK:PBD: dopants /TPBi /Ca /Al, wherein the dopants are selected from (TP-BQ)₂Ir(acac) and (TPA-BQ)₂Ir(acac) having a HOMO energy level between -5.26 eV to -4.72 eV.

Zhang Youming ET AL: "Iridium(III) Complexes with [-2, -1, 0] Charged Ligand Realized Deep-Red/Near-Infrared Phosphorescent Emission", Chemistry - A European Journal, vol. 28, no. 2, 23 November 2021, discloses an OLED with the following configuration: ITO / MoO₃ / TAPC / Ir(lll) complex in CBP / B3PYMPM LiF / Al, wherein the Ir(lll) complex is selected from complexes 1-5, wherein a HOMO energy level of complexes 1-5 is between -5.26 eV to -4.72 eV.

### SUMMARY

The present invention is defined by the features of claim 1. The dependent claims describe preferred embodiments.

One or more aspects of embodiments of the present invention are directed toward a light-emitting device with low driving voltage and high power efficiency, an electronic device including the light-emitting device, and an electronic apparatus including the light-emitting device.

Additional aspects will be set forth in part in the description which follows and, in part, will be apparent from the description, or may be learned by practice of the presented embodiments of the invention.

According to one or more embodiments of the present invention, a light-emitting device includes:
a first electrode;
a second electrode facing the first electrode; and
an interlayer between the first electrode and the second electrode, wherein:
the interlayer includes a hole transport region and an emission layer,
the hole transport region is between the first electrode and the emission layer,
the hole transport region includes a first layer,
the first layer is in direct contact with the emission layer,
the emission layer includes a first host and a first emitter,
the first emitter is to emit first light having a first emission spectrum,
a peak emission wavelength of the first light is about 610 nm to about 720 nm,
the first layer includes a first material,
an absolute value of a highest occupied molecular orbital (HOMO) energy level of the first material may be greater than an absolute value of a HOMO energy level of the first host,
an absolute value of a HOMO energy level of the first emitter may be greater than the absolute value of the HOMO energy level of the first host, and
the HOMO energy level of each of the first material, the first host, and the first emitter is measured by cyclic voltammetry and is a negative value,
the HOMO energy level of the first emitter is about -5.26 eV to about -4.72 eV.

According to one or more embodiments of the present invention, an electronic device includes the light-emitting device.

According to one or more embodiments of the present invention, an electronic apparatus includes the light-emitting device.

### BRIEF DESCRIPTION OF THE DRAWINGS

The accompanying drawings are included to provide a further understanding of the present invention and are incorporated in and constitute a part of the present invention. The drawings illustrate embodiments of the present invention and, together with the description, serve to explain principles of the present invention. The above and other aspects, features, and advantages of certain embodiments of the invention will be more apparent from the following description taken in conjunction with the accompanying drawings, in which:
FIG. 1 is a schematic view of a structure of a light-emitting device according to one or more embodiments of the present invention;
FIGs. 2 and 3 are each a schematic view schematically showing a structure of a light-emitting apparatus that is a part of or is an electronic device (e.g., one of electronic devices), according to one or more embodiments of the present invention; and
FIGs. 4, 5, 6A, 6B, and 6C are each a schematic view of a structure of an electronic apparatus according to one or more embodiments of the present invention.

### DETAILED DESCRIPTION

Reference will now be made in more detail to embodiments, examples of which are illustrated in the accompanying drawings, wherein like reference numerals refer to like elements throughout the present disclosure, and duplicative descriptions thereof may not be provided for conciseness. In this regard, the embodiments of the present disclosure may have different forms and should not be construed as being limited to the descriptions set forth herein. Accordingly, the embodiments of the present invention are merely described, by referring to the drawings, to explain aspects of the present invention. As utilized herein, the term "and/or" or "or" may include any and all combinations of one or more of the associated listed items. Throughout the disclosure, the expressions such as "at least one of," "one of," and "selected from," when preceding a list of elements, modify the entire list of elements and do not modify the individual elements of the list. For example, "at least one of a, b or c", "at least one selected from a, b, and c", "at least one selected from among a to c", etc., may indicate only a, only b, only c, both (e.g., simultaneously) a and b, both (e.g., simultaneously) a and c, both (e.g., simultaneously) b and c, all of a, b, and c, or variations thereof. The "/" utilized herein may be interpreted as "and" or as "or" depending on the situation.

According to one or more embodiments of the present invention, a light-emitting device may include: a first electrode; a second electrode facing the first electrode; and an interlayer between the first electrode and the second electrode.

The interlayer may include a hole transport region and an emission layer, and the hole transport region may be between the first electrode and the emission layer.

The hole transport region may include a first layer, and the first layer may be in direct contact with the emission layer.

For example, in one or more embodiments, in the light-emitting device, the first electrode, first layer, the emission layer, and the second electrode may be sequentially stacked (e.g., in the stated order).

The emission layer includes a first host and a first emitter, and the first emitter may be to emit first light having a first emission spectrum.

A peak emission wavelength (e.g., maximum emission wavelength, or maximum peak emission wavelength) of the first light is about 610 nm to about 720 nm, preferably it may be about 610 nm to about 700 nm, about 610 nm to about 680 nm, about 614 nm to about 680 nm, about 614 nm to about 650 nm, or about 614 nm to about 629 nm.

According to one or more embodiments, the first light may be red light.

The first layer includes a first material.

An absolute value of a highest occupied molecular orbital (HOMO) energy level of the first material is greater than an absolute value of a HOMO energy level of the first host.

For example, in one or more embodiments, an absolute value of a difference between the HOMO energy level of the first material and the HOMO energy level of the first host may be about 0.01 eV (electron Volt) to about 0.7 eV, about 0.01 eV to about 0.6 eV, about 0.1 eV to about 0.7 eV, about 0.1 eV to about 0.6 eV, about 0.3 eV to about 0.7 eV, about 0.3 eV to about 0.6 eV, or about 0.48 eV to about 0.6 eV.

According to one or more embodiments, the HOMO energy level of the first material may be about -5.60 eV to about -5.15 eV, about -5.50 eV to about -5.15 eV, about -5.40 eV to about -5.15 eV, about -5.60 eV to about -5.25 eV, about -5.50 eV to about -5.25 eV, about -5.40 eV to about -5.25 eV, about -5.60 eV to about -5.30 eV, about -5.50 eV to about -5.30 eV, about -5.40 eV to about -5.30 eV, or about -5.40 eV to about -5.33 eV.

According to one or more embodiments, a hole mobility of the first material may be about 1.00 x 10⁻⁴ cm²/(Vs) (or, cm²/Vs) to about 5.00 x 10⁻³ cm²/(Vs), about 1.68 x 10⁻⁴ cm²/(Vs) to about 2.01 x 10⁻³ cm²/(Vs), or about 1.68 x 10⁻⁴ cm²/(Vs) to about 1.77 x 10⁻³ cm²/(Vs).

Each of the hole mobility and the electron mobility of a third material, a second material, the first material, the first host, a material for a buffer layer, and a material for an electron transport layer may be measured utilizing a space-charge-limited current (SCLC) method described in "hole mobility of N,N'-bis(naphthalen-1-yl)-N,N'-bis(phenyl)benzidine investigated by utilizing space-charge-limited currents, Appl. Phys. Lett. 90, 203512 (2007)," which is incorporated in entirety herein by reference.

An absolute value of a lowest unoccupied molecular orbital (LUMO) energy level of the first material may be smaller than an absolute value of a LUMO energy level of the first host, and the LUMO energy level of each of the first material and the first host may be measured by cyclic voltammetry and may be a negative value.

For example, in one or more embodiments, the LUMO energy level of the first material may be about -2.40 eV to about -1.00 eV, or about -2.23 eV to about -1.09 eV.

According to one or more embodiments, the HOMO energy level of the first host may be about -5.07 eV to about -4.60 eV, about -5.07 eV to about -4.70 eV, about -4.90 eV to about -4.70 eV, or about -4.87 eV to about -4.80 eV.

According to one or more embodiments, a hole mobility of the first host may be about 1.00 x 10⁻⁵ cm²/(Vs) to about 5.00 x 10⁻³ cm²/(Vs), about 1.28 x 10⁻⁵ cm²/(Vs) to about 1.03 x 10⁻³ cm²/(Vs), or about 5.18 x 10⁻⁵ cm²/(Vs) to about 5.46 x 10⁻⁴ cm²/(Vs).

According to one or more embodiments, the LUMO energy level of the first host may be about -2.20 eV to about -1.80 eV, or about -2.06 eV to about -1.92 eV.

According to one or more embodiments, an electron mobility of the first host may be about 1.00 x 10⁻⁸ cm²/(Vs) to about 5.00 x 10⁻⁴ cm²/(Vs), about 1.24 x 10⁻⁸ cm²/(Vs) to about 1.55 x 10⁻⁴ cm²/(Vs), or about 3.33 x 10⁻⁶ cm²/(Vs) to about 1.55 x 10⁻⁴ cm²/(Vs).

An absolute value of a HOMO energy level of the first emitter is greater than the absolute value of the HOMO energy level of the first host.

For example, in one or more embodiments, an absolute value of a difference between the HOMO energy level of the first emitter and the HOMO energy level of the first host may be about 0.01 eV to about 1.00 eV, about 0.01 eV to about 0.7 eV, about 0.01 eV to about 0.5 eV, about 0.01 eV to about 0.3 eV, about 0.01 eV to about 0.26 eV, about 0.05 eV to about 0.5 eV, about 0.05 eV to about 0.3 eV, or about 0.05 eV to about 0.26 eV.

With respect to the light-emitting device, 1) the peak emission wavelength of the first light is be about 610 nm to about 720 nm, 2) the absolute value of the HOMO energy level of the first material is greater than the absolute value of the HOMO energy level of the first host, 3) the absolute value of the HOMO energy level of the first emitter is greater than the absolute value of the HOMO energy level of the first host, and 4) the HOMO energy level of the first emitter is about -5.26 eV to about -4.72 eV. As a result, hole injection from the first electrode to the emission layer may be smoothly performed and excitons may be effectively formed in the emission layer, and thus, the driving voltage and power efficiency characteristics of the light-emitting device may be improved.

According to one or more embodiments, the hole transport region may further include a second layer and a third layer, the second layer may be between the first electrode and the first layer, the third layer may be between the first electrode and the second layer, the second layer may include a second material, and the third layer may include a third material. For example, in some embodiments, the light-emitting device may further include a second layer and a third layer, and may have a structure in which the first electrode, the third layer, the second layer, the first layer, the emission layer, and the second electrode are sequentially stacked (e.g., in the stated order). In this regard, the first material, the second material, and the third material may be different from each other.

In one or more embodiments, the light-emitting device may satisfy:
the condition of a HOMO energy level of the third material > a HOMO energy level of the second material > the HOMO energy level of the first material, or
the condition of the HOMO energy level of the third material > the HOMO energy level of the first material > the HOMO energy level of the second material.

According to one or more embodiments, the HOMO energy level of the second material may be about -5.47 eV to about -5.00 eV, about -5.40 eV to about - 5.00 eV, about -5.30 eV to about -5.00 eV, about -5.47 eV to about -5.10 eV, about - 5.40 eV to about -5.10 eV, about -5.30 eV to about -5.10 eV, about -5.47 eV to about - 5.20 eV, about -5.40 eV to about -5.20 eV, about -5.30 eV to about -5.20 eV, or about - 5.27 eV to about -5.20 eV.

According to one or more embodiments, a hole mobility of the second material may be about 1.00 x 10⁻⁴ cm²/(Vs) to about 5.00 x 10⁻³ cm²/(Vs), about 3.01 x 10⁻⁴ cm²/(Vs) to about 1.97 x 10⁻³ cm²/(Vs), or about 3.01 x 10⁻⁴ cm²/(Vs) to about 1.79 x 10⁻³ cm²/(Vs).

According to one or more embodiments, a LUMO energy level of the second material may be about -2.30 eV to about -1.10 eV or about -2.18 eV to about -1.22 eV.

According to one or more embodiments, the HOMO energy level of the third material may be about -5.33 eV to about -4.91 eV, about -5.33 eV to about -5.00 eV, about -5.33 eV to about -5.10 eV, about -5.20 eV to about -4.91 eV, about -5.20 eV to about -5.00 eV, about -5.20 eV to about -5.10 eV, or about -5.13 eV to about -5.10 eV.

According to one or more embodiments, a hole mobility of the third material may be about 1.00 x 10⁻⁴ cm²/(Vs) to about 7.00 x 10⁻³ cm²/(Vs), about 1.22 x 10⁻⁴ cm²/(Vs) to about 5.32 x 10⁻³ cm²/(Vs), or about 1.28 x 10⁻⁴ cm²/(Vs) to about 1.15 x 10⁻³ cm²/(Vs).

According to one or more embodiments, a LUMO energy level of the third material may be about -1.70 eV to about -1.10 eV or about -1.60 eV to about -1.27 eV.

According to one or more embodiments, an absolute value of a difference between the HOMO energy level of the third material and the HOMO energy level of the second material may be about 0.05 eV to about 0.70 eV, or about 0.08 eV to about 0.15 eV.

According to one or more embodiments, an absolute value of a difference between the HOMO energy level of the second material and the HOMO energy level of the first material may be about 0.05 eV to about 0.70 eV, or about 0.07 eV to about 0.15 eV.

The HOMO energy level utilized herein may be measured by cyclic voltammetry and may be a negative value. For example, Evaluation Example 1 may be referred to as an example of the method for measuring the HOMO energy level of a material.

In one or more embodiments, the hole transport region including the first layer and, optionally, the second and/or third layers may further include a p-dopant. The p-dopant may be understood by referring to the following description.

The HOMO energy level of the first emitter in the emission layer may be about -5.26 eV to about -4.72 eV, about -5.26 eV to about -4.80 eV, about -5.26 eV to about -4.90 eV, about -5.00 eV to about -4.72 eV, about -5.00 eV to about -4.80 eV, about -5.00 eV to about -4.90 eV, or about -5.06 eV to about -4.92 eV.

In one or more embodiments, a LUMO energy level of the first emitter of the emission layer may be about -2.40 eV to about -2.00 eV, or about -2.18 eV to about - 2.01 eV.

A triplet (T₁) energy of the first emitter may be about 1.80 eV to about 2.30 eV or about 1.97 eV to about 2.1 eV.

For a method of evaluating the triplet energy of the first emitter, for example, Evaluation Example 1 of the present disclosure may be referred to.

A full width at half maximum (FWHM) of the first light may be about 15 nm to about 90 nm.

For example, in one or more embodiments, the FWHM of the first light may be about 20 nm to about 85 nm, about 25 nm to about 85 nm, about 30 nm to about 85 nm, about 35 nm to about 85 nm, about 40 nm to about 85 nm, about 45 nm to about 85 nm, about 50 nm to about 85 nm, about 15 nm to about 80 nm, about 20 nm to about 80 nm, about 25 nm to about 80 nm, about 30 nm to about 80 nm, about 35 nm to about 80 nm, about 40 nm to about 80 nm, about 45 nm to about 80 nm, about 50 nm to about 80 nm, about 15 nm to about 75 nm, about 20 nm to about 75 nm, about 25 nm to about 75 nm, about 30 nm to about 75 nm, about 35 nm to about 75 nm, about 40 nm to about 75 nm, about 45 nm to about 75 nm, about 50 nm to about 75 nm, about 15 nm to about 70 nm, about 20 nm to about 70 nm, about 25 nm to about 70 nm, about 30 nm to about 70 nm, about 35 nm to about 70 nm, about 40 nm to about 70 nm, about 45 nm to about 70 nm, about 50 nm to about 70 nm, about 15 nm to about 65 nm, about 20 nm to about 65 nm, about 25 nm to about 65 nm, about 30 nm to about 65 nm, about 35 nm to about 65 nm, about 40 nm to about 65 nm, about 45 nm to about 65 nm, about 50 nm to about 65 nm, about 15 nm to about 60 nm, about 20 nm to about 60 nm, about 25 nm to about 60 nm, about 30 nm to about 60 nm, about 35 nm to about 60 nm, about 40 nm to about 60 nm, about 45 nm to about 60 nm, or about 50 nm to about 60 nm.

The peak emission wavelength (or maximum emission wavelength) and FWHM of the first light described in the present disclosure are evaluated from an emission spectrum of a film including the first emitter (for example, refer to Evaluation Example 2). The peak emission wavelength in the present disclosure refers to the peak wavelength having the maximum emission intensity in the emission spectrum or electroluminescence spectrum.

In one or more embodiments, the first emitter may be a transition metal-containing organometallic compound.

In one or more embodiments, the first emitter may include iridium.

In one or more embodiments, the first emitter may be an organometallic compound containing iridium. The first emitter may be neutral, may include one iridium, and may not include (e.g., may exclude or be free of) transition metals other than iridium.

According to one or more embodiments, the first emitter may be a transition metal-containing organometallic compound, the transition metal may be iridium, the first emitter may include a first ligand, a second ligand, and a third ligand which are bonded to the iridium, the first ligand may be a bidentate ligand including a Y₁-containing ring B₁ and a Y₂-containing ring B₂, the second ligand may be a bidentate ligand including a Y₃-containing ring B₃ and a Y₄-containing ring B₄, or a bidentate ligand which is bonded to iridium through two oxygen atoms, the third ligand may be a bidentate ligand including a Y₅-containing ring B₅ and a Y₆-containing ring B₆, each of Y₁, Y₃ and Y₅ may be nitrogen ( N), and each of Y₂, Y₄ and Y₆ may be carbon (C), at least one selected from among the Y₁-containing ring B₁ and the Y₅-containing ring B₅ (for example, each of Y₁-containing ring B₁ and Y₅-containing ring B₅) may be a polycyclic group in which three or more cyclic groups are condensed with each other.

In one or more embodiments, at least one selected from among the Y₁-containing ring B₁ and the Y₅-containing ring B₅ (for example, each of the Y₁-containing ring B₁ and the Y₅-containing ring B₅) may be a benzoquinoline group, a benzoisoquinoline group, a naphthoquinoline group, or a naphthoisoquinoline group.

According to one or more embodiments, the Y₃-containing ring B₃ may be a pyridine group, a pyrimidine group, a pyrazine group, a pyridazine group, a triazine group, a quinoline group, or an isoquinoline group.

According to one or more embodiments, the Y₂-containing ring B₂, Y₄-containing ring B₄, and Y₆-containing ring B₆ may each independently be a benzene group, a naphthalene group, a phenanthrene group, a furan group, a thiophene group, a selenophene group, a pyrrole group, a cyclopentadiene group, a silole group, a benzofuran group, a benzothiophene group, a benzoselenophene group, an indole group, an indene group, a benzosilole group, a dibenzofuran group, a dibenzothiophene group, a dibenzoselenophene group, a carbazole group, a fluorene group, or a dibenzosilole group.

In one or more embodiments, the first emitter may be a heteroleptic complex.

In one or more embodiments, the third ligand may be the same as the first ligand.

According to one or more embodiments, the third ligand may be different from the first ligand.

According to one or more embodiments, the first emitter may include at least one fluoro group (-F).

According to one or more embodiments, the first emitter may include at least one deuterium.

In one or more embodiments, the first emitter may include a deuterated C₁-C₂₀ alkyl group, a deuterated C₃-C₁₀ cycloalkyl group, or a combination thereof.

According to one or more embodiments, at least one selected from among the first, second, and third ligands may include at least one fluoro group (-F).

According to one or more embodiments, each of the first and third ligands may include at least one fluoro group (-F).

In one or more embodiments, at least one selected from among the first ligand, the second ligand, and the third ligand may include at least one deuterium.

In one or more embodiments, at least one selected from among the first ligand, the second ligand, and the third ligand may include a deuterated C₁-C₂₀ alkyl group, a deuterated C₃-C₁₀ cycloalkyl group, or a combination thereof.

More details for the first emitter are as described herein.

According to one or more embodiments, the first host may include at least one deuterium.

According to one or more embodiments, the first host may include an amine-containing compound.

According to one or more embodiments, the first host may include at least one silicon (Si).

According to one or more embodiments, the first host may include an amine-containing compound including a silyl group that is unsubstituted or substituted with deuterium, a C₁-C₁₀ alkyl group, a phenyl group, a biphenyl group, or one or more combinations thereof.

According to one or more embodiments, the first host may include an amine-containing compound including:
i) a silyl group unsubstituted or substituted with deuterium, a C₁-C₁₀ alkyl group, a phenyl group, a biphenyl group, or one or more combinations thereof; and
ii) a triazine group, a carbazole group, or a combination thereof.

According to one or more embodiments, the first host (or a hole-transporting compound to be described later) may include an amine-containing compound including:
i) a silyl group unsubstituted or substituted with deuterium, a C₁-C₁₀ alkyl group, a phenyl group, a biphenyl group, or one or more combinations thereof; and
ii) a fluorene group, an anthracene group, a phenanthrene group, or one or more combinations thereof.

According to one or more embodiments, the first host may include an amine-containing compound including a carbazole group, a dibenzofuran group, a dibenzothiophene group, a triazine group, or one or more combinations thereof.

According to one or more embodiments, the first host may include an amine-containing compound including:
i) a carbazole group, a dibenzofuran group, a dibenzothiophene group, or one or more combinations thereof; and
ii) a triazine group, a carbazole group, or a combination thereof.

In one or more embodiments, the first host may be an electron-transporting compound, a hole-transporting compound, a bipolar compound, or one or more combinations thereof. The first host may not contain metal. The electron-transporting compound, the hole-transporting compound, and the bipolar compound are different from each other.

For example, in one or more embodiments, the electron-transporting compound may include at least one π electron-deficient nitrogen-containing C₁-C₆₀ cyclic group. For example, in some embodiments, the electron-transporting compound may include a pyridine group, a pyrimidine group, a pyrazine group, a pyridazine group, a triazine group, or one or more combinations thereof.

As another example, in one or more embodiments, the first host may be the electron-transporting compound, or may include the electron-transporting compound, and the electron-transporting compound may include:
i) at least one π electron-deficient nitrogen-containing C₁-C₆₀ cyclic group; and
ii) a carbazole group, a dibenzofuran group, a dibenzothiophene group, or one or more combinations thereof.

According to one or more embodiments, the first host (or, the electron-transporting compound) may include an amine-containing compound including:
i) a) a silyl group unsubstituted or substituted with deuterium, a C₁-C₁₀ alkyl group, a phenyl group, a biphenyl group, or one or more combinations thereof, b) a carbazole group, c) a dibenzofuran group or a dibenzothiophene group, or d) one or more combinations thereof; and
ii) a pyrimidine group, a pyrazine group, a pyridazine group, a triazine group, or one or more combinations thereof.

In one or more embodiments, the hole-transporting compound may include at least one π electron-rich C₃-C₆₀ cyclic group, a pyridine group, or a combination thereof, and may not include an (e.g., may exclude any or be free of the) electron-transporting group (examples include a π electron-deficient nitrogen-containing C₁-C₆₀ cyclic group, a cyano group, a sulfoxide group, and a phosphine oxide group, not a pyridine group).

In one or more embodiments, the following compounds may be excluded from the hole-transporting compound.

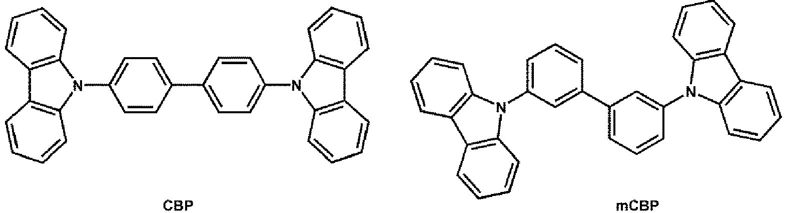

For example, in one or more embodiments, the first host may be the hole-transporting compound, or may include the hole-transporting compound, and the hole-transporting compound may be an amine-containing compound including at least one π electron-rich C₃-C₆₀ cyclic group (for example, an anthracene group, a pyrene group, a triphenylene group, etc.).

In one or more embodiments, the electron-transporting compound may include a compound represented by Formula 2-1: 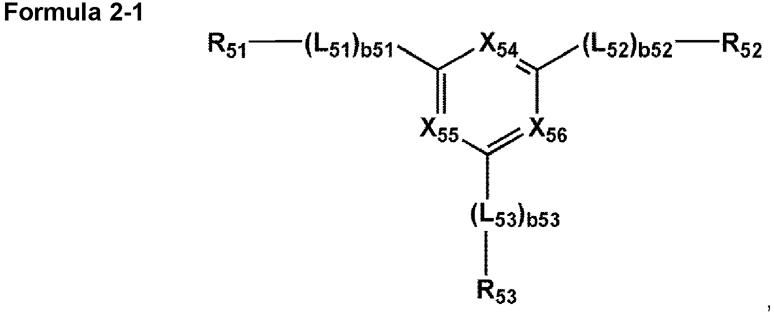
wherein, in Formula 2-1,
L₅₁ to L₅₃ may each independently be a single bond, a C₃-C₆₀ carbocyclic group that is unsubstituted or substituted with at least one R₁₀ₐ (for example, a benzene group, a naphthalene group, a phenanthrene group, an anthracene group, etc., each unsubstituted or substituted with at least one R₁₀ₐ,), a C₁-C₆₀ heterocyclic group that is unsubstituted or substituted with at least one R₁₀ₐ (for example, a carbazole group, a dibenzofuran group, a dibenzothiophene group, etc., each unsubstituted or substituted with at least one R₁₀ₐ), or *-N(R₁₀ₐ)-*',
b51 to b53 may each independently be an integer from 1 to 5,
X₅₄ may be N or C(R₅₄), X₅₅ may be N or C(R₅₅), X₅₆ may be N or C(R₅₆), at least two selected from among X₅₄ to X₅₆ may be N,
R₅₁ to R₅₆ and R₁₀ₐ are respectively the same as described in the present disclosure.

For example, in one or more embodiments, R₅₁ to R₅₃ may each independently be a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, -CF₂H, -CFH₂, a cyano group, a C₁-C₂₀ alkyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -Si(Q₃₁)(Q₃₂)(Q₃₃), -N(Q₃₁)(Q₃₂), or one or more combinations thereof, and Q₃₁ to Q₃₃ may each independently be the same as described in the present disclosure.

According to one or more embodiments, the hole-transporting compound may include a compound represented by Formula 3-1, a compound represented by Formula 3-2, a compound represented by Formula 3-3, a compound represented by Formula 3-4, a compound represented by Formula 3-5, a compound represented by Formula 3-6, a compound represented by Formula 3-7, or one or more combinations thereof: 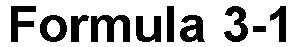 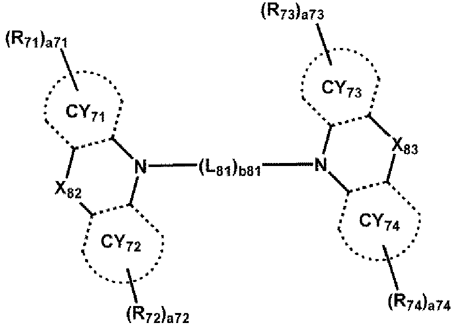 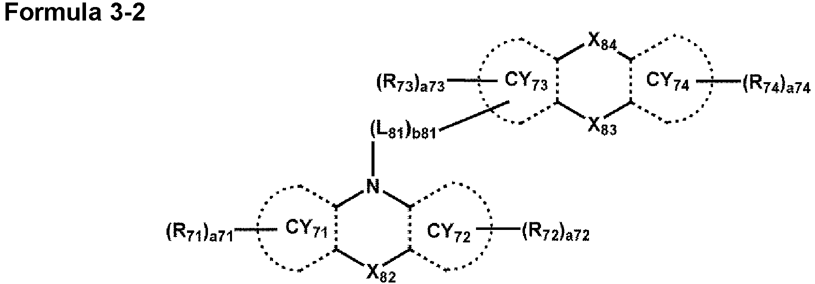 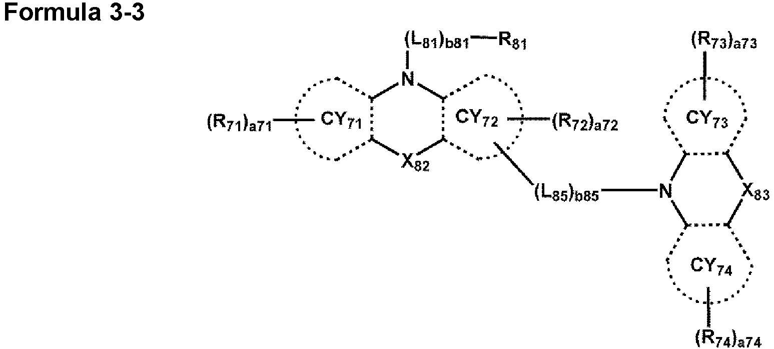 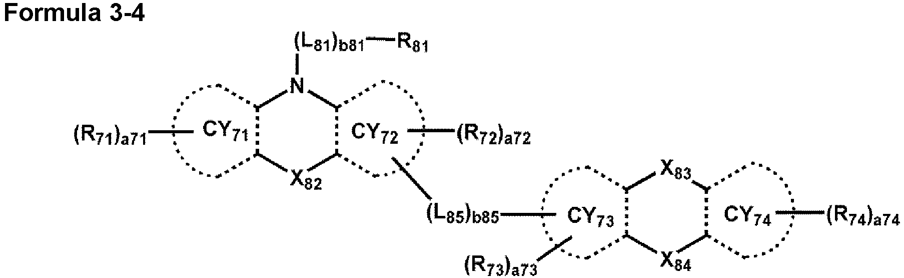 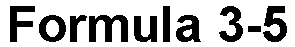 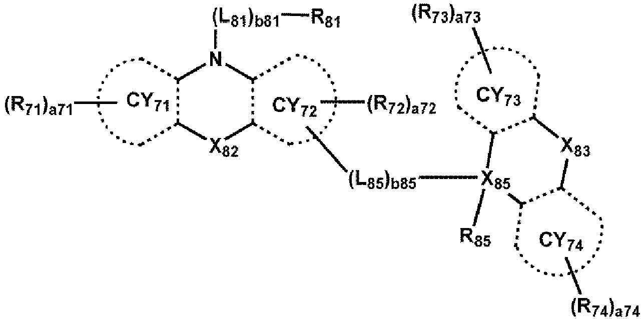 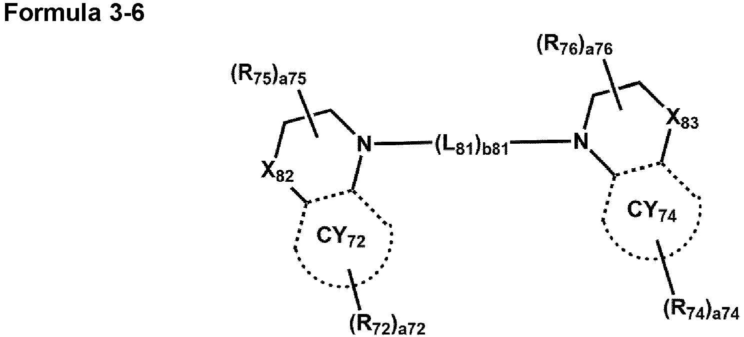 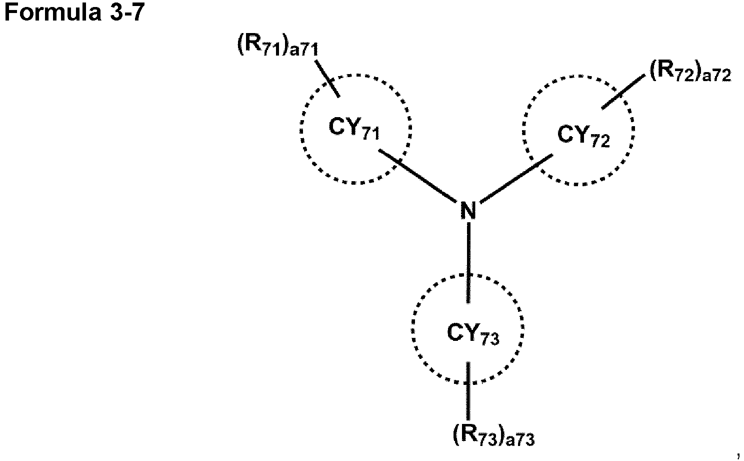
wherein, in Formulae 3-1 to 3-7,
ring CY₇₁ to ring CY₇₄ may each independently be a π electron-rich C₃-C₆₀ cyclic group (for example, a benzene group, a naphthalene group, a fluorene group, a anthracene group, a carbazole group, a dibenzofuran group, or a dibenzothiophene group), or a pyridine group,
X₈₂ may be a single bond, O, S, N-[(L₈₂)_{b82}-R₈₂], C(R₈₂ₐ)(R_{82b}), or Si(R₈₂ₐ)(R_{82b}),
X₈₃ may be a single bond, O, S, N-[(L₈₃)_{b83}-R₈₃], C(R₈₃ₐ)(R_{83b}), or Si(R₈₃ₐ)(R_{83b}),
X₈₄ may be O, S, N-[(L₈₄)_{b84}-R₈₄], C(R₈₄ₐ)(R_{84b}), or Si(R₈₄ₐ)(R_{84b}),
X₈₅ may be C or Si,
L₈₁ to L₈₅ may each independently be a single bond, *-C(Q₄)(Q₅)-*', *-Si(Q₄)(Q₅)-*', a π electron-rich C₃-C₆₀ cyclic group unsubstituted or substituted with at least one R₁₀ₐ (for example, a benzene group, a naphthalene group, a fluorene group, a anthracene group, a carbazole group, a dibenzofuran group, or a dibenzothiophene group, each unsubstituted or substituted with at least one R₁₀ₐ), or a pyridine group unsubstituted or substituted with at least one R₁₀ₐ, wherein Q₄ and Q₅ may each independently be the same as described with respect to Q₁,
b81 to b85 may each independently be an integer from 1 to 5,
each of R₇₁ to R₇₆, R₈₁ to R₈₅, R₈₂ₐ, R_{82b}, R₈₃ₐ, R_{83b}, R₈₄ₐ and R_{84b} may be the same as described in the present disclosure,
a71 to a74 may each independently be an integer from 0 to 20,
a75 and a76 may each independently be an integer from 0 to 4, and
R₁₀ₐ may be the same as described herein.

In one or more embodiments, the hole-transporting compound may be a compound represented by Formula 3-1 or a compound represented by Formula 3-6. Regarding Formulae 3-1 and 3-6, L₈₁ may be a π electron-rich C₃-C₆₀ cyclic group unsubstituted or substituted with at least one R₁₀ₐ (for example, a benzene group, a naphthalene group, a fluorene group, an anthracene group, a carbazole group, a dibenzofuran group, a dibenzothiophene group, etc., each unsubstituted or substituted with at least one R₁₀ₐ), a81 may be 1 or 2, ring CY₇₁ and ring CY₇₃ may each independently be a cyclopentane group or a cyclohexane group, and ring CY₇₂ and ring CY₇₄ may each be a benzene group.

According to one or more embodiments, the hole-transporting compound may be a compound represented by Formula 3-7.

In one or more embodiments, the emission layer may further include an auxiliary dopant, a sensitizer, a delayed fluorescence material, or one or more combinations thereof, in addition to the first emitter and the first host as described above. Each of the auxiliary dopant, the sensitizer, the delayed fluorescence material, or one or more combinations thereof may contain at least one deuterium.

The term "interlayer" as utilized herein refers to a single layer and/or all of a plurality of layers between the first electrode and the second electrode of the light-emitting device.

One or more aspects of embodiments of the present invention are directed toward an electronic device including the light-emitting device. The electronic device may further include a thin-film transistor. For example, in one or more embodiments, the electronic device may further include a thin-film transistor including a source electrode and a drain electrode, wherein the first electrode of the light-emitting device may be electrically connected to the source electrode or the drain electrode of the thin-film transistor. In one or more embodiments, the electronic device may further include a color filter, a color conversion layer, a touch screen layer, a polarizing layer, or one or more combinations thereof. More details of the electronic devices may be referred to the descriptions provided herein.

One or more aspects of embodiments of the present invention are directed toward an electronic apparatus including the light-emitting device. By including a light-emitting device having an emission layer and a first layer as described in the present disclosure, the display quality, power consumption, durability, etc. of the electronic apparatus may be improved.

For example, the electronic apparatus may be at least one of a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, or a signboard.

### Description of formulae

In one or more embodiments, the first emitter may be, for example, an organometallic compound represented by Formula 1:

**Formula 1** Ir(L₁)(L₂)(L₃),

wherein, in Formula 1,
L₁ may be a first ligand which is bonded to Ir of Formula 1, and may be represented by Formula 1-1,
L₂ may be a second ligand which is bonded to Ir of Formula 1, and may be represented by Formula 1-2A or 1-2B, and
L₃ may be a third ligand which is bonded to Ir of Formula 1, and may be represented by Formula 1-3: 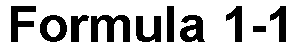 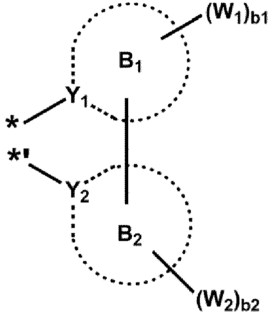 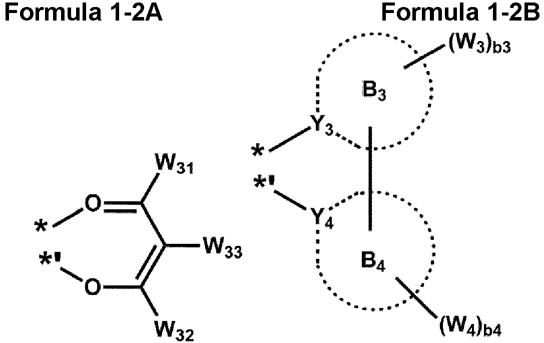 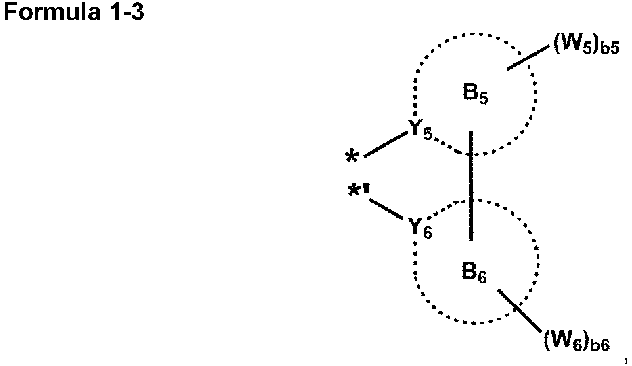 wherein, in formulae 1-1, 1-2A, 1-2B, and 1-3,
   Y₁, Y₃ and Y₅ may each be nitrogen (N),
   Y₂, Y₄ and Y₆ may each be carbon (C),
   ring B₁ to ring B₆ may each independently be a C₃-C₆₀ carbocyclic group or a C₁-C₆₀ heterocyclic group, wherein at least one selected from among the Y₁-containing ring B₁ of Formula 1-1 and the Y₅-containing ring B₅ of Formula 1-3 (for example, each of the Y₁-containing ring B₁ of Formula 1-1 and the Y₅-containing ring B₅ of Formula 1-3) may be a polycyclic group in which three or more cyclic groups (for example, a benzene group, a pyridine group, a pyrimidine group, etc.) are condensed with each other,
   W₁ to W₆ and W₃₁ to W₃₃ may each independently be hydrogen, deuterium, - F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(= O)(Q₁), -S(=O)₂(Q₁), or -P(=O)(Q₁)(Q₂),
   b1 to b6 may each independently be an integer from 0 to 20,
   Each of * and *' in Formulae 1-1, 1-2A, 1-2B, and 1-3 is a binding site to Ir in Formula 1, and
   I) 2 groups of b1 W₁(s), ii) 2 groups of b2 W₂(s), iii) 2 groups of b3 W₃(s), iv) 2 groups of b4 W₄(s), v) 2 groups of b5 W₅(s), vi) 2 groups of b6 W₆(s), and/or vii) two groups selected from among W₃₁ to W₃₃ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ. For example, i) two groups of b1 W₁ groups may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, ii) two groups of b2 W₂ groups may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, iii) two groups of b3 W₃ groups may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, iv ) two groups of b4 W₄ groups may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, v) two groups of b5 W₅ groups may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, vi) two groups of b6 W₆ groups may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, and/or vii) two groups selected from among W₃₁ to W₃₃ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
   R₁₀ₐ may be:
      deuterium, -F, -Cl, -Br, -I, a hydroxyl group, a cyano group, or a nitro group;
      a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or one or more combinations thereof;
      a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or one or more combinations thereof; or
      -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
      wherein Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or one or more combinations thereof.

In one or more embodiments, the organometallic compound represented by Formula 1 may be a heteroleptic complex.

According to one or more embodiments, L₃ in Formula 1 may be the same as L₁.

According to one or more embodiments, L₃ and L₁ in Formula 1 may be different from each other.

According to one or more embodiments, L₂ and L₁ in Formula 1 may be different from each other.

According to one or more embodiments, at least one selected from among ring B₁ and ring B₅ may be a benzoquinoline group, a benzoisoquinoline group, a naphthoquinoline group, or a naphthoisoquinoline group.

According to one or more embodiments, ring B₁ and ring B₅ may each independently be a benzoquinoline group, a benzoisoquinoline group, a naphthoquinoline group, or a naphthoisoquinoline group.

According to one or more embodiments, ring B₃ may be a pyridine group, a pyrimidine group, a pyridazine group, a pyrazine group, or a triazine group.

According to one or more embodiments, ring B₂, ring B₄, and ring B₆ may each independently be a benzene group, a naphthalene group, a phenanthrene group, a furan group, a thiophene group, a selenophene group, a pyrrole group, a cyclopentadiene group, a silole group, a benzofuran group, a benzothiophene group, a benzoselenophene group, an indole group, an indene group, a benzosilole group, a dibenzofuran group, a dibenzothiophene group, a dibenzoselenophene group, a carbazole group, a fluorene group, or a dibenzosilole group.

According to one or more embodiments, W₁ to W₆ and W₃₁ to W₃₃ in Formula 1 may each independently be:
hydrogen, deuterium, -F, or a cyano group;
a C₁-C₂₀ alkyl group or a C₃-C₁₀ cycloalkyl group, each unsubstituted or substituted with deuterium, -F, a cyano group, or one or more combinations thereof; or
a phenyl group, a biphenyl group, a naphthyl group, a dibenzofuranyl group, or a dibenzothiophenyl group (or a thienyl group), each unsubstituted or substituted with deuterium, -F, cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or one or more combinations thereof; or

   -Si(Q₁)(Q₂)(Q₃).

In this regard, Q₁ to Q₃ are each the same as described above.

According to one or more embodiments, at least one selected from among W₁, W₂, W₃, W₄, W₅, W₆, W₃₁, W₃₂, and W₃₃ may include at least one deuterium.

According to one or more embodiments, at least one selected from among W₁, W₂, W₃, W₄, W₅, W₆, W₃₁, W₃₂, and W₃₃ may be a deuterium, a deuterated C₁-C₂₀ alkyl group, or a deuterated C₃-C₁₀ cycloalkyl group.

According to one or more embodiments, at least one selected from among W₁, W₂, W₃, W₄, W₅, W₆, W₃₁, W₃₂, and W₃₃ may include at least one fluoro group (-F).

According to one or more embodiments, at least one selected from among W₁ and W₅ may include at least one fluoro group (-F).

According to one or more embodiments, at least one of the b1 W₁ and at least one of the b5 W₅ may be a fluoro group (-F).

According to one or more embodiments, at least one selected from among W₃₁ and W₃₂ of Formula 1-2A may contain 2 or more carbons.

According to one or more embodiments, each of W₃₁ and W₃₂ in Formula 1-2A may contain two or more carbons.

According to one or more embodiments, W₃₁ and W₃₂ in Formula 1-2A may not be methyl groups at the same time.

According to one or more embodiments, W₃₁ and W₃₂ in Formula 1-2A may not be tert-butyl groups at the same time.

The term "biphenyl group" as utilized herein refers to a monovalent substituent having a structure in which two benzene groups are connected to each other through a single bond.

Non-limiting examples of the C₃-C₁₀ cycloalkyl group as utilized herein may be a cyclopentyl group, a cyclohexyl group, a cycloheptyl group, an adamantanyl group, a norbornanyl group, and/or the like.

The term "deuterated" as utilized herein may include the meaning of both (e.g., simultaneously) fully deuterated and partially deuterated.

The term "fluorinated" as utilized herein may include the meaning of both (e.g., simultaneously) fully fluorinated and partially fluorinated.

b1 to b6 in Formula 1 respectively indicate the numbers of W₁ to W₆, and for example, may each independently be 0, 1, 2, 3, or 4. When b1 is 2 or more, 2 or more W₁(s) may be the same as or different from each other, when b2 is 2 or more, 2 or more W₂(s) may be the same as or different from each other, when b3 is 2 or more, 2 or more W₃(s) may be the same as or different from each other, when b4 is 2 or more, 2 or more W₄(s) may be the same as or different from each other, when b5 is 2 or more, 2 or more W₅(s) may be the same as or different from each other, and when b6 is 2 or more, 2 or more W₆(s) may be the same as or different from each other.

According to one or more embodiments, the first emitter may be an organometallic compound represented by Formula 1A or Formula 1B: 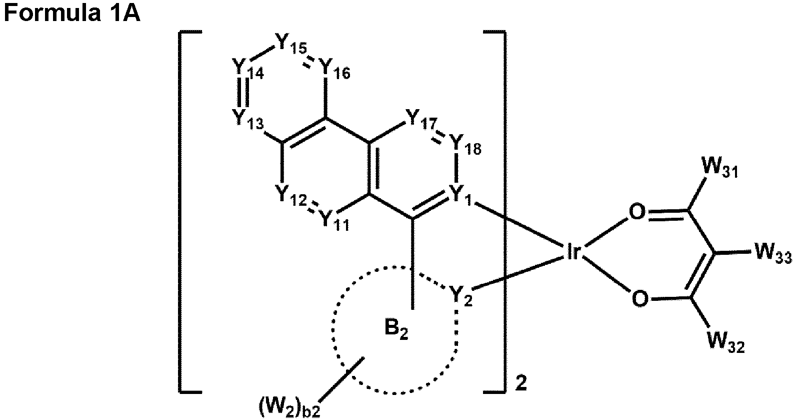 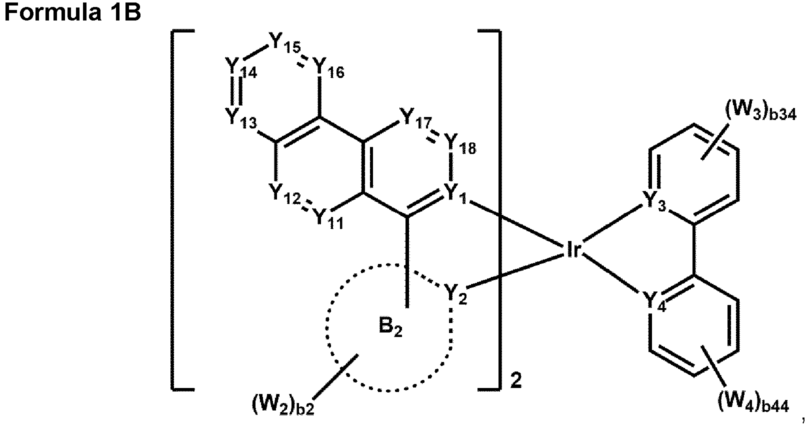 wherein, in Formulae 1A and 1B,
Y₁ and Y₃ may each be N,
Y₂ and Y₄ may each be C,
the description of each of ring B₂, W₂, W₃, W₄, W₃₁, W₃₂, W₃₃, and b2 may be the same as described herein,
b34 and b44 may each independently be an integer from 0 to 4,
Y₁₁ may be C(W₁₁) or N, Y₁₂ may be C(W₁₂) or N, Y₁₃ may be C(W₁₃) or N, Y₁₄ may be C(W₁₄) or N, Y₁₅ may be C(W₁₅) or N, Y₁₆ may be C(W₁₆) or N, Y₁₇ may be C(W₁₇) or N, and Y₁₈ may be C(W₁₈) or N,
the description of each of W₁₁ to W₁₈ may be the same as the description of W₁ in the present disclosure,
two or more of W₁₁ to W₁₈ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
two or more of b2 W₂(s) may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
two or more of b34 W₃(s) may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
two or more of b44 W₄(s) may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, and/or
two or more selected from W₃₁ to W₃₃ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

Each of Formulae 1A and 1B may correspond to an organometallic compound in which the third ligand in Formula 1 is the same as the first ligand.

According to one or more embodiments, in regard to Formulae 1A and 1B, Y₁₁ may be C(W₁₁), Y₁₂ may be C(W₁₂), Y₁₃ may be C(W₁₃), Y₁₄ may be C(W₁₄), Y₁₅ may be C(W₁₅), Y₁₆ may be C(W₁₆), Y₁₇ may be C(W₁₇), and Y₁₈ may be C(W₁₈). In this regard, at least one selected from among W₁₁ to W₁₈ i) may include a fluoro group (-F), or ii) may be a fluoro group (-F). For example, at least one selected from among W₁₁ to W₁₈ may be a fluorinated C₁-C₂₀ alkyl group (for example, -CF₃, -CHF₂, -CH₂F, etc.) or -F.

According to one or more embodiments, in regard to Formulae 1A and 1B, Y₁₁ may be C(W₁₁), Y₁₂ may be C(W₁₂), Y₁₃ may be C(W₁₃), Y₁₄ may be C(W₁₄), Y₁₅ may be C(W₁₅), Y₁₆ may be C(W₁₆), Y₁₇ may be C(W₁₇), and Y₁₈ may be C(W₁₈). In this regard, at least one selected from among W₁₁ to W₁₈ i) may include a deuterium, or ii) may be a deuterium. For example, at least one selected from among W₁₁ to W₁₈ may be a deuterated C₁-C₂₀ alkyl group (for example, -CD₃, -CHD₂, -CH₂D, etc.) or deuterium.

In one or more embodiments, a group represented by 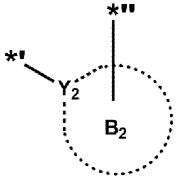 in Formulae 1-1, 1A, and 1B, and a group represented by 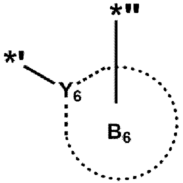 in Formula 1-3 may each independently be one selected from among the groups represented by Formula BC-1 to BC-16: 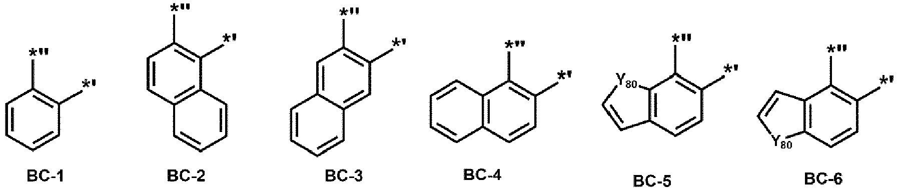 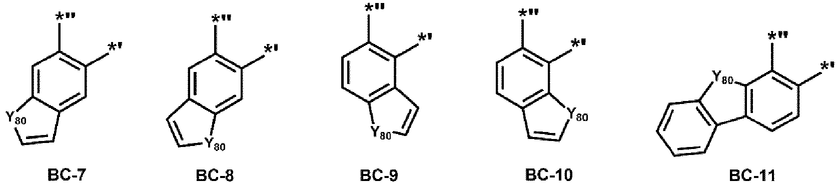 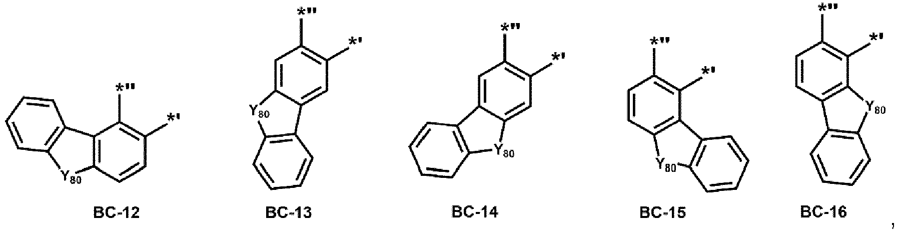 wherein in Formulae BC-1 to BC-16,
Y₈₀ may be O, S, Se, N(W₈₀), C(W₈₀ₐ)(W_{80b}), or Si(W₈₀ₐ)(W_{80b}),
The description of each of W₈₀, W₈₀ₐ and W_{80b} is the same as the description of W₂ or W₆ in the present disclosure,
*' indicates a binding site to iridium in corresponding Formula 1, 1A, or 1B, and
*" indicates a binding site to a neighboring atom in corresponding Formula 1-1, 1A, 1B, or 1-3.

Formulae BC-1 to BC-16 may be unsubstituted or substituted with W₂ or W₆ as described herein, which may be easily and readily understood from the structures of Formulae 1-1, 1A, 1B, and 1-3.

According to one or more embodiments, when ring B₂ in Formula 1A is a naphthalene group, at least one selected from among W₃₁ and W₃₂ may not be a methyl group.

b51 to b53 in Formula 2-1 represent the numbers of L₅₁ to L₅₃, respectively, and may be an integer from 1 to 5. When b51 is 2 or more, two or more of L₅₁(s) may be the same as or different from each other, when b52 is 2 or more, two or more of L₅₂(s) may be the same as or different from each other, and when b53 is 2 or more, two or more of L₅₃(s) may be the same as or different from each other. In some embodiments, b51 to b53 may each independently be 1 or 2.

L₅₁ to L₅₃ in Formula 2-1 may each independently be:
a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, a oxazole group, a isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzooxasiline group, a dibenzothiasiline group, a dibenzodihydroazasiline group, a dibenzodihydrodisiline group, a dibenzodihydrosiline group, a dibenzodioxin group, a dibenzooxathiin group, a dibenzooxazine group, a dibenzopyran group, a dibenzodithiin group, a dibenzothiazine group, a dibenzothiopyran group, a dibenzocyclohexadiene group, a dibenzodihydropyridine group, a dibenzodihydropyrazine group, an indolocarbazole group, an indolodibenzofuran group, or an indolodibenzothiophene group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, - O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or one or more combinations thereof,
Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In Formula 2-1, X₅₄ may be N or C(R₅₄), X₅₅ may be N or C(R₅₅), X₅₆ may be N or C(R₅₆), and at least one selected from among X₅₄ to X₅₆ may be N. R₅₄ to R₅₆ may each independently be the same as described above. In one or more embodiments, two or three selected from among X₅₄ to X₅₆ may be N.

R₅₁ to R₅₇, R₅₇ₐ, R_{57b}, R₇₁ to R₇₆, R₈₁ to R₈₅, R₈₂ₐ, R_{82b}, R₈₃ₐ, R_{83b}, R₈₄ₐ, and R_{84b} may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ aryl alkyl group unsubstituted or substituted with at least one R₁₀ₐ, a C₂-C₆₀ heteroaryl alkyl group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂). Q₁ to Q₃ may each be the same as described herein.

For example, in one or more embodiments, i) W₁ to W₆, W₃₁ to W₃₃, W₁₁ to W₁₈, W₈₀, W₈₀ₐ and W_{80b} in Formulae 1, 1A and 1B, ii) R₅₁ to R₅₇, R₅₇ₐ, R_{57b}, R₇₁ to R₇₆, R₈₁ to R₈₅, R₈₂ₐ, R_{82b}, R₈₃ₐ, R_{83b}, R₈₄ₐ and R_{84b} in Formulae 2-1, and 3-1 to 3-7, and iii) R₁₀ₐ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or one or more combinations thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, - CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or one or more combinations thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or one or more combinations thereof: 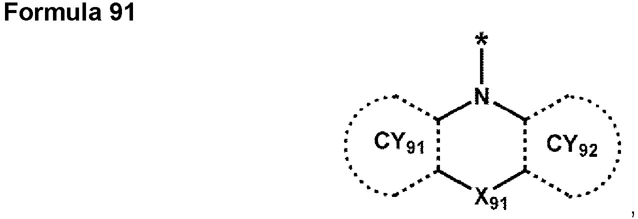 wherein, in Formula 91,
   ring CY₉₁ and ring CY₉₂ may each independently be a C₅-C₃₀ carbocyclic group unsubstituted or substituted with at least one R₁₀ₐ or a C₁-C₃₀ heterocyclic group unsubstituted or substituted with at least one R₁₀ₐ,
   X₉₁ may be a single bond, O, S, N(R₉₁), B(R₉₁), C(R₉₁ₐ)(R_{91b}), or Si(R91a)(R91b),
   R₉₁, R₉₁ₐ, and R_{91b} may each be the same as described with respect to R₈₂, R₈₂ₐ, and R_{82b}, respectively,
   R₁₀ₐ may be the same as described herein, and
   * indicates a binding site to a neighboring atom.

For example, in some embodiments, in Formula 91,
ring CY₉₁ and ring CY₉₂ may each independently be a benzene group, a pyridine group, a pyrimidine group, a pyrazine group, a pyridazine group, or a triazine group, each unsubstituted or substituted with at least one R₁₀ₐ,
R₉₁, R₉₁ₐ, and R_{91b} may each independently be:
hydrogen or a C₁-C₁₀ alkyl group; or
a phenyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or one or more combinations thereof.

According to one or more embodiments, i) W₁ to W₆, W₃₁ to W₃₃, W₁₁ to W₁₈, W₈₀, W₈₀ₐ and W_{80b} in Formulae 1, 1A and 1B, ii) R₅₁ to R₅₇, R₅₇ₐ, R_{57b}, R₇₁ to R₇₆, R₈₁ to R₈₅, R₈₂ₐ, R_{82b}, R₈₃ₐ, R_{83b}, R₈₄ₐ and R_{84b} in Formulae 2-1, 3-1 to 3-7, and iii) R₁₀ₐ may each independently be hydrogen, deuterium, -F, a cyano group, a nitro group, -CH₃, - CD₃, -CD₂H, -CDH₂, -CF₃, -CF₂H, -CFH₂, a group represented by one selected from among Formulae 9-1 to 9-19, a group represented by one selected from among Formulae 10-1 to 10-246, -C(Q₁)(Q₂)(Q₃), -Si(Q₁)(Q₂)(Q₃), or -P(=O)(Q₁)(Q₂)(Q₁ to Q₃ may each independently be the same as described in the present disclosure) (with the proviso that R₁₀ₐ is not hydrogen):

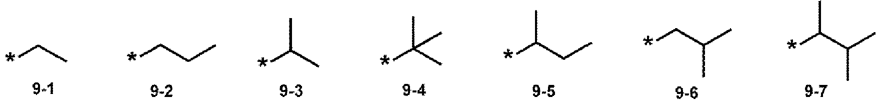

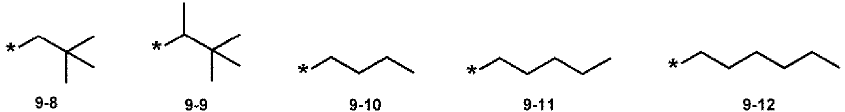

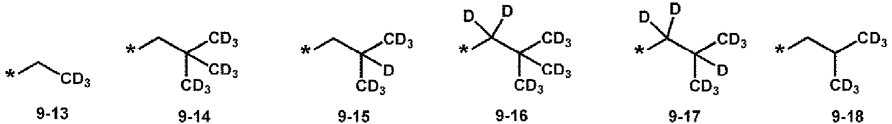

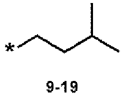

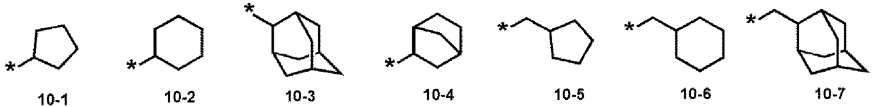

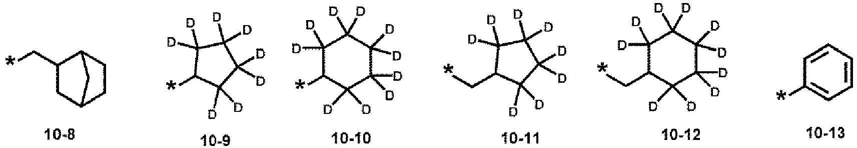

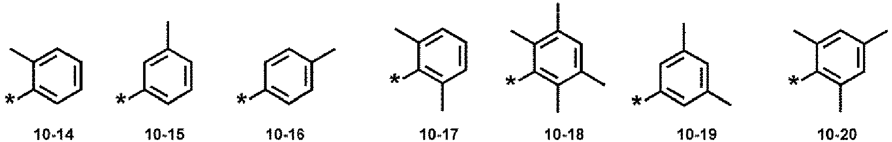

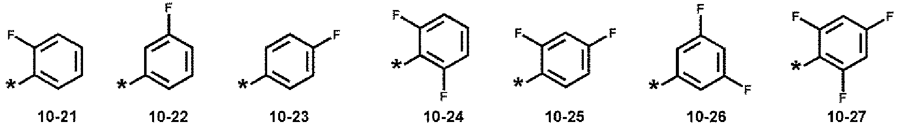

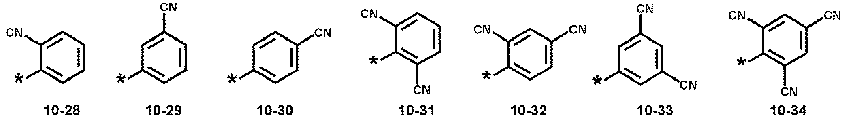

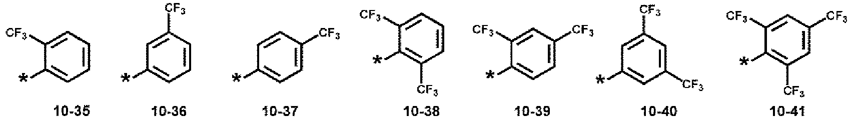

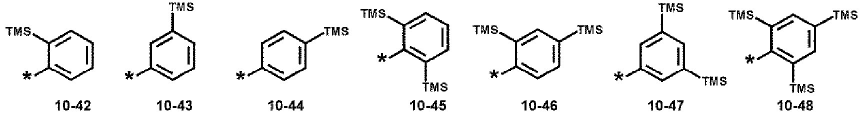

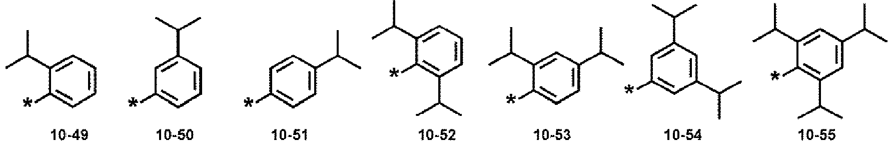

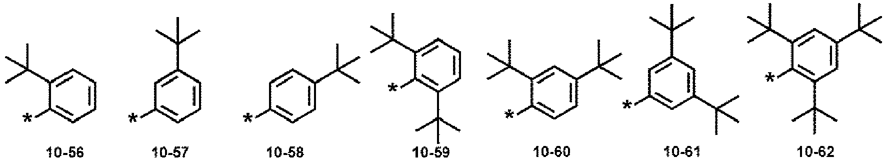

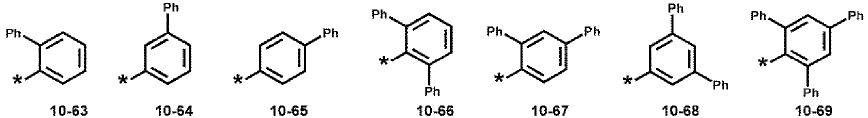

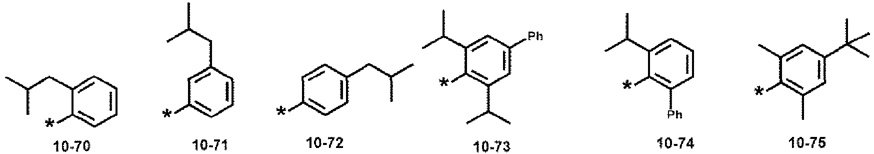

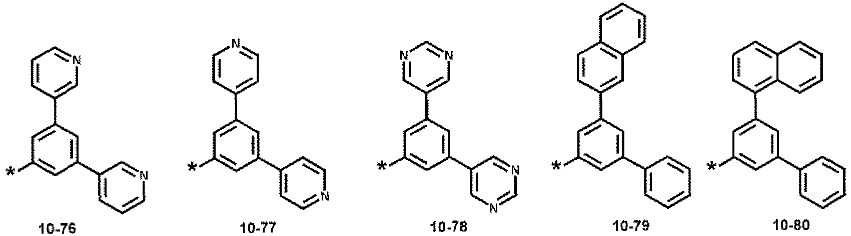

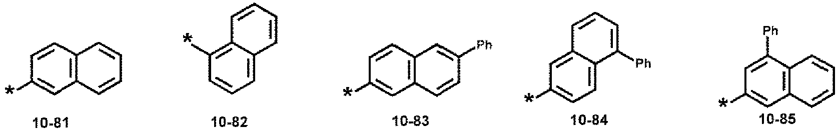

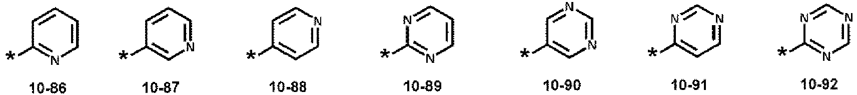

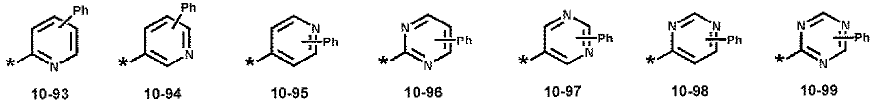

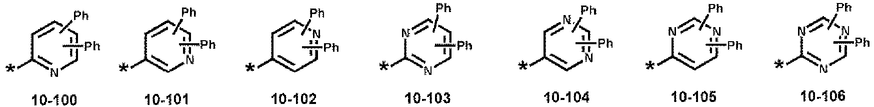

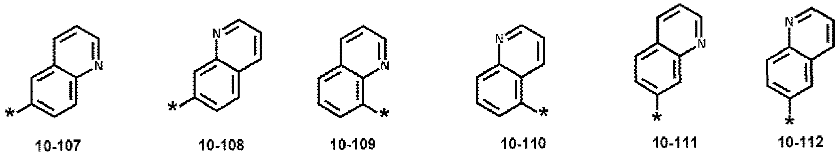

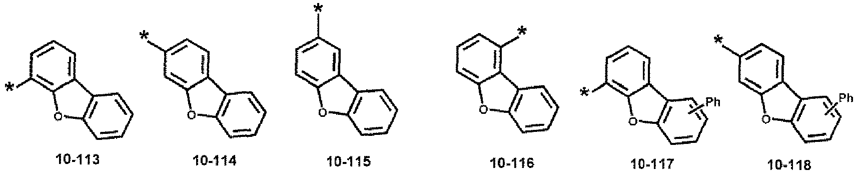

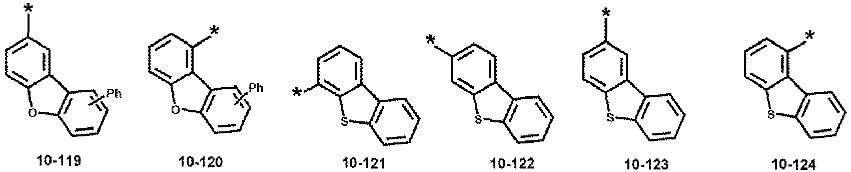

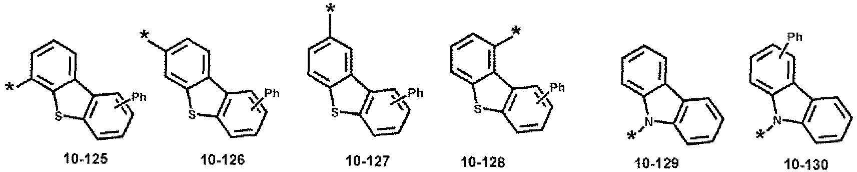

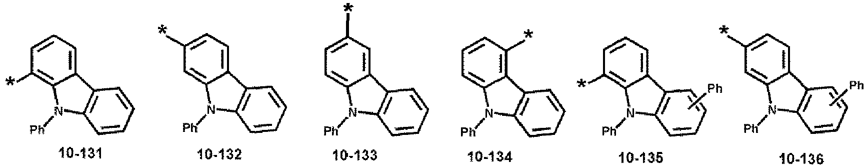

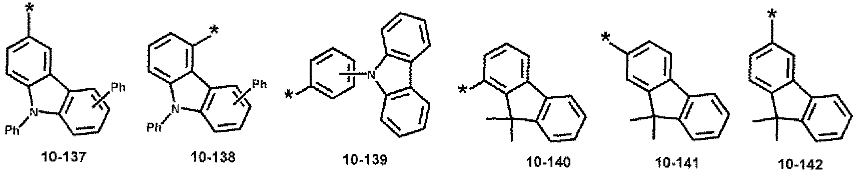

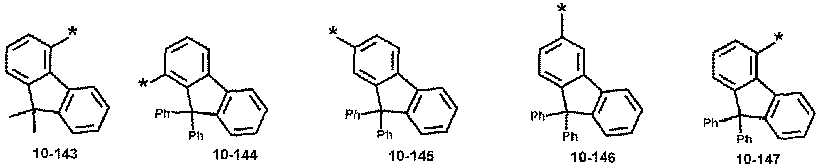

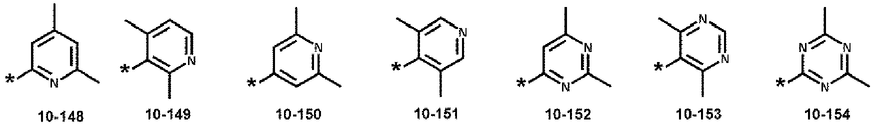

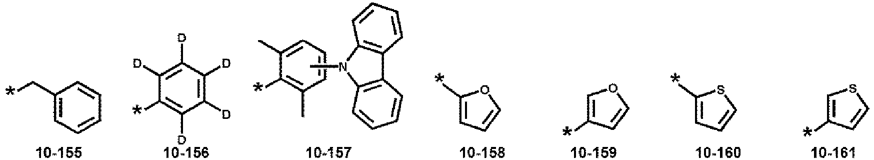

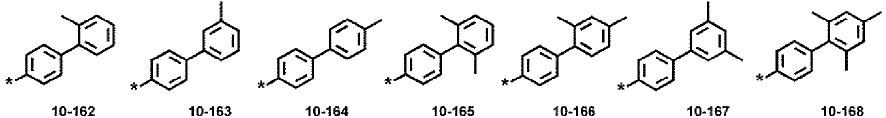

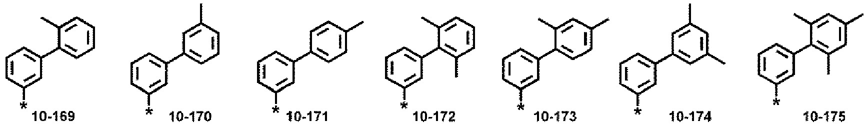

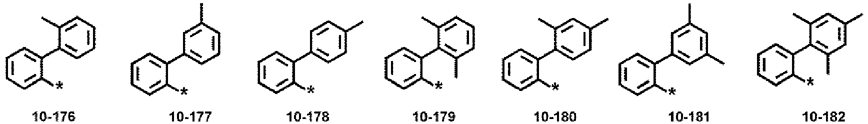

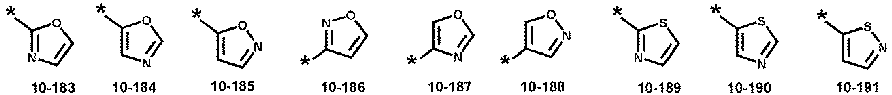

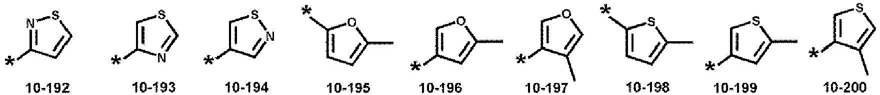

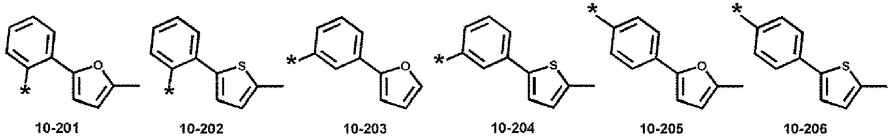

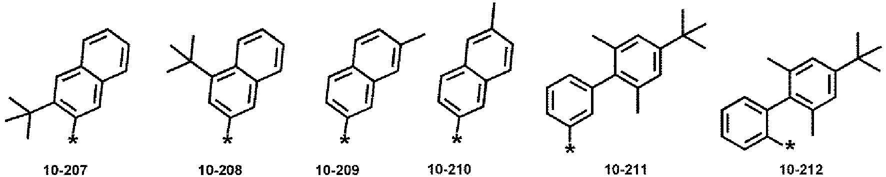

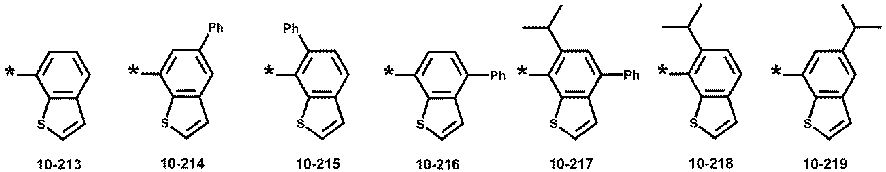

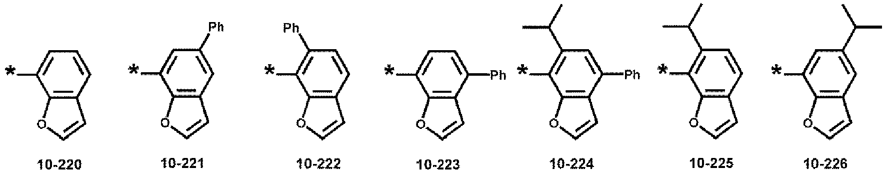

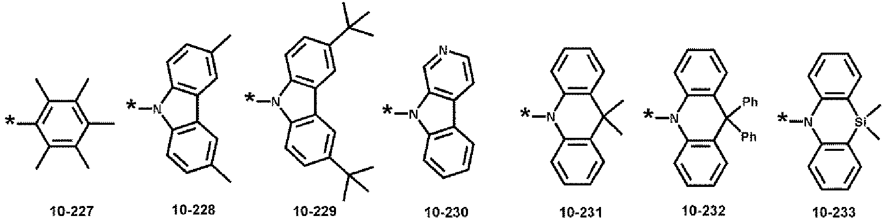

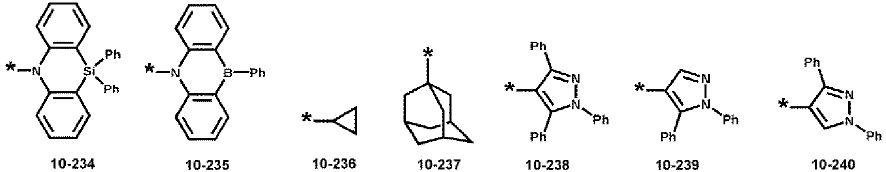

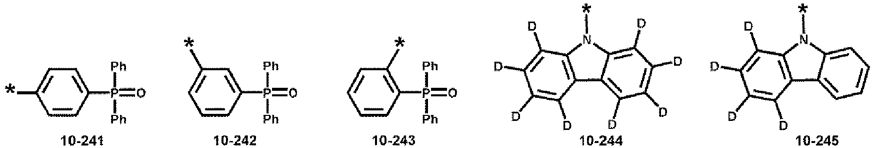

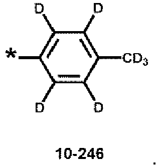

In Formulae 9-1 to 9-19 and 10-1 to 10-246, * indicates a binding site to a neighboring atom, "Ph" represents a phenyl group, "D" represents deuterium, and "TMS" represents a trimethylsilyl group.

a71 to a74 in Formulae 3-1 to 3-7 each represent the numbers of R₇₁ to R₇₄, respectively, and may each independently be an integer from 0 to 20. When a71 is 2 or more, two or more of R₇₁(s) may be the same as or different from each other, when a72 is 2 or more, two or more of R₇₂(s) may be the same as or different from each other, when a73 is 2 or more, two or more of R₇₃(s) may be the same as or different from each other, and when a74 is 2 or more, two or more of R₇₄(s) may be the same as or different from each other. a71 to a74 may each independently be an integer from 0 to 8.

In Formulae 3-1 to 3-5, L₈₁ to L₈₅ may each independently be:
a single bond; or
*-C(Q₄)(Q₅)-*' or *-Si(Q₄)(Q₅)-*", or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, - F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), - Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), - P(=O)(Q₃₁)(Q₃₂), or one or more combinations thereof,
wherein Q₄, Q₅, and Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In one or more embodiments, a group represented by 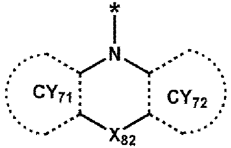 in Formulae 3-1 and 3-2 may be a group represented by one selected from among Formulae CY71-1(1) to CY71-1(8), and/or
a group represented by 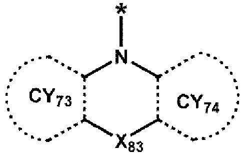 in Formulae 3-1 and 3-3 may be a group represented by one selected from among Formulae CY71-2(1) to CY71-2(8), and/or
a group represented by 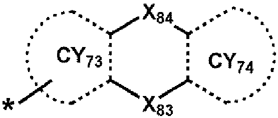 in Formulae 3-2 and 3-4 may be a group represented by one selected from among Formulae CY71-3(1) to CY71-3(32), and/or
a group represented by 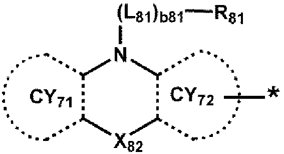 in Formulae 3-3 to 3-5 may be a group represented by one selected from among Formulae CY71-4(1) to CY71-4(32), and/or
a group represented by 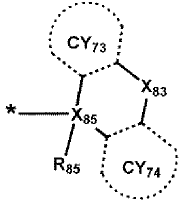 in Formula 3-5 may be a group represented by one selected from among Formulae CY71-5(1) to CY71-5(8): 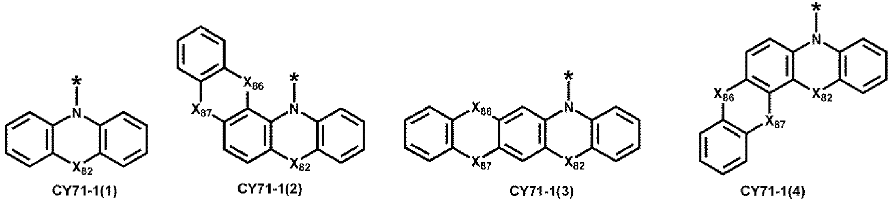 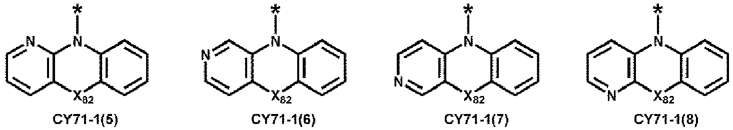 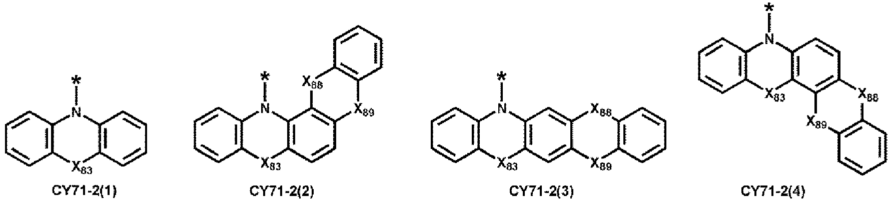 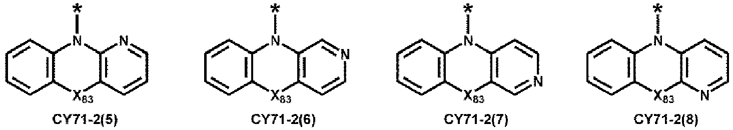 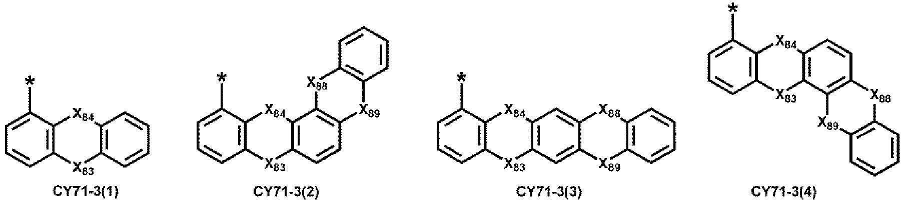 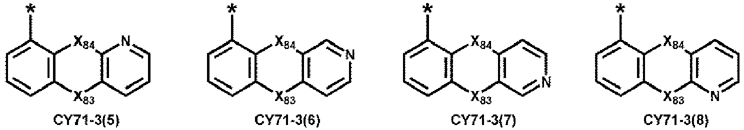 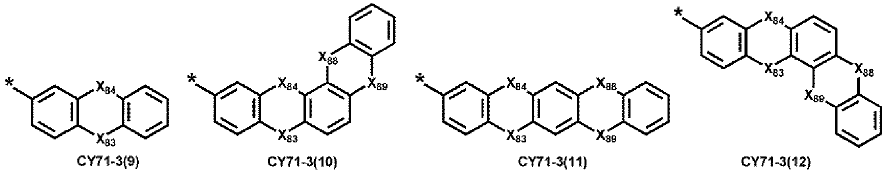 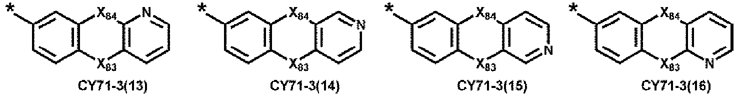 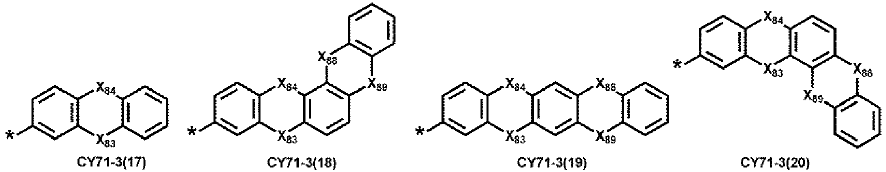 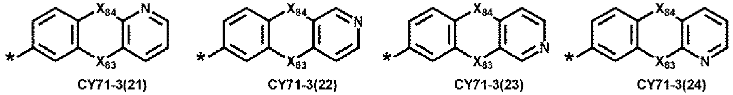 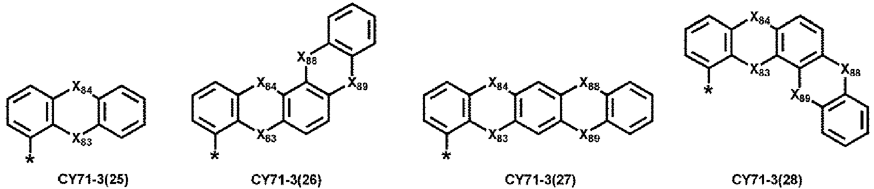 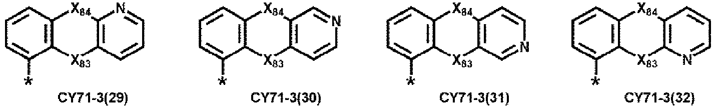 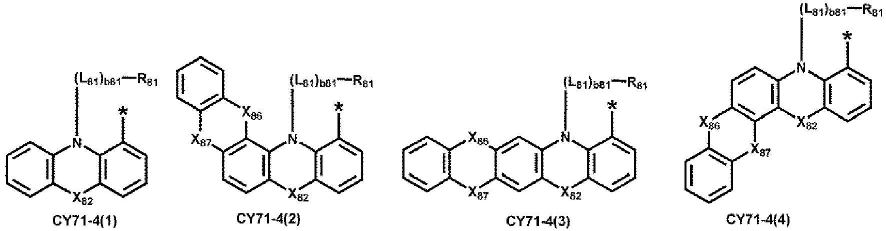 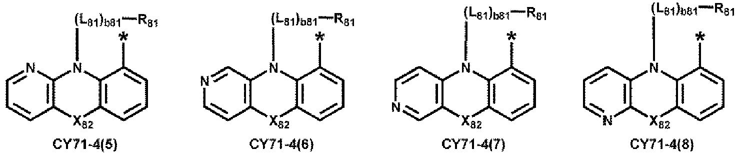 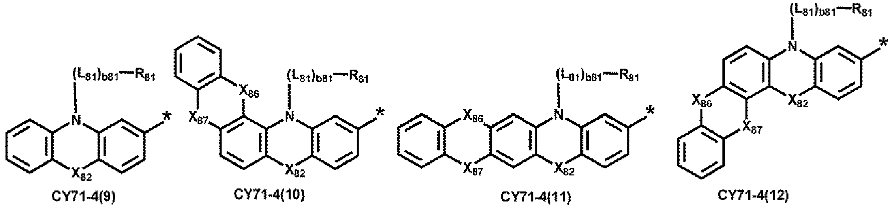 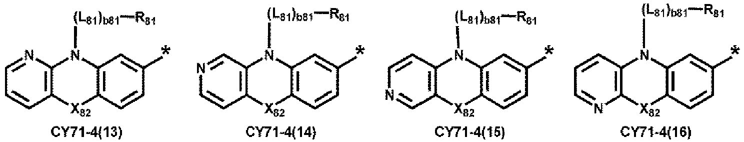 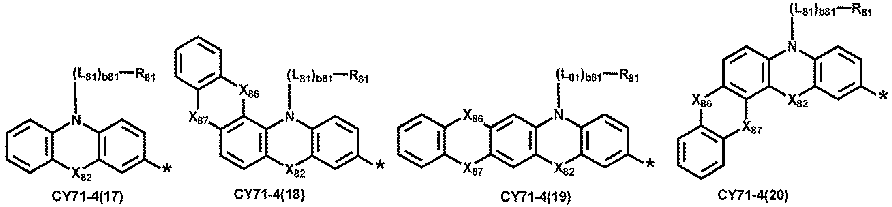 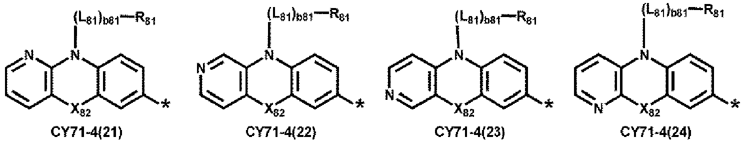 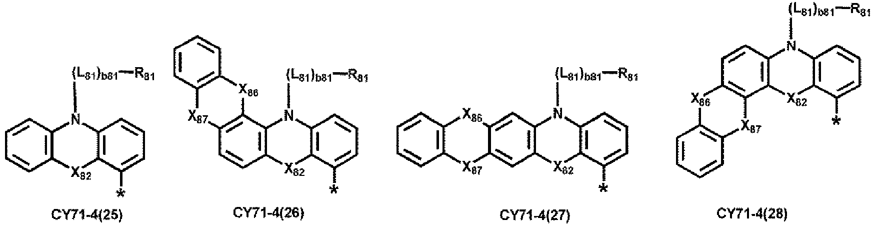 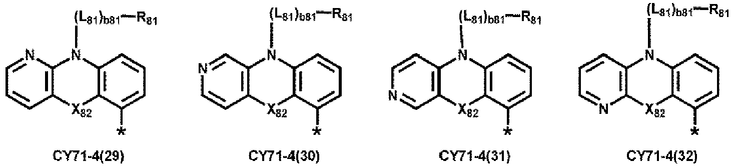 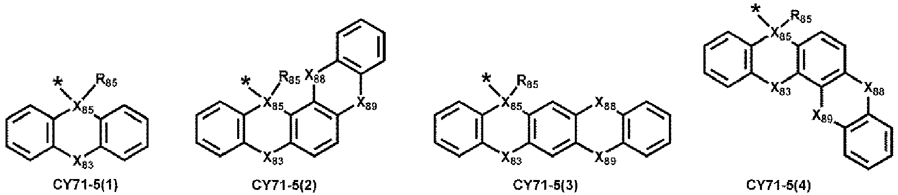 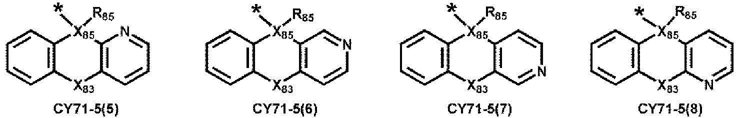
wherein, in Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),
X₈₁ to X₈₅, L₈₁, b81, R₈₁, and R₈₅ may each be the same as described herein,
X₈₆ may be a single bond, O, S, N(R₈₆), B(R₈₆), C(R₈₆ₐ)(R_{86b}), or Si(R86a)(R86b),
X₈₇ may be a single bond, O, S, N(R₈₇), B(R₈₇), C(R₈₇ₐ)(R_{87b}), or Si(R87a)(R87b),
in Formulae CY71-1(1) to CY71-1(8) and CY71-4(1) to CY71-4(32), each of X₈₆ and X₈₇ may not be a single bond at the same time (e.g., X₈₆ and X₈₇ may not all be a single bond at the same time),
X₈₈ may be a single bond, O, S, N(R₈₈), B(R₈₈), C(R₈₈ₐ)(R_{88b}), or Si(R₈₈ₐ)(R_{88b}),
X₈₉ may be a single bond, O, S, N(R₈₉), B(R₈₉), C(R₈₉ₐ)(R_{89b}), or Si(R89a)(R89b),
in Formulae CY71-2(1) to CY71-2(8), CY71-3(1) to CY71-3(32), and CY71-5(1) to CY71-5(8), each of X₈₈ and X₈₉ may not be a single bond at the same time (e.g., X₈₈ and X₈₉ may not all be a single bond at the same time), and
R₈₆ to R₈₉, R₈₆ₐ, R_{86b}, R₈₇ₐ, R_{87b}, R₈₈ₐ, R_{88b}, R₈₉ₐ, and R_{89b} may each be the same as described with respect to R₈₁.

### Examples of compounds

According to one or more embodiments, the first emitter or the organometallic compound represented by Formula 1, 1A or 1B may be one selected from among compounds RD01 to RD04 and D1 to D16:

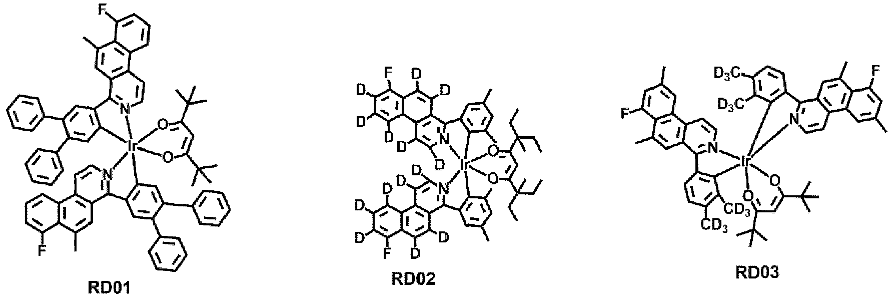

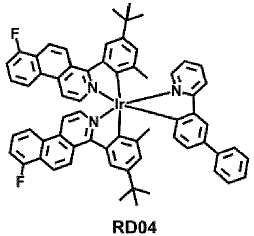

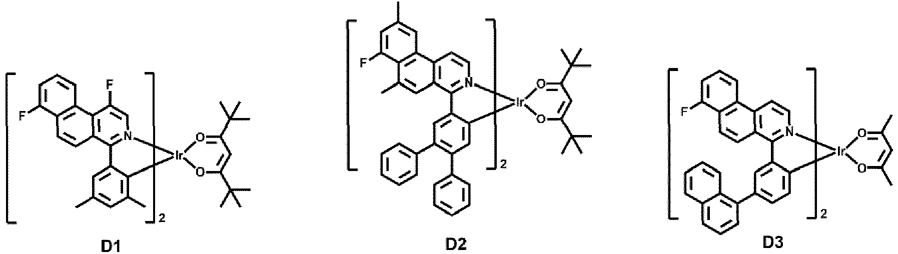

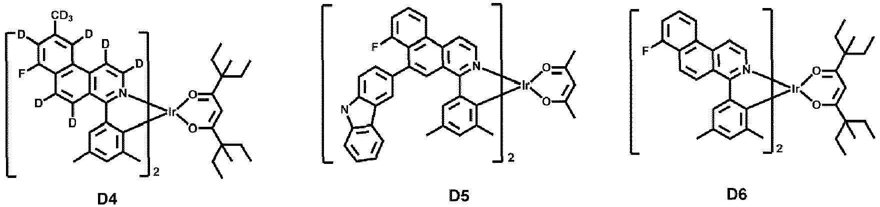

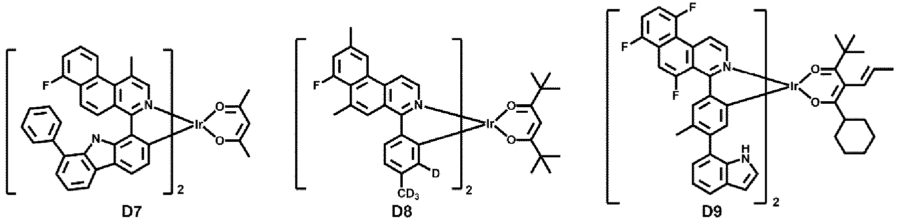

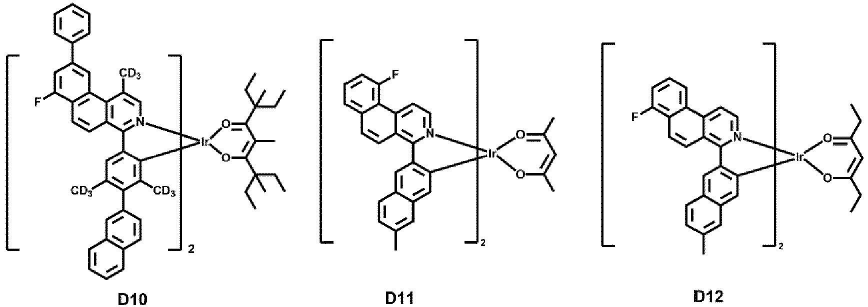

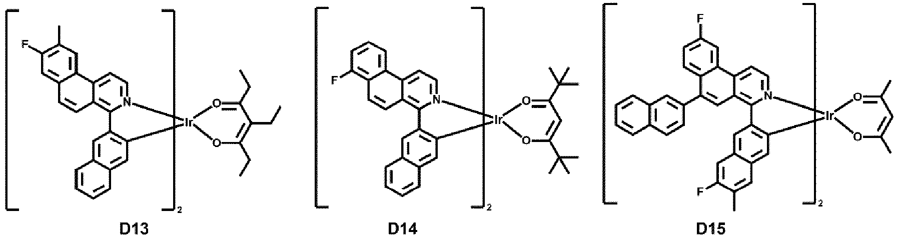

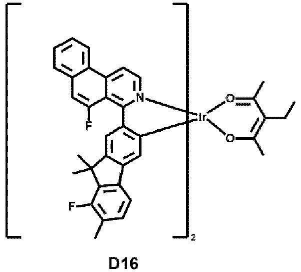

According to one or more embodiments, the first host may be one selected from among Host1 to Host4:

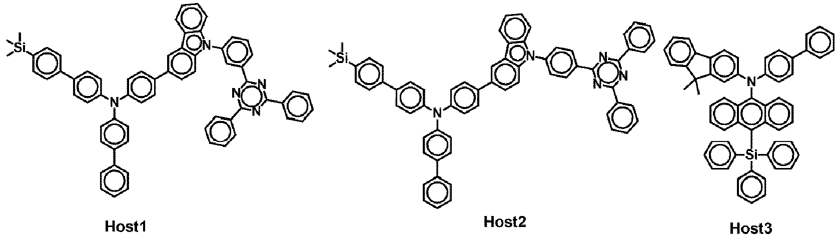

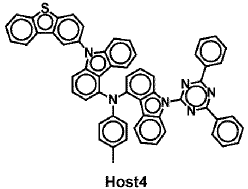

According to one or more embodiments, the first material may be one selected from among compounds RI01 to RI10:

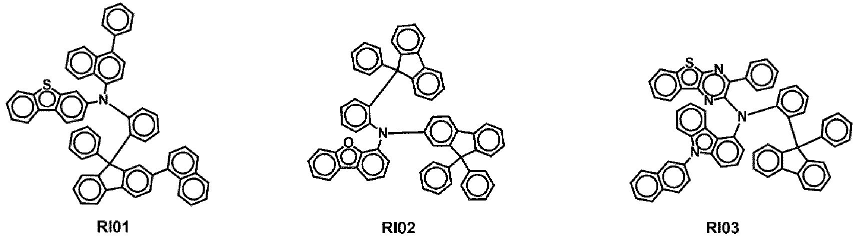

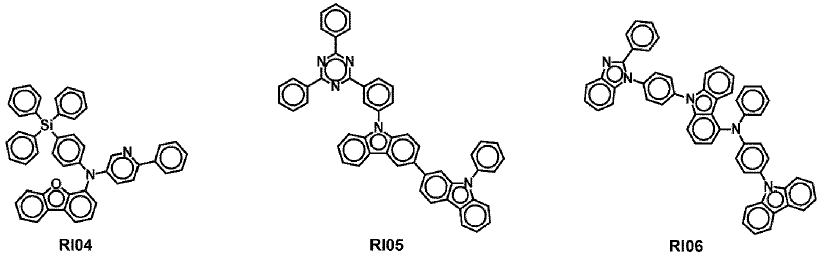

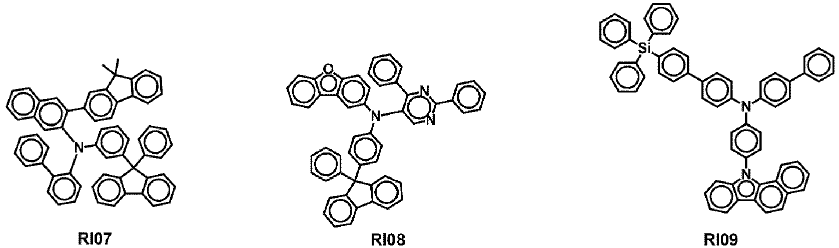

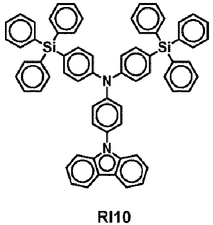

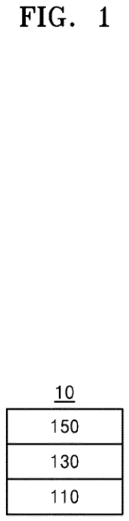

### Description of FIG. 1

FIG. 1 is a schematic cross-sectional view of a light-emitting device 10 according to one or more embodiments. The light-emitting device 10 may include a first electrode 110, an interlayer 130, and a second electrode 150.

Hereinafter, the structure of the light-emitting device 10 according to one or more embodiments and a method of manufacturing the light-emitting device 10 will be described in more detail with reference to FIG. 1.

### First electrode 110

In FIG. 1, in one or more embodiments, a substrate may be additionally provided and arranged under the first electrode 110 and/or on the second electrode 150. In one or more embodiments, as the substrate, a glass substrate or a plastic substrate may be utilized. In one or more embodiments, the substrate may be a flexible substrate, and may include plastics with excellent or suitable heat resistance and durability, such as polyimide, polyethylene terephthalate (PET), polycarbonate, polyethylene naphthalate, polyarylate (PAR), polyetherimide, or one or more combinations thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a semi-transmissive electrode, or a transmissive electrode. In one or more embodiments, when the first electrode 110 is a transmissive electrode, a material for forming the first electrode 110 may include indium tin oxide (ITO), indium zinc oxide (IZO), tin oxide (SnO₂), zinc oxide (ZnO), or one or more combinations thereof. In one or more embodiments, when the first electrode 110 is a semi-transmissive electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or one or more combinations thereof.

The first electrode 110 may have a single-layer structure including (e.g., consisting of) a single layer or a multi-layer structure including multiple layers. For example, in some embodiments, the first electrode 110 may have a three-layer structure of ITO/Ag/ITO.

### Interlayer 130

The interlayer 130 may be on the first electrode 110. The interlayer 130 may include the emission layer.

In one or more embodiments, the interlayer 130 may further include a hole transport region arranged between the first electrode 110 and the emission layer, and an electron transport region arranged between the emission layer and the second electrode 150.

In one or more embodiments, the interlayer 130 may further include, in addition to one or more suitable organic materials, a metal-containing compound such as an organometallic compound, for example, the organometallic compound represented by Formula 1, an inorganic material such as quantum dots, and/or the like.

In one or more embodiments, the interlayer 130 may include i) two or more emitting units sequentially stacked between the first electrode 110 and the second electrode 150, and ii) a charge generation layer located between two neighboring emitting units. When the interlayer 130 includes the two or more emitting units and the charge generation layer, the light-emitting device 10 may be a tandem light-emitting device.

### Hole transport region in interlayer 130

The hole transport region may have: i) a single-layer structure including (e.g., consisting of) a single layer including (e.g., consisting of) a single material, ii) a single-layer structure including (e.g., consisting of) a single layer including (e.g., consisting of) multiple materials that are different from each other, or iii) a multi-layer structure including multiple layers including multiple materials that are different from each other.

In one or more embodiments, the hole transport region may include a first layer as described herein. The hole transport region may optionally further include at least one of a second layer or a third layer, in addition to the first layer.

When the hole transport region includes a third layer, a second layer, and a first layer, the third layer, the second layer, and the first layer may have a structure in which the third layer, the second layer, and the first layer are sequentially stacked on the first electrode 110 (e.g., in the stated order). The first layer may be in direct contact with the emission layer.

In one or more embodiments, the hole transport region may further include, in addition to the first layer, a hole injection layer, a hole transport layer, an emission auxiliary layer, an electron-blocking layer, or one or more combinations thereof.

The hole transport region may include a compound represented by Formula 201, a compound represented by Formula 202, or a combination thereof: 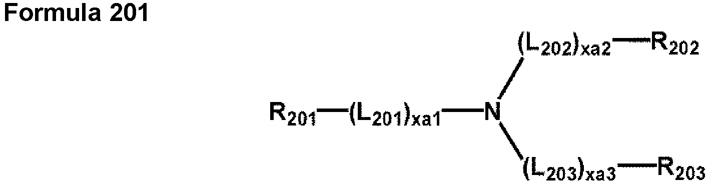 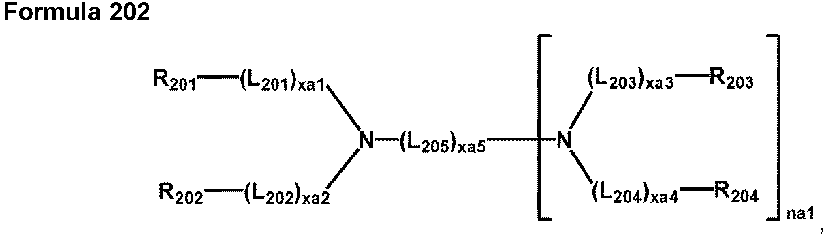 wherein, in Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ to form a C₈-C₆₀ polycyclic group (for example, a carbazole group and/or the like) unsubstituted or substituted with at least one R₁₀ₐ,
R₂₀₃ and R₂₀₄ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.
For example, in one or more embodiments, the first material, the second material, and the third material described in the present disclosure may each be a compound that satisfies the conditions described in the present disclosure (for example, the HOMO energy level condition) from among the compounds represented by Formula 201 and the compounds represented by Formula 202.

For example, in some embodiments, each of Formulae 201 and 202 may include at least one selected from groups represented by Formulae CY201 to CY217:

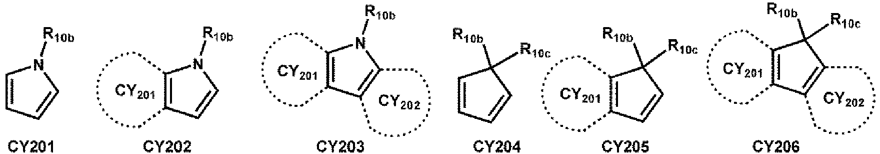

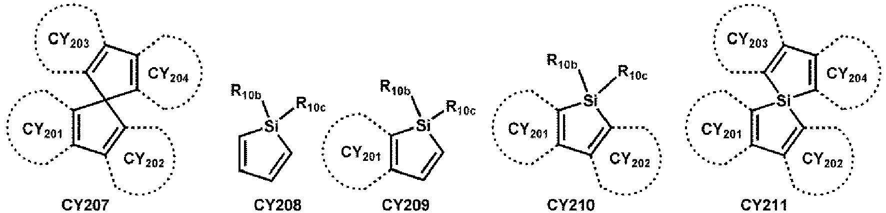

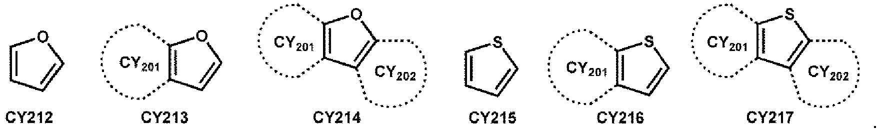

In Formulae CY201 to CY217, R_{10b} and R_{10c} may each be the same as described with respect to R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In one or more embodiments, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one selected from the groups represented by Formulae CY201 to CY203.

In one or more embodiments, Formula 201 may include each of at least one selected from the groups represented by Formulae CY201 to CY203 and at least one selected from the groups represented by Formulae CY204 to CY217.

In one or more embodiments, in Formula 201, xa1 may be 1, R₂₀₁ may be one selected from the groups represented by Formulae CY201 to CY203, xa2 may be 0, and R₂₀₂ may be one selected from the groups represented by Formulae CY204 to CY207.

In one or more embodiments, each of Formulae 201 and 202 may not include (e.g., may exclude or be free of) any groups represented by Formulae CY201 to CY203.

In one or more embodiments, each of Formulae 201 and 202 may not include (e.g., may exclude or be free of) any groups represented by Formulae CY201 to CY203, and may include at least one selected from the groups represented by Formulae CY204 to CY217.

In one or more embodiments, each of Formulae 201 and 202 may not include (e.g., may exclude or be free of) any groups represented by Formulae CY201 to CY217.

A thickness of the hole transport region may be in a range of about 5 nm (50 Å) to about 1,000 nm (10,000 Å), for example, about 10 nm (100 Å) to about 400 nm (4,000 Å). In this regard, a thickness of the third layer may be from about 2 nm (20 Å) to about 700 nm (7000 Å), a thickness of the second layer may be from about 2 nm (20 Å) to about 400nm (4000 Å), and a thickness of the first layer may be from about 1 nm (10 Å) to about 400 nm (4000 Å). When the thickness of each of the hole transport region, the third layer, the second layer, and the first layer are within these ranges, satisfactory hole-transporting characteristics may be obtained without a substantial increase in driving voltage.

Compounds that may be included in the hole transport region, for example, examples of compounds that may be included in each of the first layer, the second layer, and the third layer may include at least one selected from among Compounds HT01 to HT10, R'01 to R'10, and RI01 to RI10.

### p-dopant

In one or more embodiments, the hole transport region may further include, in addition to these aforementioned materials, a charge-generation material for the improvement of conductive properties. The charge-generation material may be substantially uniformly or non-uniformly dispersed in the hole transport region (for example, in the form of a single layer including (e.g., consisting of) a charge-generation material).

The charge-generation material may be, for example, a p-dopant.

For example, in some embodiments, the p-dopant may have a LUMO energy level of -3.5 eV or less.

In one or more embodiments, the p-dopant may include a quinone derivative, a cyano group-containing compound, a compound including element EL1 and element EL2, or one or more combinations thereof.

Non-limiting examples of the quinone derivative may be tetracyanoquinodimethane (TCNQ), 2,3,5,6-tetrafluoro-7,7,8,8-tetracyanoquinodimethane (F4-TCNQ), and/or the like.

Non-limiting examples of the cyano group-containing compound may include dipyrazino[2,3-f: 2',3'-h] quinoxaline-2,3,6,7,10,11-hexacarbonitrile (HAT-CN (or HAT)), a compound represented by Formula 221, and/or the like: 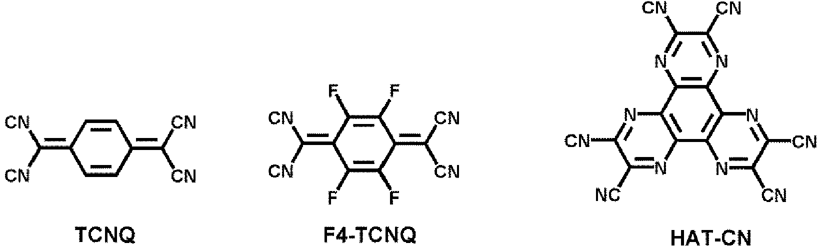 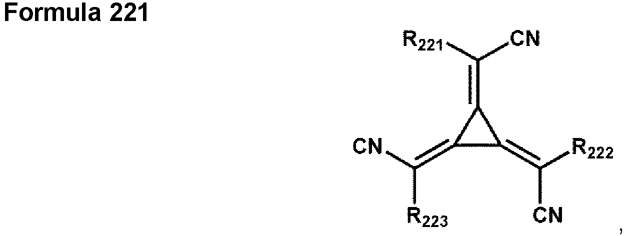 wherein, in Formula 221,
R₂₂₁ to R₂₂₃ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ, and
at least one selected from among R₂₂₁ to R₂₂₃ may each independently be a C₃-C₆₀ carbocyclic group or a C₁-C₆₀ heterocyclic group, each substituted with: a cyano group; -F; -Cl; -Br; -I; a C₁-C₂₀ alkyl group substituted with a cyano group, -F, -Cl, -Br, - I, or one or more combinations thereof; or one or more combinations thereof.

In the compound including element EL1 and element EL2, element EL1 may be metal, metalloid, or a combination thereof, and element EL2 may be non-metal, metalloid, or a combination thereof.

Non-limiting examples of the metal may be an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.); and/or the like.

Non-limiting examples of the metalloid may be silicon (Si), antimony (Sb), tellurium (Te), and/or the like.

Non-limiting examples of the non-metal may be oxygen (O), a halogen (for example, F, Cl, Br, I, etc.), and/or the like.

Non-limiting examples of the compound including element EL1 and element EL2 may be metal oxides, metal halides (for example, metal fluorides, metal chlorides, metal bromides, metal iodides, etc.), metalloid halides (for example, metalloid fluorides, metalloid chlorides, metalloid bromides, metalloid iodides, etc.), metal tellurides, or one or more combinations thereof.

Non-limiting examples of the metal oxide may be tungsten oxides (for example, WO, W₂O₃, WO₂, WO₃, W₂O₅, etc.), vanadium oxides (for example, VO, V₂O₃, VO₂, V₂O₅, etc.), molybdenum oxides (for example, MoO, Mo₂O₃, MoO₂, MoO₃, Mo₂O₅, etc.), rhenium oxides (for example, ReO₃, etc.), and/or the like.

Non-limiting examples of the metal halide may be alkali metal halides, alkaline earth metal halides, transition metal halides, post-transition metal halides, lanthanide metal halides, and/or the like.

Non-limiting examples of the alkali metal halide may be LiF, NaF, KF, RbF, CsF, LiCl, NaCl, KCI, RbCl, CsCl, LiBr, NaBr, KBr, RbBr, CsBr, Lil, Nal, KI, Rbl, CsI, and/or the like.

Non-limiting examples of the alkaline earth metal halide may be BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, BaI₂, and/or the like.

Non-limiting examples of the transition metal halide may be titanium halides (for example, TiF₄, TiCl₄, TiBr₄, TiI₄, etc.), zirconium halides (for example, ZrF₄, ZrCl₄, ZrBr₄, ZrI₄, etc.), hafnium halides (for example, HfF₄, HfCl₄, HfBr₄, HfI₄, etc.), vanadium halides (for example, VF₃, VCl₃, VBr₃, VI₃, etc.), niobium halides (for example, NbF₃, NbCl₃, NbBr₃, NbI₃, etc.), tantalum halides (for example, TaF₃, TaCl₃, TaBr₃, TaI₃, etc.), chromium halides (for example, CrF₃, CrCl₃, CrBr₃, CrI₃, etc.), molybdenum halides (for example, MoF₃, MoCl₃, MoBr₃, MoI₃, etc.), tungsten halides (for example, WF₃, WCl₃, WBr₃, WI₃, etc.), manganese halides (for example, MnF₂, MnCl₂, MnBr₂, MnI₂, etc.), technetium halides (for example, TcF₂, TcCl₂, TcBr₂, TcI₂, etc.), rhenium halides (for example, ReF₂, ReCl₂, ReBr₂, ReI₂, etc.), ferrous halides (for example, FeF₂, FeCl₂, FeBr₂, FeI₂, etc.), ruthenium halides (for example, RuF₂, RuCl₂, RuBr₂, RuI₂, etc.), osmium halides (for example, OsF₂, OsCl₂, OsBr₂, OsI₂, etc.), cobalt halides (for example, CoF₂, CoCl₂, CoBr₂, CoI₂, etc.), rhodium halides (for example, RhF₂, RhCl₂, RhBr₂, RhI₂, etc.), iridium halides (for example, IrF₂, IrCl₂, IrBr₂, IrI₂, etc.), nickel halides (for example, NiF₂, NiCl₂, NiBr₂, NiI₂, etc.), palladium halides (for example, PdF₂, PdCl₂, PdBr₂, PdI₂, etc.), platinum halides (for example, PtF₂, PtCl₂, PtBr₂, PtI₂, etc.), cuprous halides (for example, CuF, CuCl, CuBr, Cul, etc.), silver halides (for example, AgF, AgCl, AgBr, AgI, etc.), gold halides (for example, AuF, AuCl, AuBr, Aul, etc.), and/or the like.

Non-limiting examples of the post-transition metal halide may be zinc halides (for example, ZnF₂, ZnCl₂, ZnBr₂, ZnI₂, etc.), indium halides (for example, InI₃, etc.), tin halides (for example, SnI₂, etc.), and/or the like.

Non-limiting examples of the lanthanide metal halide may be YbF, YbF₂, YbF₃, SmF₃, YbCl, YbCl₂, YbCl₃, SmCl₃, YbBr, YbBr₂, YbBr₃, SmBr₃, Ybl, YbI₂, YbI₃, SmI₃, and/or the like.

Non-limiting examples of the metalloid halide may be antimony halides (for example, SbCls, etc.) and/or the like.

Non-limiting examples of the metal telluride may be alkali metal tellurides (for example, Li₂Te, Na₂Te, K₂Te, Rb₂Te, Cs₂Te, etc.), alkaline earth metal tellurides (for example, BeTe, MgTe, CaTe, SrTe, BaTe, etc.), transition metal tellurides (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), post-transition metal tellurides (for example, ZnTe, etc.), lanthanide metal tellurides (for example, LaTe, CeTe, PrTe, NdTe, PmTe, EuTe, GdTe, TbTe, DyTe, HoTe, ErTe, TmTe, YbTe, LuTe, etc.), and/or the like.

### Emission layer in interlayer 130

When the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers selected from a red emission layer, a green emission layer, and a blue emission layer, in which the two or more layers contact each other or are separated from each other, to emit white light (e.g., combined white light). In one or more embodiments, the emission layer may include two or more materials selected from a red light-emitting material, a green light-emitting material, and a blue light-emitting material, in which the two or more materials are mixed with each other in a single layer, to emit white light (e.g., combined white light).

According to one or more embodiments, in addition to the first emitter and the first host as described herein, the emission layer may further include an auxiliary dopant, a sensitizer, a delayed fluorescence material, or one or more combinations thereof.

An amount of the first emitter in the emission layer may be about 0.01 parts by weight to about 15 parts by weight based on 100 parts by weight of the emission layer. When the amount of the first emitter satisfies the range described above, excellent or suitable luminous efficiency may be achieved without a substantial increase in driving voltage.

A thickness of the emission layer may be in a range of about 10 nm (100 Å) to about 100 nm (1,000 Å), for example, about 20 nm (200 Å) to about 60 nm (600 Å). When the thickness of the emission layer is within these ranges, excellent or suitable luminescence characteristics may be obtained without a substantial increase in driving voltage.

Each of the first emitter and the first host of the emission layer may be the same as described in the present disclosure.

### Fluorescent dopant

In one or more embodiments, the emission layer may further include a fluorescent dopant in addition to the first emitter and first host as described herein.

In one or more embodiments, the fluorescent dopant may include an arylamine compound, a styrylamine compound, a boron-containing compound, or one or more combinations thereof.

For example, in some embodiments, the fluorescent dopant may include a compound represented by Formula 501: 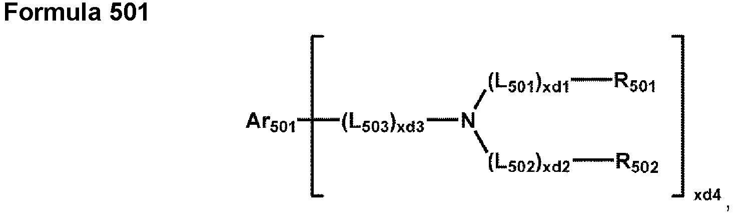 wherein, in Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

In some embodiments, Ar₅₀₁ in Formula 501 may be a condensed cyclic group (for example, an anthracene group, a chrysene group, a pyrene group, etc.) in which three or more monocyclic groups are condensed together.

In some embodiments, xd4 in Formula 501 may be 2.

For example, in one or more embodiments, the fluorescent dopant may include: at least one selected from among Compounds FD1 to FD36; 4,4'-bis(2,2-diphenylvinyl)-1,1'-biphenyl (DPVBi); 4,4'-bis[4-(N,N-diphenylamino)styryl]biphenyl (DPAVBi); or one or more combinations thereof:

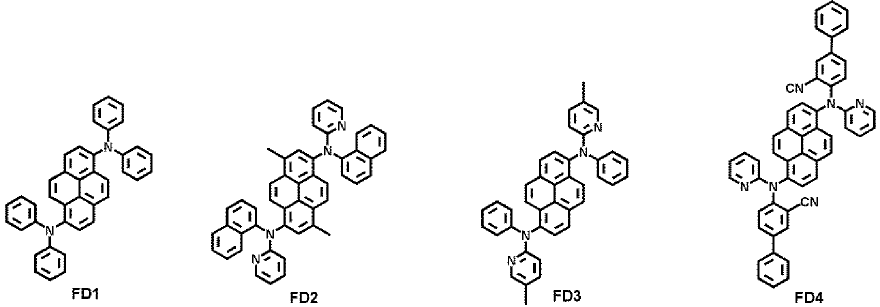

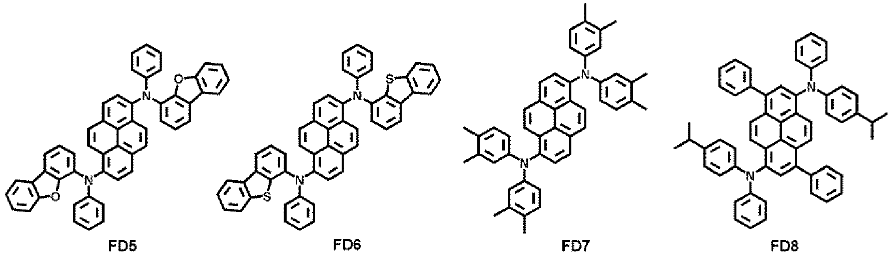

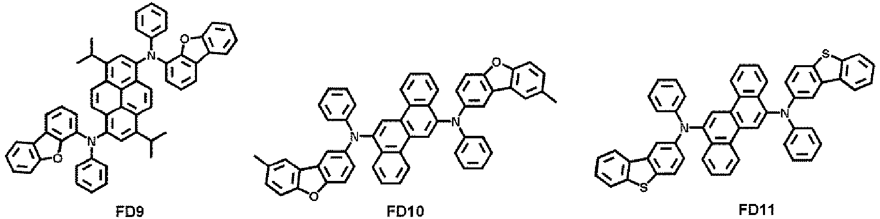

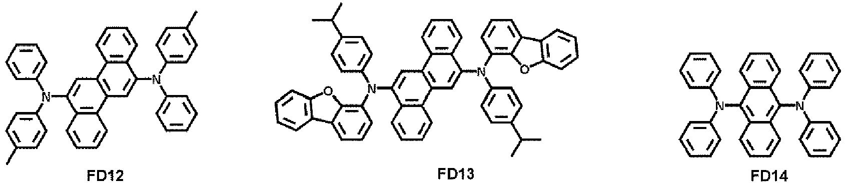

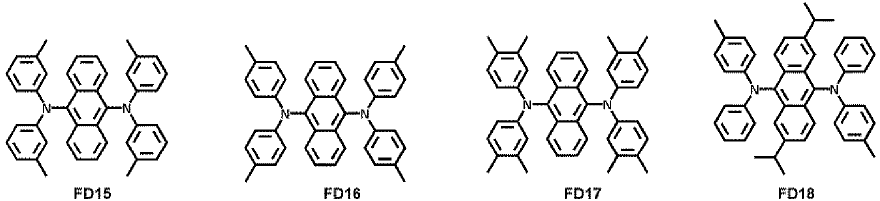

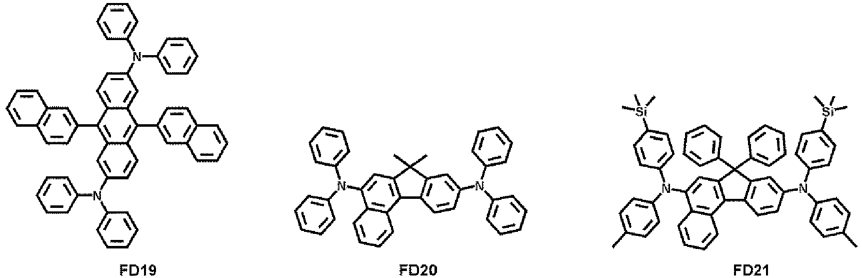

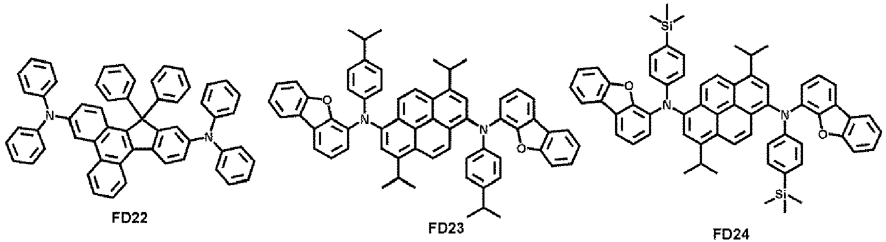

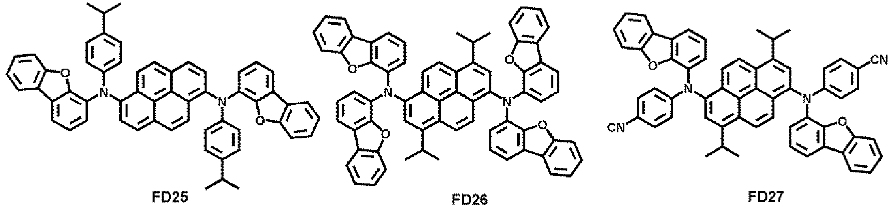

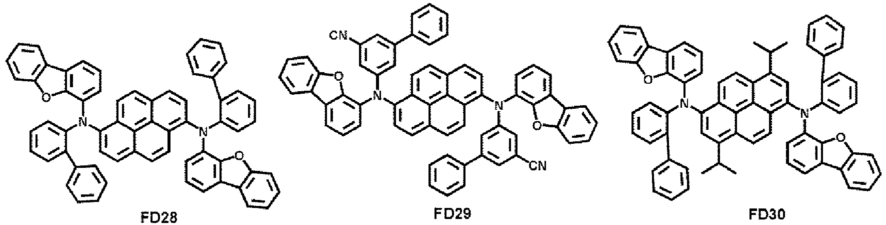

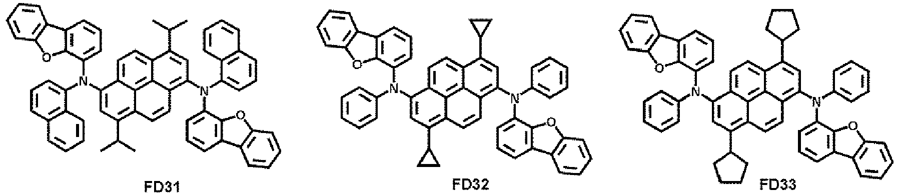

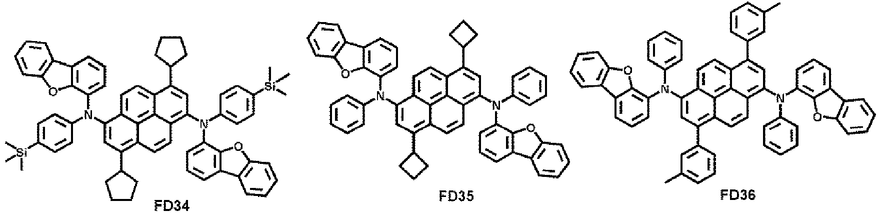

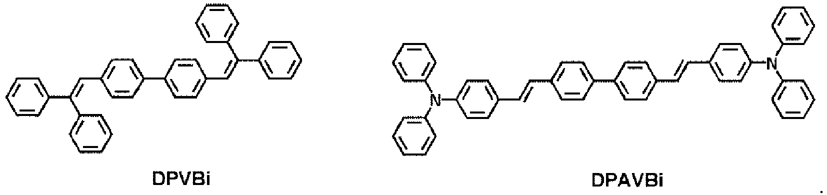

### Delayed fluorescence material

In one or more embodiments, the emission layer may further include a delayed fluorescence material in addition to the first emitter and the first host.

The delayed fluorescence material utilized herein may be selected from compounds capable of emitting delayed fluorescence based on a delayed fluorescence emission mechanism.

The delayed fluorescence material included in the emission layer may act as a host or a dopant depending on the type or kind of other materials included in the emission layer.

In one or more embodiments, a difference between a triplet energy level (eV) of the delayed fluorescence material and a singlet energy level (eV) of the delayed fluorescence material may be greater than or equal to 0 eV and less than or equal to 0.5 eV. When the difference between the triplet energy level (eV) of the delayed fluorescence material and the singlet energy level (eV) of the delayed fluorescence material is satisfied within the range above, up-conversion from the triplet state to the singlet state of the delayed fluorescence materials may effectively occur, and thus, the light-emitting device 10 may have improved luminescence efficiency.

For example, in one or more embodiments, the delayed fluorescence material may include: i) a material including at least one electron donor (for example, a π electron-rich C₃-C₆₀ cyclic group and/or the like, such as a carbazole group) and at least one electron acceptor (for example, a sulfoxide group, a cyano group, a π electron-deficient nitrogen-containing C₁-C₆₀ cyclic group, and/or the like), ii) a material including a C₈-C₆₀ polycyclic group including at least two cyclic groups condensed to each other while sharing boron (B), and/or iii) the like.

Non-limiting examples of the delayed fluorescence material may include at least one selected from Compounds DF1 to DF14:

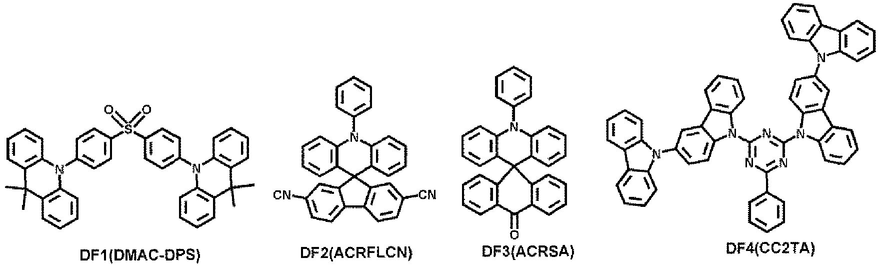

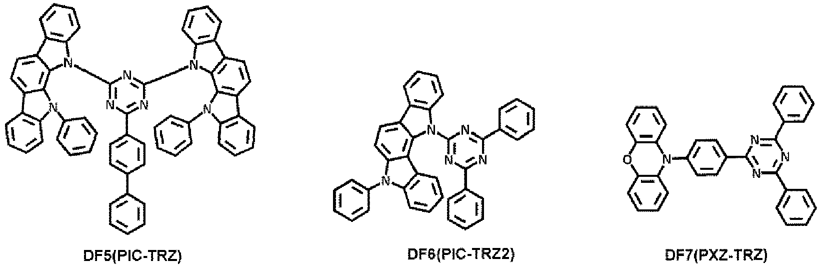

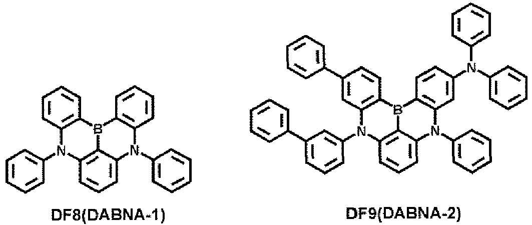

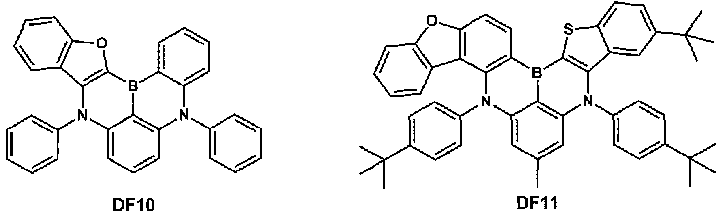

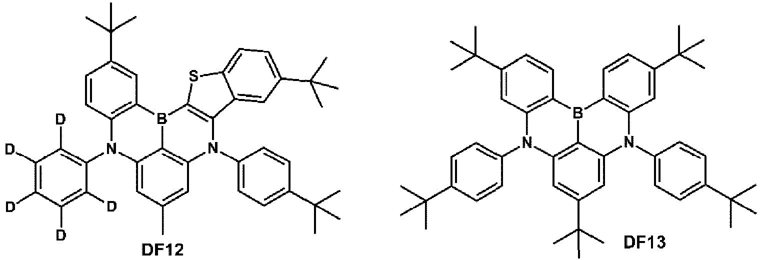

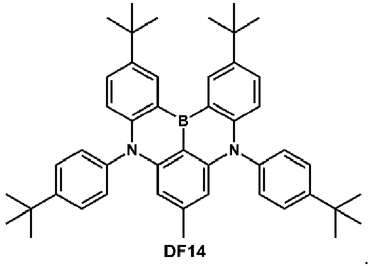

### Electron transport region in interlayer 130

The electron transport region 140 may have: i) a single-layer structure including (e.g., consisting of) a single layer including (e.g., consisting of) a single material, ii) a single-layer structure including (e.g., consisting of) a single layer including (e.g., consisting of) multiple materials that are different from each other, or iii) a multi-layer structure including multiple layers including multiple materials that are different from each other.

The electron transport region may include a buffer layer, a hole-blocking layer, an electron control layer, an electron transport layer, an electron injection layer, or one or more combinations thereof.

For example, in one or more embodiments, the electron transport region may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, wherein constituent layers of each structure are sequentially stacked from the emission layer in each stated order.

According to one or more embodiments, the electron transport region may include a buffer layer and an electron transport layer, the buffer layer may be between the emission layer and the second electrode 150, and the electron transport layer may be between the buffer layer and the second electrode 150. For example, the light-emitting device may have a structure in which the buffer layer and the electron transport layer are sequentially stacked from the emission layer (e.g., in the stated order).

In one or more embodiments, a LUMO energy level of a buffer layer material included in the buffer layer may be about -2.20 eV to about -1.80 eV, or about -2.02 eV to about -1.95 eV.

According to one or more embodiments, an electron mobility of the buffer layer material included in the buffer layer may be about 1.00 x 10⁻⁵ cm²/(Vs) to about 5.00 x 10⁻³ cm²/(Vs), or about 2.57 x 10⁻⁴ cm²/(Vs) to about 1.17 x 10⁻⁴ cm²/(Vs).

According to one or more embodiments, a LUMO energy level of an electron transport layer material included in the electron transport layer may be about -2.50 eV to about -2.00 eV, or about -2.17 eV to about -2.12 eV.

According to one or more embodiments, an electron mobility of the electron transport layer material included in the electron transport layer may be about 1.00 x 10⁻⁴ cm²/(Vs) to about 3.00 x 10⁻³ cm²/(Vs), or about 1.04 x 10⁻⁴ cm²/(Vs) to about 1.20 x 10⁻³ cm²/(Vs).

According to one or more embodiments, an absolute value of the LUMO energy level of the buffer layer material may be greater than an absolute value of the LUMO energy level of the first host.

According to one or more embodiments, an absolute value of a difference between the LUMO energy level of the first host and the LUMO energy level of the buffer layer material may be 0 eV to about 0.60 eV, or 0 eV to about 0.54 eV.

According to one or more embodiments, an absolute value of the LUMO energy level of the electron transport layer material may be greater than an absolute value of the LUMO energy level of the buffer layer material.

According to one or more embodiments, the absolute value of the LUMO energy level of the electron transport layer material may be smaller than the absolute value of the LUMO energy level of the buffer layer material.

According to one or more embodiments, an absolute value of a difference between the LUMO energy level of the buffer layer material and the LUMO energy level of the electron transport layer material may be about 0 eV to about 0.30 eV.

In one or more embodiments, the electron transport region (for example, the buffer layer, the hole-blocking layer, the electron control layer, and/or the electron transport layer in the electron transport region) may include a metal-free compound including at least one π electron-deficient nitrogen-containing C₁-C₆₀ cyclic group.

For example, in one or more embodiments, the electron transport region may include a compound represented by Formula 601:

**Formula 601** [Ar₆₀₁]ₓₑ₁₁-[(L₆₀₁)ₓₑ₁-R₆₀₁]ₓₑ₂₁,

wherein, in Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be the same as described with respect to Q₁,
xe21 may be 1, 2, 3, 4, or 5, and
at least one selected from among Ar₆₀₁, L₆₀₁, and R₆₀₁ may each independently be a π electron-deficient nitrogen-containing C₁-C₆₀ cyclic group unsubstituted or substituted with at least one R₁₀ₐ (for example, a pyridine group, a pyrimidine group, a pyrazine group, a pyridazine group, a triazine group, a quinoline group, a isoquinoline group, a oxadiazole group, a thiadiazole group, an imidazole group, a benzimidazole group, a quinoxaline group, a quinazoline group, etc., each unsubstituted or substituted with at least one R₁₀ₐ).

In one or more embodiments, when xe11 in Formula 601 is 2 or more, two or more of Ar₆₀₁(s) may be linked to each other via a single bond.

In one or more embodiments, Ar₆₀₁ in Formula 601 may be an anthracene group unsubstituted or substituted with at least one R₁₀ₐ. R₁₀ₐ is the same as described herein.

According to one or more embodiments, the electron transport region may include a buffer layer and an electron transport layer sequentially stacked on the emission layer, and each of the buffer layer material and the electron transport layer material may be a compound that satisfies the conditions described in the present disclosure (for example, the LUMO energy level) from among compounds represented by Formula 601.

In one or more embodiments, the electron transport region may include a compound represented by Formula 601-1: 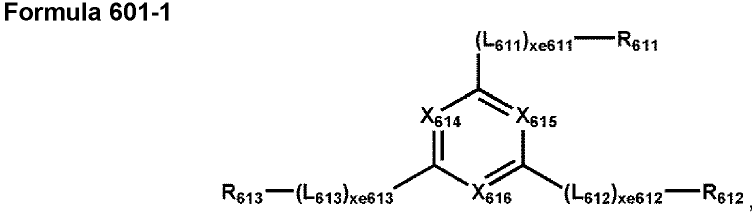 wherein, in Formula 601-1,
X₆₁₄ may be N or C(R₆₁₄), X₆₁₅ may be N or C(R₆₁₅), X₆₁₆ may be N or C(R₆₁₆), and at least one selected from among X₆₁₄ to X₆₁₆ may be N,
L₆₁₁ to L₆₁₃ may each be the same as described with respect to L₆₀₁,
xe611 to xe613 may each be the same as described with respect to xe1,
R₆₁₁ to R₆₁₃ may each be the same as described with respect to R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

For example, in some embodiments, xe1 and xe611 to xe613 in Formulae 601 and 601-1 may each independently be 0, 1, or 2.

According to one or more embodiments, the electron transport region may include a buffer layer, and the buffer layer material may be at least one selected from among BF01 to BF10:

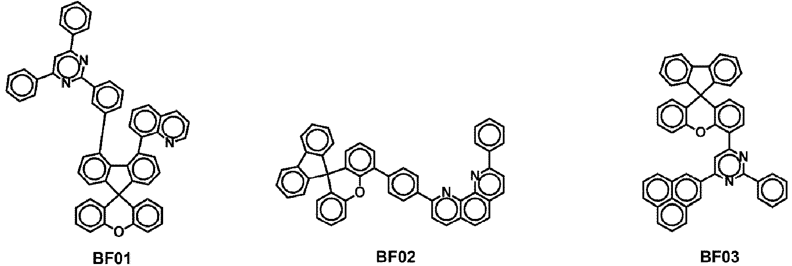

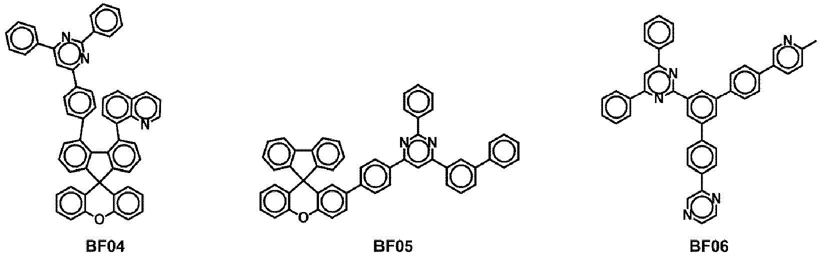

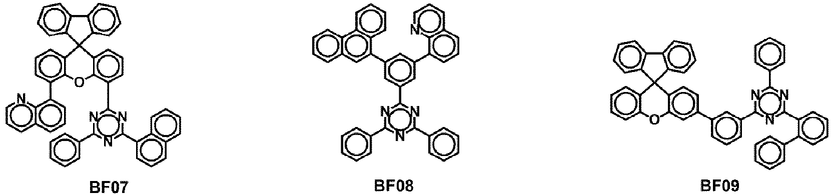

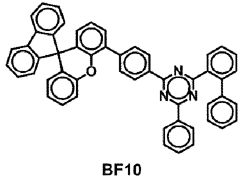

According to one or more embodiments, the electron transport region may include an electron transport layer, and the electron transport layer material may be at least one selected from among ET01 to ET10:

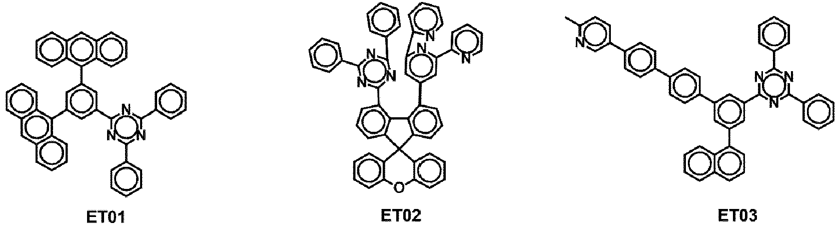

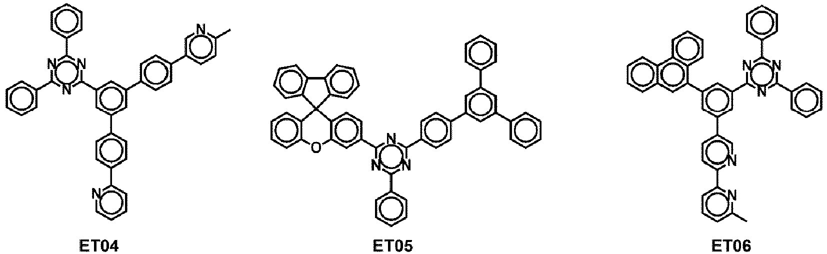

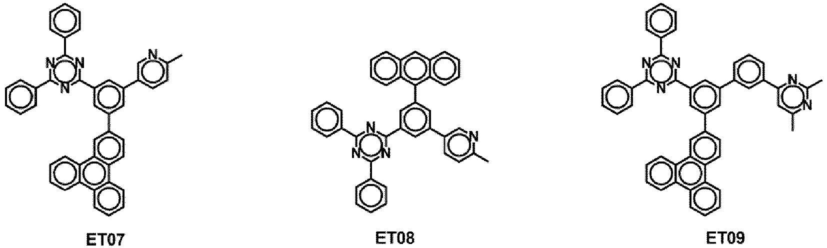

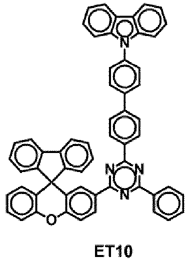

A thickness of the electron transport region may be in a range of about 10 nm (100 Å) to about 500 nm (5,000 Å), for example, about 16 nm (160 Å) to about 400 nm (4,000 Å). When the electron transport region includes a buffer layer, a hole-blocking layer, an electron control layer, a thickness of the buffer layer, the hole-blocking layer, or the electron control layer may each independently be about 2 nm (20 Å) to about 100 nm (1000 Å), for example, about 3 nm (30 Å) to about 30 nm (300 Å), and a thickness of the electron transport layer may be about 10 nm (100 Å) to about 100 nm (1000 Å), for example, about 15 nm (150 Å) to about 50 nm (500 Å). When the thicknesses of the buffer layer, the hole-blocking layer, the electron control layer, the electron transport layer, and/or the electron transport region are within these ranges, satisfactory electron-transporting characteristics may be obtained without a substantial increase in driving voltage.

In one or more embodiments, the electron transport region (for example, the electron transport layer in the electron transport region) may further include, in addition to the materials described above, a metal-containing material.

The metal-containing material may include an alkali metal complex, an alkaline earth metal complex, or a combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the metal ion of the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or one or more combinations thereof.

For example, in some embodiments, the metal-containing material may include a Li complex. The Li complex may include, for example, Compound ET-D1 (LiQ) or ET-D2:

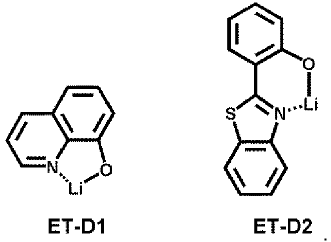

In one or more embodiments, the electron transport region may include an electron injection layer that facilitates the injection of electrons from the second electrode 150. The electron injection layer may be in direct contact with the second electrode 150.

The electron injection layer may have: i) a single-layered structure including (e.g., consisting of) a single layer including (e.g., consisting of) a single material, ii) a single-layered structure including (e.g., consisting of) a single layer including multiple materials that are different from each other, or iii) a multi-layered structure including multiple layers including multiple materials that are different from each other.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or one or more combinations thereof.

The alkali metal may include Li, Na, K, Rb, Cs, or one or more combinations thereof. The alkaline earth metal may include Mg, Ca, Sr, Ba, or one or more combinations thereof. The rare earth metal may include Sc, Y, Ce, Tb, Yb, Gd, or one or more combinations thereof.

The alkali metal-containing compound, the alkaline earth metal-containing compound, and the rare earth metal-containing compound may be oxides, halides (for example, fluorides, chlorides, bromides, iodides, etc.), or tellurides of the alkali metal, the alkaline earth metal, and the rare earth metal, respectively, or one or more combinations thereof.

The alkali metal-containing compound may include: alkali metal oxide(s), such as Li₂O, Cs₂O, K₂O, etc.; alkali metal halide(s), such as LiF, NaF, CsF, KF, Lil, Nal, CsI, KI, etc.; or one or more combinations thereof. The alkaline earth metal-containing compound may include an alkaline earth metal oxide, such as BaO, SrO, CaO, BaₓSr₁₋ₓO (wherein x is a real number satisfying 0<x<1), BaₓCa₁₋ₓO (wherein x is a real number satisfying 0<x<1), and/or the like. The rare earth metal-containing compound may include YbF₃, ScF₃, Sc₂O₃, Y₂O₃, Ce₂O₃, GdF₃, TbF₃, YbI₃, ScI₃, TbI₃, or one or more combinations thereof. In one or more embodiments, the rare earth metal-containing compound may include lanthanide metal tellurides. Non-limiting examples of the lanthanide metal telluride may be LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, and/or the like.

The alkali metal complex, the alkaline earth-metal complex, and the rare earth metal complex may include i) one of metal ions of the alkali metal, one of metal ions of the alkaline earth metal, and one of metal ions of the rare earth metal, respectively, and ii) a ligand bonded to the metal ions, for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or one or more combinations thereof.

In one or more embodiments, the electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or one or more combinations thereof, as described above. In one or more embodiments, the electron injection layer may further include an organic material (for example, a compound represented by Formula 601).

In one or more embodiments, the electron injection layer may include (e.g., consist of) i) an alkali metal-containing compound (for example, an alkali metal halide), or ii) a) an alkali metal-containing compound (for example, an alkali metal halide); and b) an alkali metal, an alkaline earth metal, a rare earth metal, or one or more combinations thereof. For example, in some embodiments, the electron injection layer may be a Kl:Yb co-deposited layer, an Rbl:Yb co-deposited layer, a LiF:Yb co-deposited layer, and/or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or one or more combinations thereof may be substantially uniformly or non-uniformly dispersed in a matrix including the organic material.

A thickness of the electron injection layer may be in a range of about 0.1 nm (1 Å) to about 10 nm (100 Å), for example, about 0.3 nm (3 Å) to about 9 nm (90 Å). When the thickness of the electron injection layer is within these ranges, satisfactory electron injection characteristics may be obtained without a substantial increase in driving voltage.

### Second electrode 150

The second electrode 150 may be on the interlayer 130 having the aforementioned structure. The second electrode 150 may be a cathode, which is an electron injection electrode, and as a material for forming the second electrode 150, a metal, an alloy, an electrically conductive compound, or one or more combinations thereof, each having a low-work function, may be utilized.

The second electrode 150 may include Li, Ag, Mg, Al, Al-Li, Ca, Mg-In, Mg-Ag, Yb, Ag-Yb, ITO, IZO, or one or more combinations thereof. The second electrode 150 may be a transmissive electrode, a semi-transmissive electrode, or a reflective electrode.

The second electrode 150 may have a single-layer structure or a multi-layer structure including multiple layers.

### Capping layer

A first capping layer may be arranged outside (e.g., on) the first electrode 110, and/or a second capping layer may be arranged outside (e.g., on) the second electrode 150. In one or more embodiments, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

In some embodiments, light generated in the emission layer of the interlayer 130 of the light-emitting device 10 may be extracted toward the outside through the first electrode 110 which is a semi-transmissive electrode or a transmissive electrode, and the first capping layer. In some embodiments, light generated in the emission layer of the interlayer 130 of the light-emitting device 10 may be extracted toward the outside through the second electrode 150 which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 is increased, so that the luminescence efficiency of the light-emitting device 10 may be improved.

For example, at least one of the first capping layer or the second capping layer may include a material having a refractive index of 1.6 or more, 1.8 or more, or 2.0 or more at a wavelength of 589 nm.

The first capping layer and the second capping layer may each independently be an organic capping layer including an organic material, an inorganic capping layer including an inorganic material, or an organic-inorganic composite capping layer including an organic material and an inorganic material.

At least one of the first capping layer or the second capping layer may (e.g., the first capping layer and the second capping layer may each independently) include a carbocyclic compound, a heterocyclic compound, an amine group-containing compound, a porphine derivative, a phthalocyanine derivative, a naphthalocyanine derivative, an alkali metal complex, an alkaline earth metal complex, or one or more combinations thereof. The carbocyclic compound, the heterocyclic compound, and the amine group-containing compound may each optionally be substituted with a substituent including O, N, S, Se, Si, F, Cl, Br, I, or one or more combinations thereof. In one or more embodiments, at least one of the first capping layer or the second capping layer may (e.g., the first capping layer and the second capping layer may each independently) include an amine group-containing compound.

In one or more embodiments, at least one of the first capping layer or the second capping layer may (e.g., the first capping layer and the second capping layer may each independently) include a compound represented by Formula 201, a compound represented by Formula 202, or a combination thereof.

According to one or more embodiments, at least one of the first capping layer or the second capping layer may (e.g., the first capping layer and the second capping layer may each independently) include at least one selected from Compounds HT28 to HT33, at least one selected from Compounds CP1 to CP8, β-NPB, and/or one or more compounds (and/or combinations) thereof:

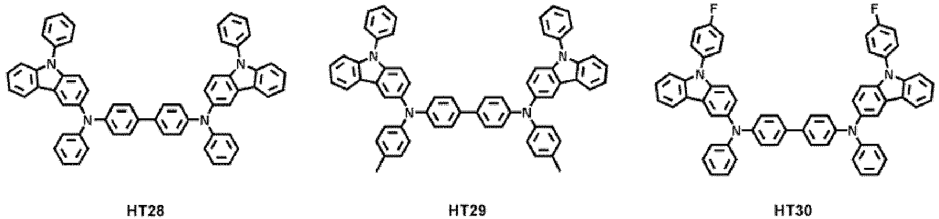

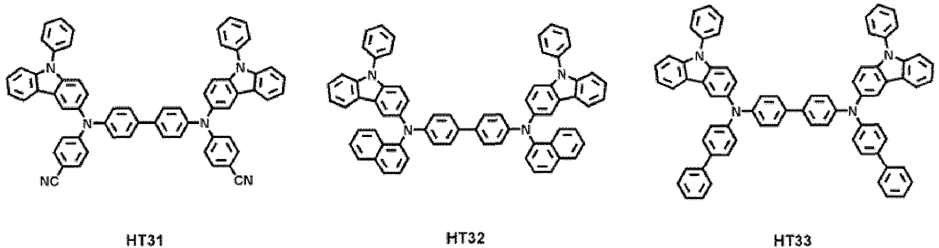

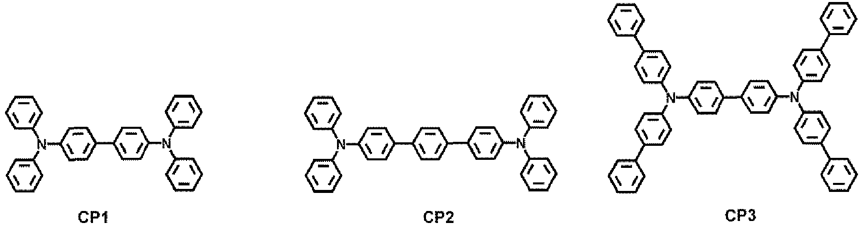

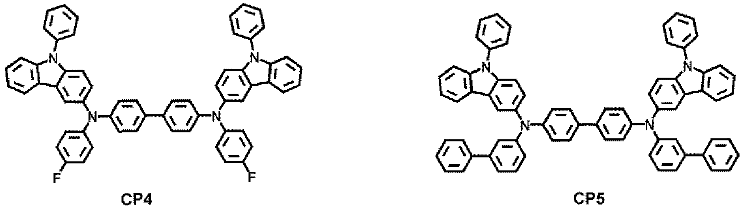

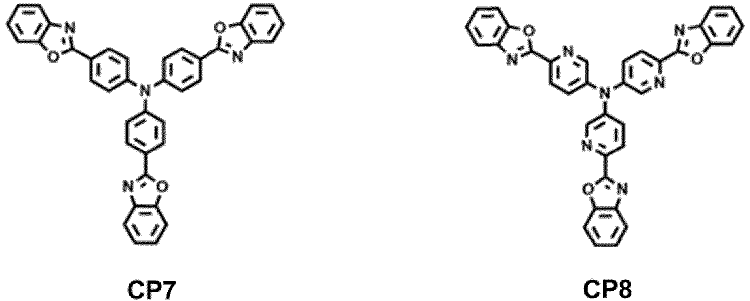

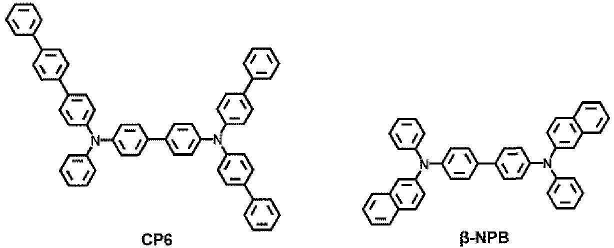

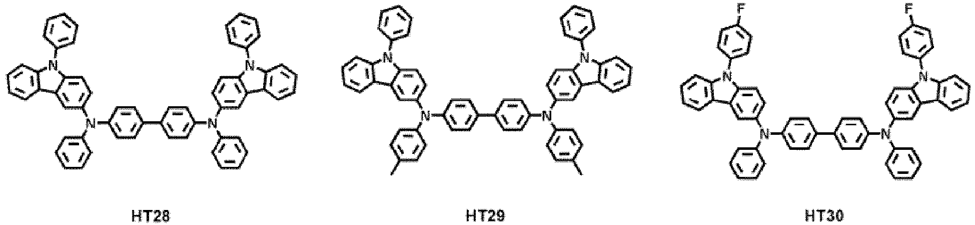

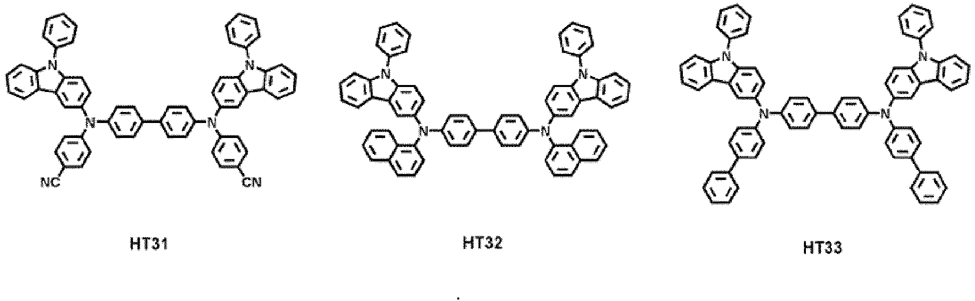

### Electronic device

The light-emitting device may be included in one or more suitable electronic devices. For example, in one or more embodiments, the electronic device including the light-emitting device may be a light-emitting device, an authentication device, and/or the like.

In one or more embodiments, the electronic device (for example, a light-emitting device) may further include, in addition to the light-emitting device, i) a color filter, ii) a color conversion layer, or iii) a color filter and a color conversion layer. The color filter and/or the color conversion layer may be arranged in at least one travel direction of light emitted from the light-emitting device. For example, in some embodiments, light emitted from the light-emitting device may be blue light, green light, or white light (e.g., combined white light). Details on the light-emitting device may be referred to the descriptions provided herein. In some embodiments, the color conversion layer may include a quantum dot.

The electronic device may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be arranged among the subpixel areas to define each of the subpixel areas.

The color filter may further include a plurality of color filter areas and light-shielding patterns arranged among the color filter areas, and the color conversion layer may further include a plurality of color conversion areas and light-shielding patterns arranged among the color conversion areas.

The plurality of color filter areas (or the plurality of color conversion areas) may include a first area configured to emit first color light, a second area configured to emit second color light, and/or a third area configured to emit third color light, wherein the first color light, the second color light, and/or the third color light may have different maximum emission wavelengths from one another. For example, in one or more embodiments, the first color light may be red light, the second color light may be green light, and the third color light may be blue light. For example, in one or more embodiments, the plurality of color filter areas (or the plurality of color conversion areas) may include quantum dots. In some embodiments, the first area may include a red quantum dot to emit red light, the second area may include a green quantum dot to emit green light, and the third area may not include (e.g., may exclude or be free of) any quantum dot. In one or more embodiments, the first area, the second area, and/or the third area may each further include a scatter.

For example, in one or more embodiments, the light-emitting device may be to emit first light, the first area may be to absorb the first light to emit first-first color light, the second area may be to absorb the first light to emit second-first color light, and the third area may be to absorb the first light to emit third-first color light. Here, the first-first color light, the second-first color light, and the third-first color light may have different maximum emission wavelengths. In some embodiments, the first light may be blue light, the first-first color light may be red light, the second-first color light may be green light, and the third-first color light may be blue light.

In one or more embodiments, the electronic device may further include a thin-film transistor, in addition to the light-emitting device as described above. The thin-film transistor may include a source electrode, a drain electrode, and an activation layer, wherein one selected from the source electrode and the drain electrode may be electrically connected to the first electrode or the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

In one or more embodiments, the electronic device may further include a sealing portion for sealing the light-emitting device. The sealing portion may be arranged between the color filter and/or the color conversion layer and the light-emitting device. The sealing portion allows light from the light-emitting device to be extracted to the outside, and concurrently (e.g., simultaneously) prevents ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin film encapsulation layer, the electronic device may be flexible.

Various functional layers may be additionally arranged on the sealing portion, in addition to the color filter and/or the color conversion layer, according to the utilization of the electronic device. Non-limiting examples of the functional layers may include a touch screen layer, a polarizing layer, and/or the like. The touch screen layer may be a pressure-sensitive touch screen layer, a capacitive touch screen layer, or an infrared touch screen layer.

The authentication apparatus may be, for example, a biometric authentication apparatus that authenticates an individual by utilizing biometric information of a living body (for example, fingertips, pupils, etc.). The authentication apparatus may further include, in addition to the light-emitting device as described above, a biometric information collector.

The electronic device may be applied to one or more of displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (for example, meters for a vehicle, an aircraft, and a vessel), projectors, and/or the like.

### Electronic apparatus

The light-emitting device may be included in one or more suitable electronic apparatuses.

For example, the electronic apparatus including the light-emitting device may be at least one of a flat panel display, a curved display, a computer monitor, a medical monitor, a television, a billboard, a light for indoor or outdoor lighting and/or signaling, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a 3D display, a virtual or augmented-reality display, a vehicle, a video wall including multiple displays tiled together, a theater or stadium screen, a phototherapy device, or a signboard.

Because the light-emitting device of the present invention has excellent or suitable effects in terms of luminescence efficiency long lifespan, the electronic apparatus including the light-emitting device may have characteristics with high luminance, high resolution, and low power consumption.

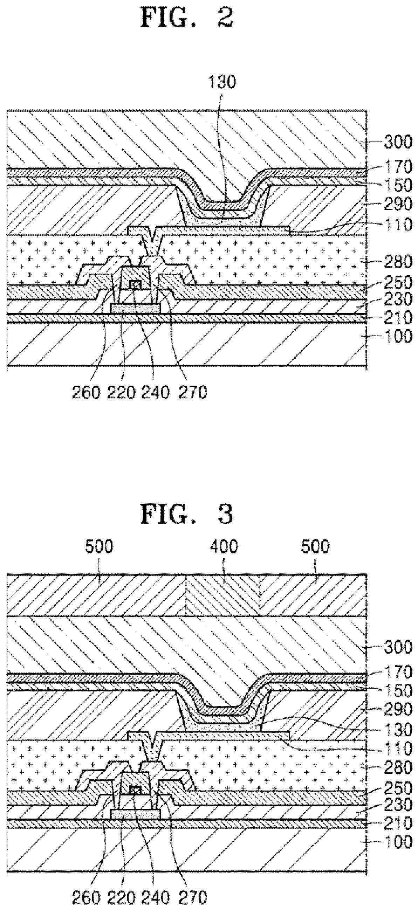

### Description of FIG. 2 and FIG. 3

FIG. 2 is a cross-sectional view showing a light-emitting apparatus as an example of an electronic device according to one or more embodiments of the present invention.

The light-emitting apparatus of FIG. 2 may include a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be on the substrate 100. The buffer layer 210 may prevent or reduce penetration of impurities through the substrate 100 and may provide a flat surface on the substrate 100.

The TFT may be on the buffer layer 210. The TFT may include an activation layer 220, a gate electrode 240, a source electrode 260, and a drain electrode 270.

The activation layer 220 may include an inorganic semiconductor, such as silicon or polysilicon, an organic semiconductor, or an oxide semiconductor, and may include a source region, a drain region, and a channel region.

A gate insulating film 230 for insulating the activation layer 220 from the gate electrode 240 may be on the activation layer 220, and the gate electrode 240 may be on the gate insulating film 230.

An interlayer insulating film 250 may be on the gate electrode 240. The interlayer insulating film 250 may be arranged between the gate electrode 240 and the source electrode 260 and between the gate electrode 240 and the drain electrode 270, to insulate from one another.

The source electrode 260 and the drain electrode 270 may be on the interlayer insulating film 250. The interlayer insulating film 250 and the gate insulating film 230 may be formed to expose the source region and the drain region of the activation layer 220, and the source electrode 260 and the drain electrode 270 may be arranged in contact with the exposed portions of the source region and the drain region of the activation layer 220, respectively.

The TFT may be electrically connected to the light-emitting device to drive the light-emitting device, and may be covered and protected by a passivation layer 280. The passivation layer 280 may include an inorganic insulating film, an organic insulating film, or a combination thereof. The light-emitting device may be provided on the passivation layer 280. The light-emitting device may include a first electrode 110, an interlayer 130, and a second electrode 150.

The first electrode 110 may be on the passivation layer 280. The passivation layer 280 may be arranged to expose a portion of the drain electrode 270, not fully covering the drain electrode 270, and the first electrode 110 may be arranged to be connected to the exposed portion of the drain electrode 270.

A pixel defining layer 290 including an insulating material may be on the first electrode 110. The pixel defining layer 290 may expose a certain region of the first electrode 110, and the interlayer 130 may be formed in the exposed region of the first electrode 110. The pixel defining layer 290 may be a polyimide-based organic film or a polyacrylic-based organic film. In some embodiments, at least some layers of the interlayer 130 may extend beyond the upper portion of the pixel defining layer 290 to be arranged in the form of a common layer.

The second electrode 150 may be on the interlayer 130, and a second capping layer 170 may be additionally formed on the second electrode 150. The second capping layer 170 may be formed to cover the second electrode 150.

The encapsulation portion 300 may be on the second capping layer 170. The encapsulation portion 300 may be arranged on the light-emitting device to protect the light-emitting device from moisture and/or oxygen. The encapsulation portion 300 may include: an inorganic film including silicon nitride (SiNₓ), silicon oxide (SiOₓ), indium tin oxide, indium zinc oxide, or one or more combinations thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or one or more combinations thereof; or a combination of the inorganic film(s) and the organic film(s).

FIG. 3 is a cross-sectional view of a light-emitting apparatus as an example of an electronic device according to one or more embodiments of the present invention.

The light-emitting apparatus of FIG. 3 is substantially the same as the light-emitting apparatus of FIG. 2, except that a light-shielding pattern 500 and a functional region 400 are additionally arranged on the encapsulation portion 300. The functional region 400 may be i) a color filter area, ii) a color conversion area, or iii) a combination of the color filter area and the color conversion area. In one or more embodiments, the light-emitting device included in the light-emitting apparatus of FIG. 3 may be a tandem light-emitting device.

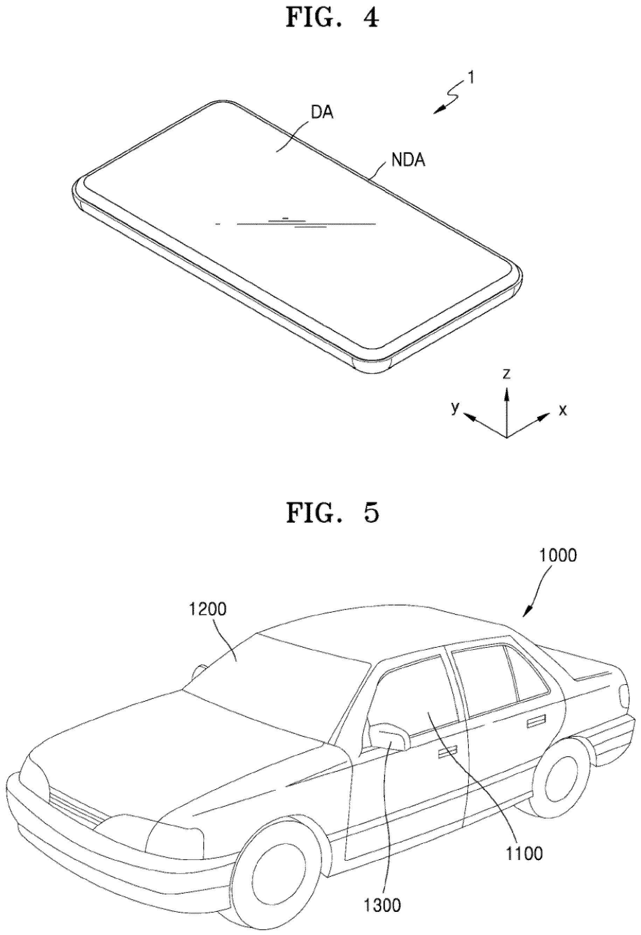

### Description of FIG. 4

FIG. 4 is a schematic perspective view of electronic apparatus 1 including a light-emitting device according to one or more embodiments. The electronic apparatus 1 may be, as a device apparatus that displays a moving image or still image, a portable electronic apparatus, such as a mobile phone, a smart phone, a tablet personal computer (PC), a mobile communication terminal, an electronic notebook, an electronic book, a portable multimedia player (PMP), a navigation, or a ultra-mobile PC (UMPC), and/or may be one or more suitable products, such as a television, a laptop, a monitor, a billboard, or an Internet of things (IOT). The electronic apparatus 1 may be such a product above or a part thereof. In some embodiments, the electronic apparatus 1 may be a wearable device, such as a smart watch, a watch phone, a glasses-type or kind display, or a head mounted display (HMD), or a part of the wearable device. However, embodiments of the present invention are not limited thereto. For example, in one or more embodiments, the electron apparatus 1 may include a dashboard of a vehicle, a center fascia of a vehicle, a center information display arranged on a dashboard of a vehicle, a room mirror display replacing a side mirror of a vehicle, an entertainment display for the rear seat of a vehicle or a display arranged on the back of the front seat, or a head up display (HUD) installed in the front of a vehicle or projected on a front window glass, and/or a computer generated hologram augmented reality head up display (CGH AR HUD). FIG. 4 illustrates an embodiment in which the electronic apparatus 1 is a smart phone for convenience of explanation.

The electronic apparatus 1 may include a display area DA and a non-display area NDA outside the display area DA. A display device of the electronic apparatus 1 may implement an image through an array of a plurality of pixels that are two-dimensionally arranged in the display area DA.

The non-display area NDA is an area that does not display an image, and may entirely surround the display area DA. On the non-display area NDA, a driver for providing electrical signals or power to display devices arranged on the display area DA may be arranged. On the non-display area NDA, a pad, which is an area to which an electronic element or a printing circuit board may be electrically connected, may be arranged.

In the electronic apparatus 1, a length in the x-axis direction and a length in the y-axis direction may be different from each other. In some embodiments, as shown in FIG. 4, the length in the x-axis direction may be shorter than the length in the y-axis direction. In one or more embodiments, the length in the x-axis direction may be substantially the same as the length in the y-axis direction. In one or more embodiments, the length in the x-axis direction may be longer than the length in the y-axis direction.

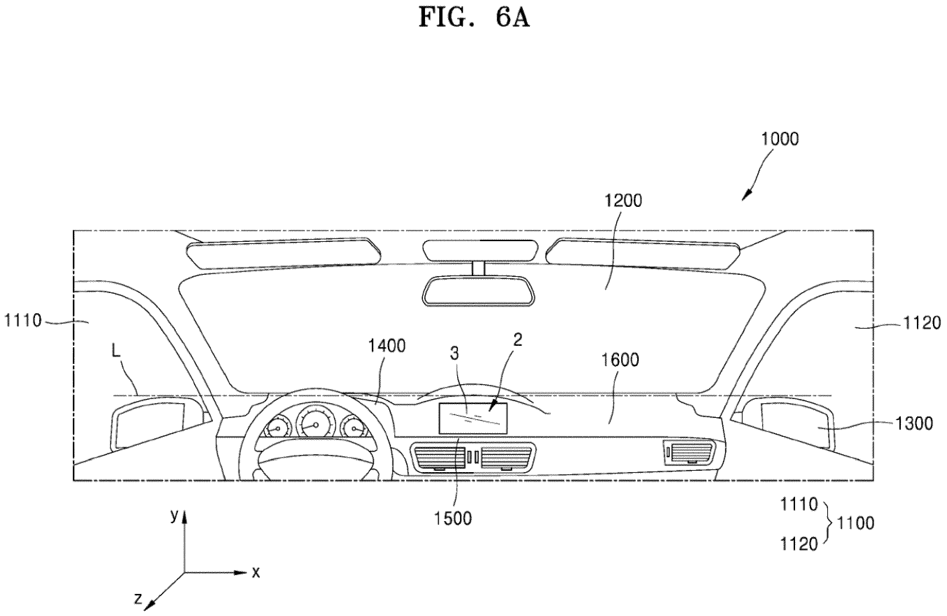

### Descriptions of FIGs. 5 and 6A to 6C

FIG. 5 is a schematic view of an exterior of a vehicle 1000 as an electronic apparatus including a light-emitting device according to one or more embodiments. FIGs. 6A to 6C are each a schematic view of an interior of the vehicle 1000 according to one or more embodiments.

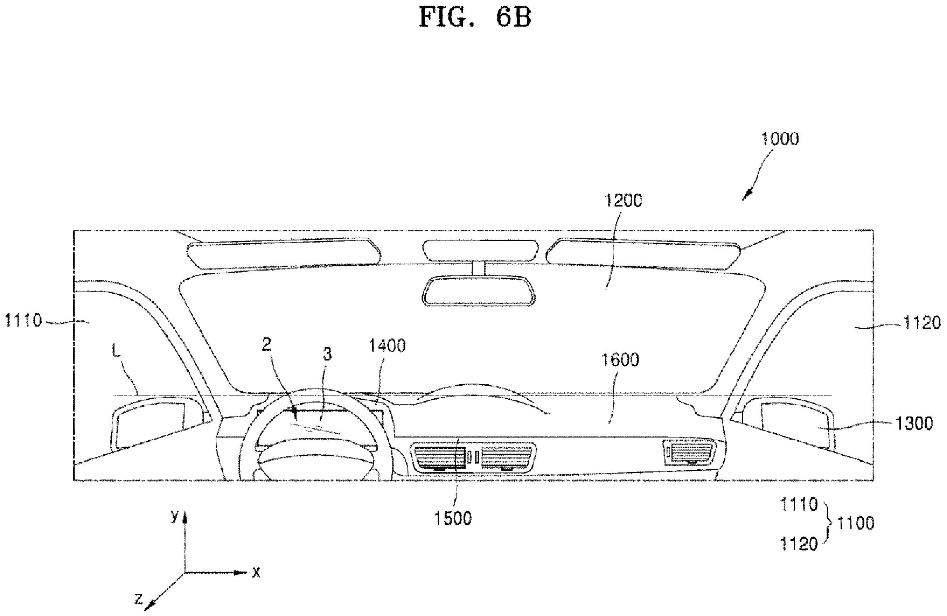

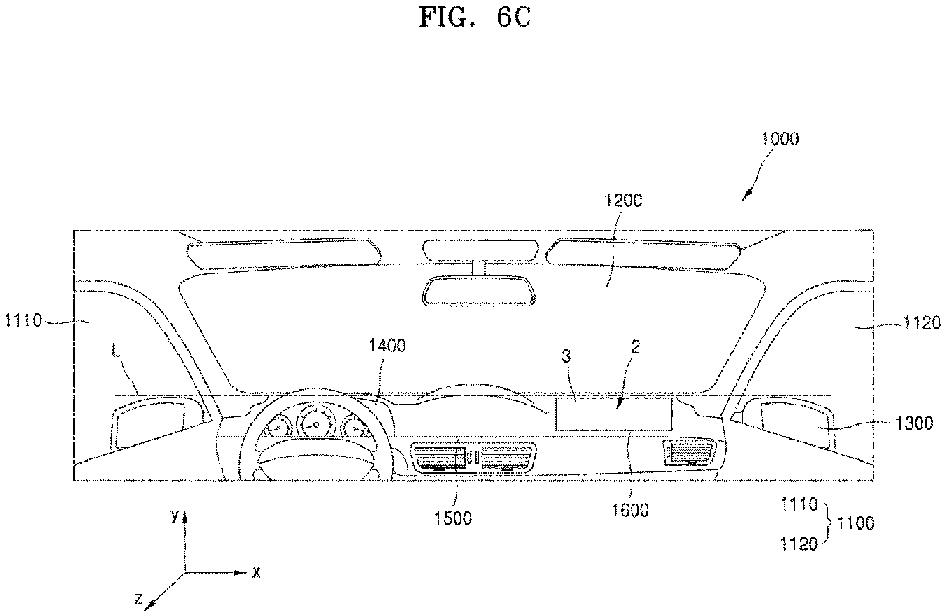

Referring to FIGs. 5, 6A, 6B, and 6C, the vehicle 1000 may refer to one or more suitable apparatuses for moving a subject to be transported, such as a human, an object, or an animal, from a departure point to a destination point. The vehicle 1000 may include a vehicle traveling on a road or a track, a vessel moving over the sea or a river, an airplane flying in the sky utilizing the action of air, and/or the like.

In one or more embodiments, the vehicle 1000 may travel on a road or a track. The vehicle 1000 may move in a set or predetermined direction according to rotation of at least one wheel thereof. For example, the vehicle 1000 may include a three-wheeled or four-wheeled vehicle, a construction machine, a two-wheeled vehicle, a prime mover device, a bicycle, or a train running on a track.

The vehicle 1000 may include a body having an interior and an exterior, and a chassis in which mechanical apparatuses necessary for driving are installed as other parts except for the body. The exterior of the body may include a front panel, a bonnet, a roof panel, a rear panel, a trunk, a pillar provided at a boundary between doors, and/or the like. The chassis of the vehicle 1000 may include a power generating device, a power transmitting device, a driving device, a steering device, a braking device, a suspension device, a transmission device, a fuel device, front and rear wheels, left and right wheels, and/or the like.

The vehicle 1000 may include a side window glass 1100, a front window glass 1200, a side mirror 1300, a cluster 1400, a center fascia 1500, a passenger seat dashboard 1600, and a display device 2.

The side window glass 1100 and the front window glass 1200 may be partitioned by a pillar arranged between the side window glass 1100 and the front window glass 1200.

The side window glass 1100 may be installed on a side of the vehicle 1000. In some embodiments, the side window glass 1100 may be installed on a door of the vehicle 1000. A plurality of side window glasses 1100 may be provided and may face each other. In some embodiments, the side window glass 1100 may include a first side window glass 1110 and a second side window glass 1120. In some embodiments, the first side window glass 1110 may be arranged adjacent to the cluster 1400. The second side window glass 1120 may be arranged adjacent to the passenger seat dashboard 1600.

In one or more embodiments, the side window glasses 1100 may be spaced apart from each other in the x-direction or the -x-direction. For example, the first side window glass 1110 and the second side window glass 1120 may be spaced apart from each other in the x direction or the -x direction (the direction opposite to the x direction). In other words, an imaginary straight line L connecting the side window glasses 1100 may extend in the x-direction or the -x-direction. For example, in some embodiments, an imaginary straight line L connecting the first side window glass 1110 and the second side window glass 1120 to each other may extend in the x direction or the -x direction.

The front window glass 1200 may be installed in the front of the vehicle 1000. The front window glass 1200 may be arranged between the side window glasses 1100 facing each other.

The side mirror 1300 may provide a rear view of the vehicle 1000. The side mirror 1300 may be installed on the exterior of the vehicle body. In some embodiments, a plurality of side mirrors 1300 may be provided. Any one of the plurality of side mirrors 1300 may be arranged outside the first side window glass 1110. The other one of the plurality of side mirrors 1300 may be arranged outside the second side window glass 1120.

The cluster 1400 may be arranged in front of the steering wheel. The cluster 1400 may include a tachometer, a speedometer, a coolant thermometer, a fuel gauge turn indicator, a high beam indicator, a warning light, a seat belt warning light, an odometer, an automatic shift selector indicator, a door open warning light, an engine oil warning light, and /or a low fuel warning light.

The center fascia 1500 may include a control panel on which a plurality of buttons for adjusting an audio device, an air conditioning device, and/or a heater of a seat are located. The center fascia 1500 may be arranged on one side of the cluster 1400.

The passenger seat dashboard 1600 may be spaced apart from the cluster 1400 with the center fascia 1500 arranged therebetween. In some embodiments, the cluster 1400 may be arranged to correspond to a driver seat, and the passenger seat dashboard 1600 may be located to correspond to a passenger seat. In some embodiments, the cluster 1400 may be adjacent to the first side window glass 1110, and the passenger seat dashboard 1600 may be adjacent to the second side window glass 1120.

In one or more embodiments, the display device 2 may include a display panel 3, and the display panel 3 may display an image. The display device 2 may be arranged inside the vehicle 1000. In some embodiments, the display device 2 may be arranged between the side window glasses 1100 facing each other. The display device 2 may be arranged on at least one of the cluster 1400, the center fascia 1500, or the passenger seat dashboard 1600.

The display device 2 may include an organic light-emitting display device, an inorganic EL display device, a quantum dot display device, and/or the like. Hereinafter, as the display device 2 according to one or more embodiments of the invention, an organic light-emitting display device including the light-emitting device according to one or more embodiments of the invention will be described as an example, but one or more suitable types (kinds) of display devices as described above may be utilized in embodiments of the invention.

Referring to FIG. 6A, in one or more embodiments, the display device 2 may be arranged on the center fascia 1500. In some embodiments, the display device 2 may display navigation information. In some embodiments, the display device 2 may display audio, video, or information regarding vehicle settings.

Referring to FIG. 6B, in one or more embodiments, the display device 2 may be arranged on the cluster 1400. When the display device 2 is arranged on the cluster 1400, the cluster 1400 may display driving information and/or the like through the display device 2. For example, the cluster 1400 may be implemented digitally. The digital cluster 1400 may display vehicle information and driving information as images. For example, in some embodiments, a needle and a gauge of a tachometer and one or more suitable warning light icons may be displayed by a digital signal.

Referring to FIG. 6C, in one or more embodiments, the display device 2 may be arranged on the passenger seat dashboard 1600. The display device 2 may be embedded in the passenger seat dashboard 1600 or arranged on the passenger seat dashboard 1600. In some embodiments, the display device 2 arranged on the passenger seat dashboard 1600 seat may display an image related to information displayed on the cluster 1400 and/or information displayed on the center fascia 1500. In one or more embodiments, the display device 2 arranged on the passenger seat dashboard 1600 may display information different from information displayed on the cluster 1400 and/or information displayed on the center fascia 1500.

### Manufacturing method

The layers constituting the hole transport region, the emission layer, and the layers constituting the electron transport region may be formed in a certain region by utilizing one or more suitable methods such as vacuum deposition, spin coating, casting, Langmuir-Blodgett (LB) deposition, ink-jet printing, laser-printing, laser-induced thermal imaging, and/or the like.

When the layers constituting the hole transport region, the emission layer, and the layers constituting the electron transport region are each formed by vacuum deposition, the deposition may be performed at a deposition temperature in a range of about 100 °C to about 500 °C, at a vacuum degree in a range of about 133 x 10⁻⁸ Pa (10⁻⁸ torr) to about 133 x 10⁻³ Pa (10⁻³ torr), and at a deposition speed in a range of about 0.001 nm/sec (0.01 Å/sec) to about 10 nm/sec (100 Å/sec), depending on a material to be included in a layer to be formed and the structure of a layer to be formed.

### Definition of Terms

The term "C₃-C₆₀ carbocyclic group" as utilized herein refers to a cyclic group including (e.g., consisting of) carbon only as a ring-forming atom and having three to sixty carbon atoms, and the term "C₁-C₆₀ heterocyclic group" as utilized herein refers to a cyclic group that has one to sixty carbon atoms and further has, in addition to carbon, a heteroatom as a ring-forming atom. The C₃-C₆₀ carbocyclic group and the C₁-C₆₀ heterocyclic group may each be a monocyclic group including (e.g., consisting of) one ring or a polycyclic group in which two or more rings are condensed with each other. For example, the number of ring-forming atoms of the C₁-C₆₀ heterocyclic group may be from 3 to 61.

The "cyclic group" as utilized herein may include both (e.g., simultaneously) the C₃-C₆₀ carbocyclic group and the C₁-C₆₀ heterocyclic group.

The term "π electron-rich C₃-C₆₀ cyclic group" as utilized herein refers to a cyclic group that has three to sixty carbon atoms and does not include *-N=*' as a ring-forming moiety, and the term "π electron-deficient nitrogen-containing C₁-C₆₀ cyclic group" as utilized herein refers to a heterocyclic group that has one to sixty carbon atoms and includes *-N=*' as a ring-forming moiety.

For example,
the C₃-C₆₀ carbocyclic group may be i) Group T1 or ii) a condensed cyclic group in which two or more of Group T1(s) are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) Group T2, ii) a condensed cyclic group in which at least two of Group T2 are condensed with each other, or iii) a condensed cyclic group in which at least one Group T2 and at least one Group T1 are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),
the π electron-rich C₃-C₆₀ cyclic group may be i) Group T1, ii) a condensed cyclic group in which two or more of Group T1(s) are condensed with each other, iii) Group T3, iv) a condensed cyclic group in which two or more of Group T3(s) are condensed with each other, or v) a condensed cyclic group in which at least one Group T3 and at least one Group T1 are condensed with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, and/or the like),
the π electron-deficient nitrogen-containing C₁-C₆₀ cyclic group may be i) Group T4, ii) a condensed cyclic group in which at least two of Groups T4 are condensed with each other, iii) a condensed cyclic group in which at least one Group T4 and at least one Group T1 are condensed with each other, iv) a condensed cyclic group in which at least one Group T4 and at least one Group T3 are condensed with each other, or v) a condensed cyclic group in which at least one Group T4, at least one Group T1, and at least one Group T3 are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),
Group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,
Group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
Group T3 may be a furan group, a thiophene group, a 1H-pyrrole group, a silole group, or a borole group, and
Group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The term "cyclic group," "C₃-C₆₀ carbocyclic group," "C₁-C₆₀ heterocyclic group," "π electron-rich C₃-C₆₀ cyclic group," or "π electron-deficient nitrogen-containing C₁-C₆₀ cyclic group" as utilized herein refer to a group condensed to any cyclic group, a monovalent group, or a polyvalent group (for example, a divalent group, a trivalent group, a tetravalent group, etc.) according to the structure of a formula for which the corresponding term is utilized. For example, the "benzene group" may be a benzo group, a phenyl group, a phenylene group, and/or the like, which may be easily understood by one of ordinary skill in the art according to the structure of a formula including the "benzene group."

Depending on context, in the present disclosure, a divalent group may refer or be a polyvalent group (e.g., trivalent, tetravalent, etc., and not just divalent) per, e.g., the structure of a formula in connection with which of the terms are utilized.

Non-limiting examples of the monovalent C₃-C₆₀ carbocyclic group and the monovalent C₁-C₆₀ heterocyclic group may be a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Non-limiting examples of the divalent C₃-C₆₀ carbocyclic group and the divalent C₁-C₆₀ heterocyclic group may be a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a divalent non-aromatic condensed heteropolycyclic group.

The term "C₁-C₆₀ alkyl group" as utilized herein refers to a linear or branched aliphatic hydrocarbon monovalent group that has one to sixty carbon atoms, and non-limiting examples thereof may be a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as utilized herein refers to a divalent group having substantially the same structure as the C₁-C₆₀ alkyl group.

The term "C₂-C₆₀ alkenyl group" as utilized herein refers to a monovalent hydrocarbon group having at least one carbon-carbon double bond in the middle or at the terminus of a C₂-C₆₀ alkyl group, and non-limiting examples thereof may be an ethenyl group, a propenyl group, a butenyl group, and/or the like. The term "C₂-C₆₀ alkenylene group" as utilized herein refers to a divalent group having substantially the same structure as the C₂-C₆₀ alkenyl group.

The term "C₂-C₆₀ alkynyl group" as utilized herein refers to a monovalent hydrocarbon group having at least one carbon-carbon triple bond in the middle or at the terminus of a C₂-C₆₀ alkyl group, and non-limiting examples thereof may be an ethynyl group, a propynyl group, and/or the like. The term "C₂-C₆₀ alkynylene group" as utilized herein refers to a divalent group having substantially the same structure as the C₂-C₆₀ alkynyl group.

The term "C₁-C₆₀ alkoxy group" as utilized herein refers to a monovalent group represented by -OA₁₀₁ (wherein A₁₀₁ is a C₁-C₆₀ alkyl group), and non-limiting examples thereof may be a methoxy group, an ethoxy group, an isopropyloxy group, and/or the like.

The term "C₃-C₁₀ cycloalkyl group" as utilized herein refers to a monovalent saturated hydrocarbon cyclic group having 3 to 10 carbon atoms, and non-limiting examples thereof may be a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, and/or the like. The term "C₃-C₁₀ cycloalkylene group" as utilized herein refers to a divalent group having substantially the same structure as the C₃-C₁₀ cycloalkyl group.

The term "C₁-C₁₀ heterocycloalkyl group" as utilized herein refers to a monovalent cyclic group of 1 to 10 carbon atoms, further including, in addition to carbon atoms, at least one heteroatom, as ring-forming atoms, and non-limiting examples thereof may be a 1,2,3,4-oxatriazolidinyl group, a tetrahydrofuranyl group, a tetrahydrothiophenyl group, and/or the like. The term "C₁-C₁₀ heterocycloalkylene group" as utilized herein refers to a divalent group having substantially the same structure as the C₁-C₁₀ heterocycloalkyl group.

The term "C₃-C₁₀ cycloalkenyl group" as utilized herein refers to a monovalent cyclic group that has three to ten carbon atoms and at least one carbon-carbon double bond in the ring thereof and no aromaticity, and non-limiting examples thereof may be a cyclopentenyl group, a cyclohexenyl group, a cycloheptenyl group, and/or the like. The term "C₃-C₁₀ cycloalkenylene group" as utilized herein refers to a divalent group having substantially the same structure as the C₃-C₁₀ cycloalkenyl group.

The term "C₁-C₁₀ heterocycloalkenyl group" as utilized herein refers to a monovalent cyclic group of 1 to 10 carbon atoms, further including, in addition to carbon atoms, at least one heteroatom, as ring-forming atoms, and having at least one double bond in the cyclic structure thereof. Non-limiting examples of the C₁-C₁₀ heterocycloalkenyl group may be a 4,5-dihydro-1,2,3,4-oxatriazolyl group, a 2,3-dihydrofuranyl group, a 2,3-dihydrothiophenyl group, and/or the like. The term "C₁-C₁₀ heterocycloalkenylene group" as utilized herein refers to a divalent group having substantially the same structure as the C₁-C₁₀ heterocycloalkenyl group.

The term "C₆-C₆₀ aryl group" as utilized herein refers to a monovalent group having a carbocyclic aromatic system of 6 to 60 carbon atoms, and the term "C₆-C₆₀ arylene group" as utilized herein refers to a divalent group having a carbocyclic aromatic system of 6 to 60 carbon atoms. Non-limiting examples of the C₆-C₆₀ aryl group may be a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, an ovalenyl group, and/or the like. When the C₆-C₆₀ aryl group and the C₆-C₆₀ arylene group each include two or more rings, the rings may be condensed with each other.

The term "C₁-C₆₀ heteroaryl group" as utilized herein refers to a monovalent group having a heterocyclic aromatic system of 1 to 60 carbon atoms, further including, in addition to carbon atoms, at least one heteroatom, as ring-forming atoms. The term "C₁-C₆₀ heteroarylene group" as utilized herein refers to a divalent group having a heterocyclic aromatic system of 1 to 60 carbon atoms, further including, in addition to carbon atoms, at least one heteroatom, as ring-forming atoms. Non-limiting examples of the C₁-C₆₀ heteroaryl group may be a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the rings may be condensed with each other.

The term "monovalent non-aromatic condensed polycyclic group" as utilized herein refers to a monovalent group (for example, having 8 to 60 carbon atoms) having two or more rings condensed to each other, only carbon atoms as ring-forming atoms, and no aromaticity in its entire molecular structure as a whole. Non-limiting examples of the monovalent non-aromatic condensed polycyclic group may be an indenyl group, a fluorenyl group, a spiro-bifluorenyl group, a benzofluorenyl group, an indenophenanthrenyl group, an indeno anthracenyl group, and/or the like. The term "divalent non-aromatic condensed polycyclic group" as utilized herein refers to a divalent group having substantially the same structure as the monovalent non-aromatic condensed polycyclic group described above.

The term "monovalent non-aromatic condensed heteropolycyclic group" as utilized herein refers to a monovalent group (for example, having 1 to 60 carbon atoms) having two or more rings condensed to each other, further including, in addition to carbon atoms, at least one heteroatom, as ring-forming atoms, and having non-aromaticity in its entire molecular structure as a whole. Non-limiting examples of the monovalent non-aromatic condensed heteropolycyclic group may include a pyrrolyl group, a thiophenyl group, a furanyl group, an indolyl group, a benzoindolyl group, a naphtho indolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as utilized herein refers to a divalent group having substantially the same structure as the monovalent non-aromatic condensed heteropolycyclic group described above.

The term "C₆-C₆₀ aryloxy group" as utilized herein indicates -OA₁₀₂ (wherein A₁₀₂ is a C₆-C₆₀ aryl group), and the term "C₆-C₆₀ arylthio group" as utilized herein indicates -SA₁₀₃ (wherein A₁₀₃ is a C₆-C₆₀ aryl group).

The term "C₇-C₆₀ arylalkyl group" as utilized herein refers to -A₁₀₄A₁₀₅ (wherein A₁₀₄ is a C₁-C₅₄ alkylene group, and A₁₀₅ is a C₆-C₅₉ aryl group), and the term "C₂-C₆₀ heteroarylalkyl group" as utilized herein refers to -A₁₀₆A₁₀₇ (wherein A₁₀₆ is a C₁-C₅₉ alkylene group, and A₁₀₇ is a C₁-C₅₉ heteroaryl group).

The term "R₁₀ₐ" as utilized herein may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or one or more combinations thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or one or more combinations thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).

Q₁ to Q₃, Q₁₁ to Q₁₃, Q₂₁ to Q₂₃, and Q₃₁ to Q₃₃ utilized herein may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or one or more combinations thereof.

The term "heteroatom" as utilized herein refers to any atom other than a carbon atom. Non-limiting examples of the heteroatom may be O, S, N, P, Si, B, Ge, Se, and one or more combinations thereof.

The term "third-row transition metal" as utilized herein may include hafnium (Hf), tantalum (Ta), tungsten (W), rhenium (Re), osmium (Os), iridium (Ir), platinum (Pt), gold (Au), and/or the like.

"Ph" as utilized herein refers to a phenyl group, "Me" as utilized herein refers to a methyl group, "Et" as utilized herein refers to an ethyl group, "tert-Bu" or "Bu^{t}" as utilized herein refers to a tert-butyl group, and "OMe" as utilized herein refers to a methoxy group.

The term "biphenyl group" as utilized herein refers to "a phenyl group substituted with a phenyl group." In some embodiments, the "biphenyl group" may be a substituted phenyl group having a C₆-C₆₀ aryl group as a substituent.

The term "terphenyl group" as utilized herein refers to "a phenyl group substituted with a biphenyl group." In some embodiments, the "terphenyl group" may be a substituted phenyl group having, as a substituent, a C₆-C₆₀ aryl group substituted with a C₆-C₆₀ aryl group.

* and *' as utilized herein, unless defined otherwise, each refer to a binding site to a neighboring atom in a corresponding formula or moiety.

Hereinafter, a light-emitting device according to one or more embodiments will be described in more detail with reference to Examples.

### Examples

### Evaluation Example 1

The HOMO energy level, LUMO energy level, hole mobility, electron mobility, and/or triplet (T₁) energy of each of the compounds listed in Tables 2 to 8 were evaluated according to the method in Table 1, and the results are shown in Tables 2 to 8.

**Table 1**

| | |
|---|---|
| HOMO energy level evaluation method | By utilizing cyclic voltammetry (CV) (electrolyte: 0.1 M Bu₄NPF₆ / solvent: dimethylformamide (DMF) / electrode: 3-electrode system (working electrode: glassy carbon (GC), reference electrode: Ag/AgCl, and auxiliary electrode: Pt)), the potential (V)-current (A) graph of each compound was obtained, and then, from the oxidation onset of the graph, the HOMO energy level of each compound was calculated. |
| LUMO energy level evaluation method | By utilizing cyclic voltammetry (CV) (electrolyte: 0.1 M Bu₄NPF₆ / solvent: dimethylformamide (DMF) / electrode: 3-electrode system (working electrode: glassy carbon (GC), reference electrode: Ag/AgCl, and auxiliary electrode: Pt)), the potential (V)-current (A) graph of each compound was obtained, and then, from the reduction onset of the graph, the LUMO energy level of each compound was calculated. |
| Method of evaluating hole mobility and electron mobility | Evaluated utilizing the space-charge-limited current (SCLC) method described in "Hole mobility of N,N'-bis(naphthalen-1-yl)-N,N'-bis(phenyl)benzidine investigated by utilizing space-charge-limited currents," Appl. Phys. Lett. 90, 203512 (2007)" |
| Triplet (T₁) energy | A mixture of 2-methyl-THF(2-MeTHF) and each compound (each compound was dissolved to a concentration of 10 mM in 3 mL of 2-MeTHF) was put into a quartz cell, which was then placed in a cryostat containing liquid nitrogen (77 K)(Oxford, DN). Then, the phosphorescent spectrum thereof was measured utilizing a luminescence measuring instrument (PTI, Quanta Master 400), and then the triplet energy level was measured from the peak wavelength of the phosphorescent spectrum. |

**Table 2**

| Third material | HOMO energy level (eV) | LUMO energy level (eV) | Hole mobility ( cm²/(Vs)) | Electron mobility ( cm²/(Vs)) |
|---|---|---|---|---|
| HT01 | -5.13 | -1.59 | 1.15 x 10⁻³ | 2.74 x 10⁻⁴ |
| HT02 | -5.13 | -1.60 | 5.07 x 10⁻⁴ | 5.97 x 10⁻⁵ |
| HT03 | -5.13 | -1.50 | 9.02 x 10⁻⁴ | 8.14 x 10⁻⁵ |
| HT04 | -5.13 | -1.51 | 3.86 x 10⁻⁴ | 2.04 x 10⁻⁵ |
| HT05 | -5.13 | -1.37 | 5.08 x 10⁻⁴ | 2.89 x 10⁻⁵ |
| HT06 | -5.11 | -1.52 | 6.36 x 10⁻⁴ | 6.89 x 10⁻⁵ |
| HT07 | -5.11 | -1.36 | 8.58 x 10⁻⁴ | 6.33 x 10⁻⁵ |
| HT08 | -5.10 | -1.49 | 1.28 x 10⁻⁴ | 3.10 x 10⁻⁶ |
| HT09 | -5.10 | -1.27 | 4.87 x 10⁻⁴ | 1.49 x 10⁻⁵ |
| HT10 | -5.10 | -1.57 | 5.41 x 10⁻⁴ | 6.23 x 10⁻⁵ |
| R-HT | -4.57 | -1.08 | 1.44 x 10⁻³ | 2.41 x 10⁻⁴ |
| 2-TNATA | -4.65 | -1.30 | 1.22 x 10⁻⁴ | 2.23 x 10⁻⁵ |
| NPB | -5.00 | -1.42 | 5.32 x 10⁻³ | 1.35 x 10⁻³ |

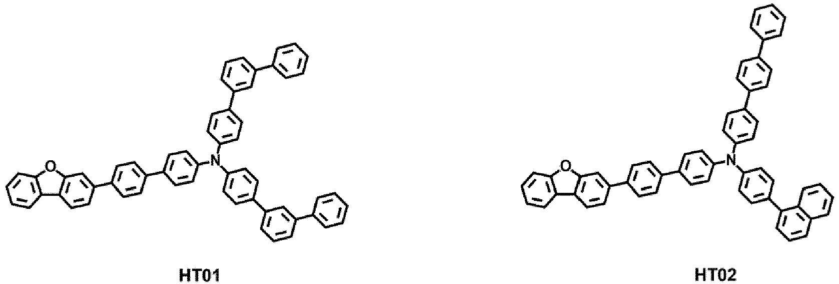

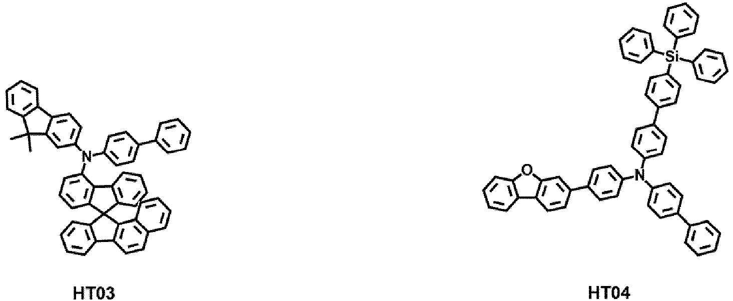

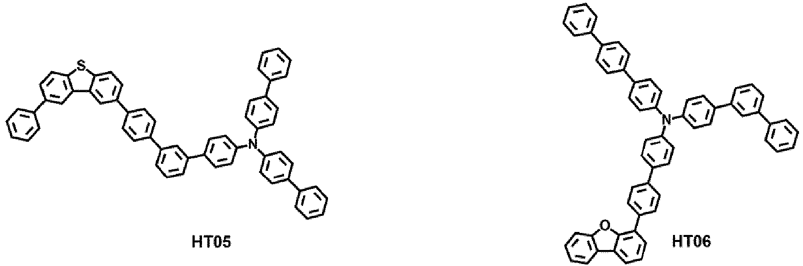

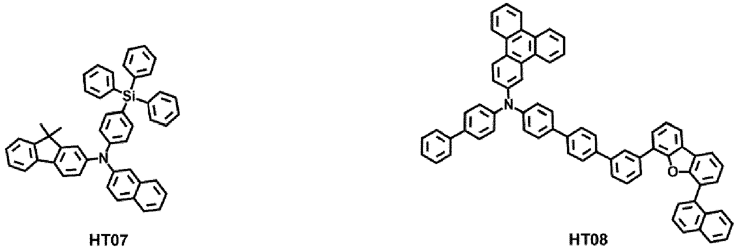

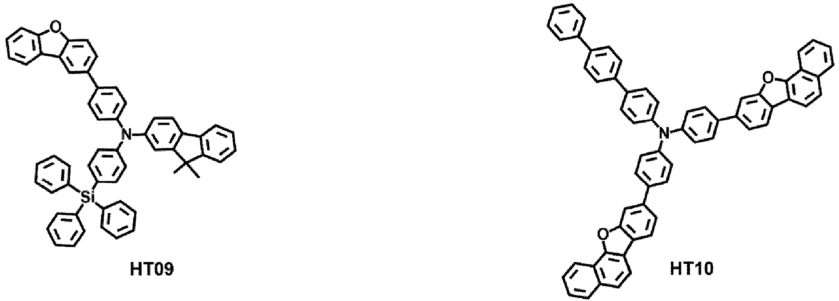

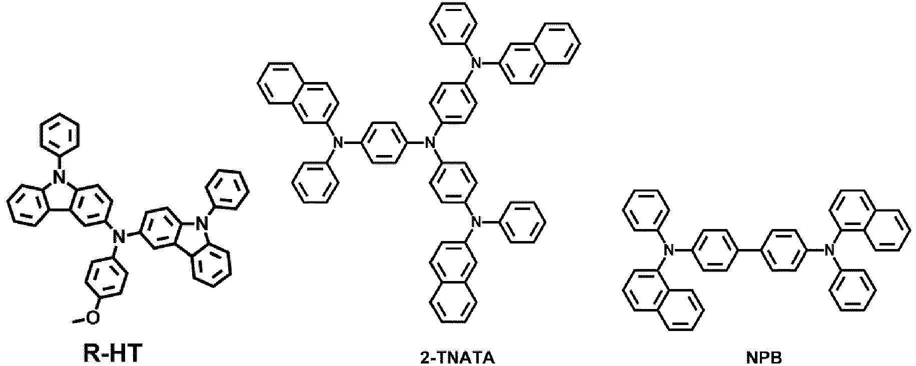

**Table 3**

| Second material | HOMO energy level (eV) | LUMO energy level (eV) | Hole mobility ( cm²/(Vs)) | Electron mobility ( cm²/(Vs)) |
|---|---|---|---|---|
| R'01 | -5.27 | -2.18 | 1.51 x 10⁻³ | 8.89 x 10⁻⁴ |
| R'02 | -5.26 | -1.22 | 4.33 x 10⁻⁴ | 5.29 x 10⁻⁶ |
| R'03 | -5.26 | -1.31 | 1.03 x 10⁻³ | 5.50 x 10⁻⁵ |
| R'04 | -5.26 | -1.44 | 1.30 x 10⁻³ | 8.51 x 10⁻⁵ |
| R'05 | -5.26 | -1.71 | 1.24 x 10⁻³ | 1.70 x 10⁻⁴ |
| R'06 | -5.21 | -1.50 | 3.76 x 10⁻⁴ | 1.66 x 10⁻⁵ |
| R'07 | -5.21 | -2.10 | 3.08 x 10⁻⁴ | 4.32 x 10⁻⁵ |
| R'08 | -5.20 | -1.84 | 3.01 x 10⁻⁴ | 2.34 x 10⁻⁵ |
| R'09 | -5.20 | -1.47 | 1.79 x 10⁻³ | 2.30 x 10⁻⁴ |
| R'10 | -5.20 | -1.47 | 1.19 x 10⁻³ | 9.79 x 10⁻⁵ |
| R-R' | -4.66 | -1.09 | 1.97 x 10⁻³ | 3.69 x 10⁻⁴ |
| 1-9 | -5.13 | -1.36 | - | - |

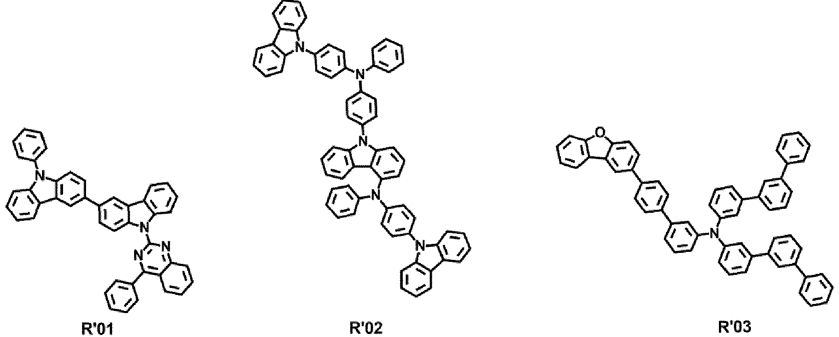

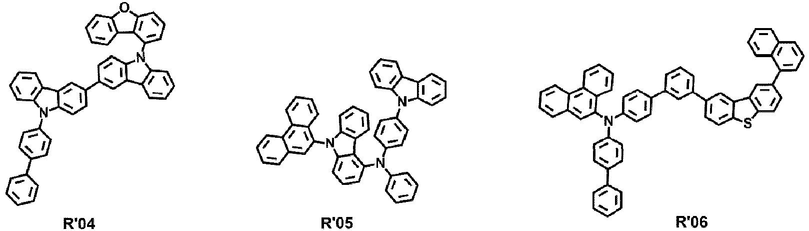

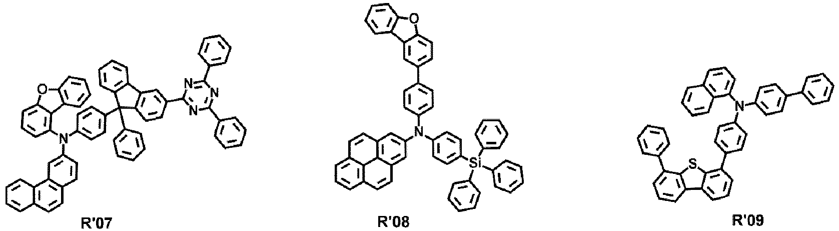

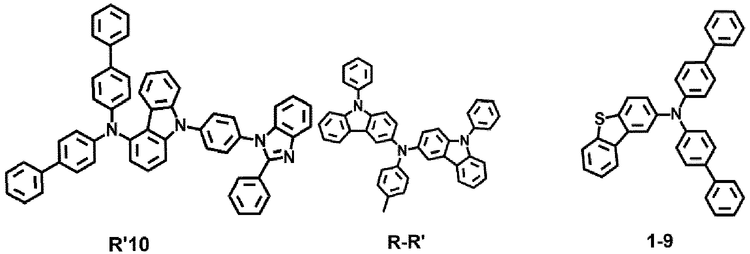

**Table 4**

| First material | HOMO energy level (eV) | LUMO energy level (eV) | Hole mobility ( cm²/(Vs)) | Electron mobility ( cm²/(Vs)) |
|---|---|---|---|---|
| RI01 | -5.40 | -1.47 | 1.01 x 10⁻³ | 6.35 x 10⁻⁵ |
| RI02 | -5.38 | -1.24 | 1.58 x 10⁻³ | 7.47 x 10⁻⁵ |
| RI03 | -5.38 | -1.90 | 8.71 x 10⁻⁴ | 1.37 x 10⁻⁴ |
| RI04 | -5.37 | -1.44 | 9.65 x 10⁻⁴ | 4.53 x 10⁻⁵ |
| RI05 | -5.37 | -2.23 | 6.75 x 10⁻⁴ | 1.55 x 10⁻⁴ |
| RI06 | -5.35 | -1.51 | 1.55 x 10⁻³ | 1.12 x 10⁻⁴ |
| RI07 | -5.35 | -1.38 | 1.04 x 10⁻³ | 5.02 x 10⁻⁵ |
| RI08 | -5.34 | -1.78 | 1.77 x 10⁻³ | 3.97 x 10⁻⁴ |
| RI09 | -5.34 | -1.40 | 2.16 x 10⁻⁴ | 2.50 x 10⁻⁶ |
| RI10 | -5.33 | -1.09 | 1.68 x 10⁻⁴ | 5.56 x 10⁻⁷ |
| R-RI | -4.63 | -1.84 | 2.01 x 10⁻³ | 2.78 x 10⁻³ |
| 1-5 | -5.14 | -1.26 | 3.56 x 10⁻³ | 5.15 x 10⁻³ |

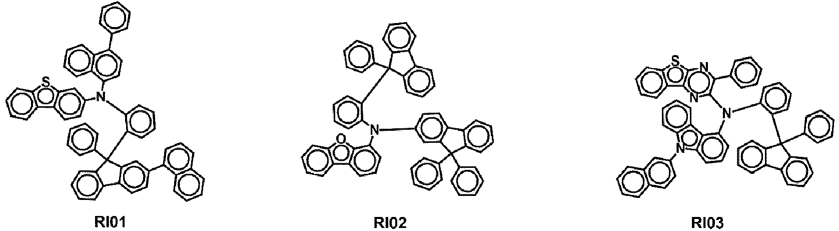

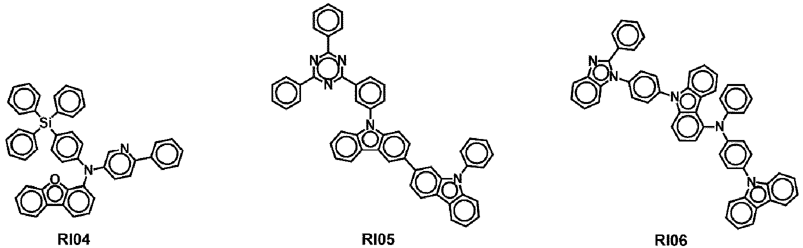

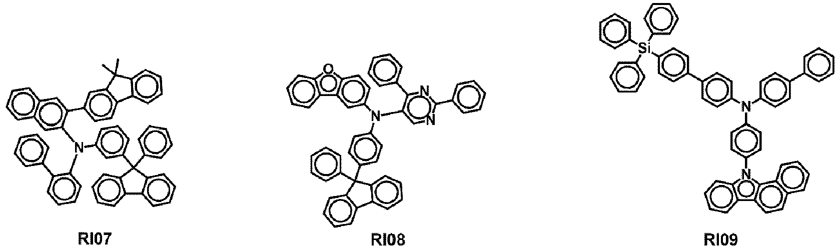

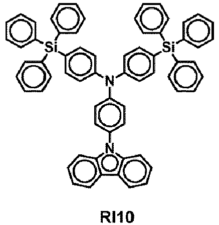

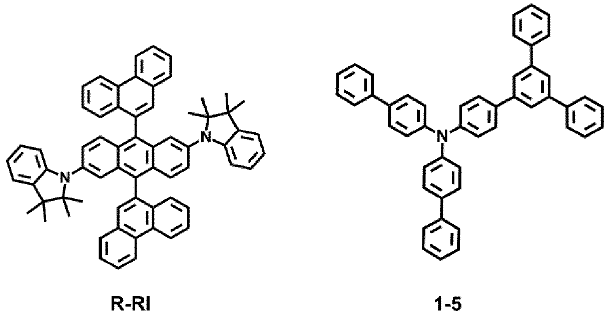

**Table 5**

| First host | HOMO energy level (eV) | LUMO energy level (eV) | Hole mobility ( cm²/(Vs)) | Electron mobility ( cm²/(Vs)) |
|---|---|---|---|---|
| Host1 | -4.80 | -2.06 | 5.18 x 10⁻⁵ | 3.33 x 10⁻⁶ |
| Host2 | -4.83 | -2.02 | 7.76 x 10⁻⁵ | 6.53 x 10⁻⁶ |
| Host3 | -4.87 | -1.93 | 2.36 x 10⁻⁴ | 3.87 x 10⁻⁵ |
| Host4 | -4.84 | -1.92 | 5.46 x 10⁻⁴ | 1.55 x 10⁻⁴ |
| R-Host | -5.06 | -1.32 | 1.28 x 10⁻⁵ | 1.24 x 10⁻⁸ |
| CBP | -5.59 | -1.53 | 1.03 x 10⁻³ | 2.34 x 10⁻⁵ |

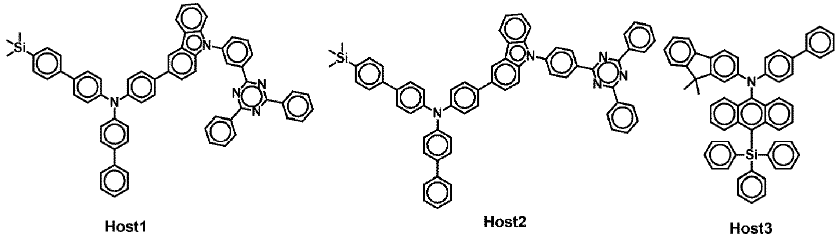

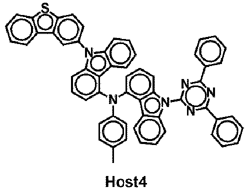

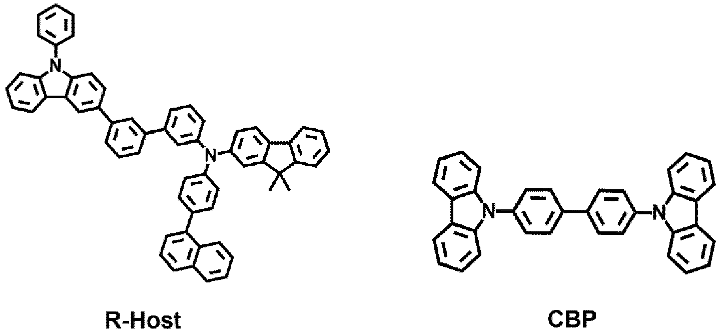

**Table 6**

| First emitter | HOMO energy level (eV) | LUMO energy level (eV) | T₁ energy (eV) |
|---|---|---|---|
| RD01 | -5.06 | -2.18 | 2.00 |
| RD02 | -4.92 | -2.07 | 1.97 |
| RD03 | -4.95 | -2.01 | 2.1 |
| RD04 | -4.95 | -2.12 | 2.05 |
| R-RD | -5.21 | -1.96 | 2.11 |
| Ir(piq)₂(acac) | -5.04 | -2.05 | 1.99 |

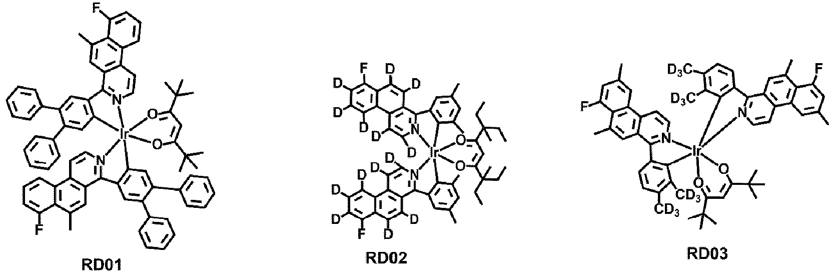

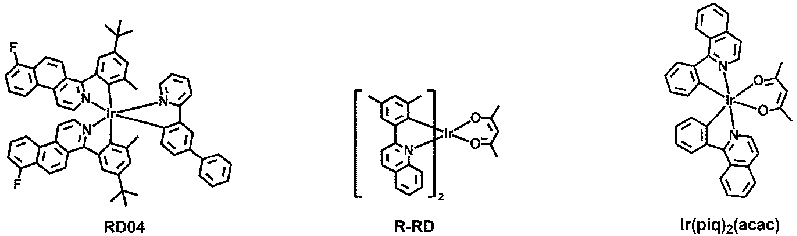

**Table 7**

| Material for buffer layer | HOMO energy level (eV) | LUMO energy level (eV) | Hole mobility ( cm²/(Vs)) | Electron mobility ( cm²/(Vs)) |
|---|---|---|---|---|
| BF01 | -5.81 | -1.95 | 1.88 x 10⁻³ | 2.33 x 10⁻⁴ |
| BF02 | -5.74 | -1.95 | 2.76 x 10⁻³ | 7.37 x 10⁻⁴ |
| BF03 | -5.60 | -1.95 | 4.91 x 10⁻³ | 2.21 x 10⁻³ |
| BF04 | -5.92 | -1.95 | 2.30 x 10⁻³ | 3.02 x 10⁻⁴ |
| BF05 | -5.83 | -1.95 | 3.57 x 10⁻³ | 8.95 x 10⁻⁴ |
| BF06 | -6.07 | -2.01 | 3.95 x 10⁻³ | 4.77 x 10⁻⁴ |
| BF07 | -5.82 | -2.01 | 6.36 x 10⁻³ | 4.18 x 10⁻³ |
| BF08 | -5.82 | -2.01 | 4.18 x 10⁻³ | 1.17 x 10⁻³ |
| BF09 | -5.91 | -2.02 | 3.90 x 10⁻³ | 1.30 x 10⁻³ |
| BF10 | -5.91 | -2.02 | 5.33 x 10⁻³ | 1.88 x 10⁻³ |
| R-BF | -5.18 | -1.50 | 5.92 x 10⁻⁴ | 3.54 x 10⁻⁵ |
| BAlq | -5.17 | -2.25 | 4.42 x 10⁻⁷ | 2.57 x 10⁻⁵ |

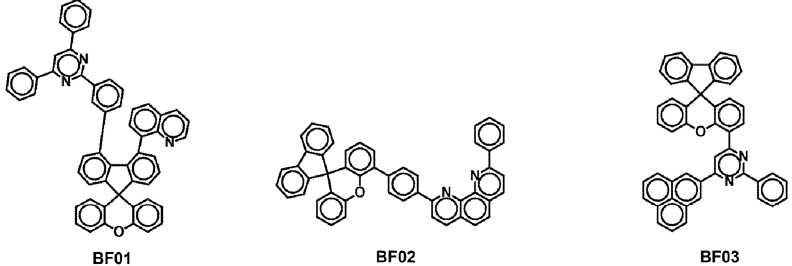

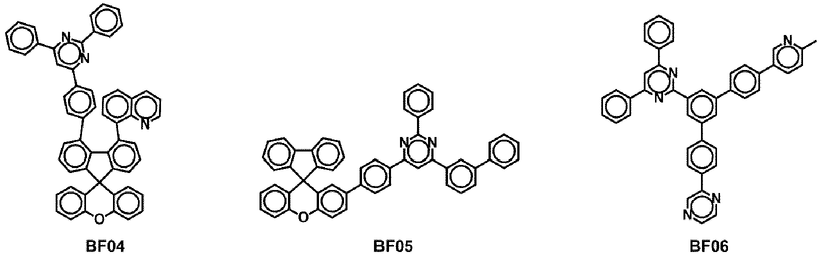

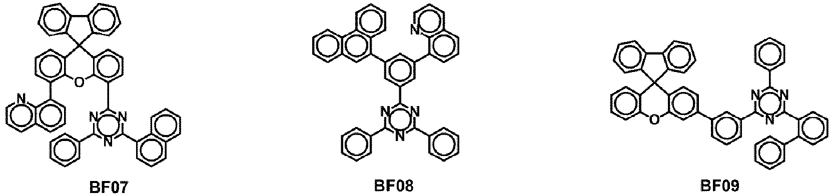

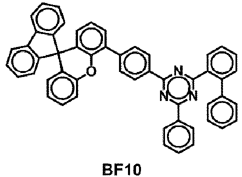

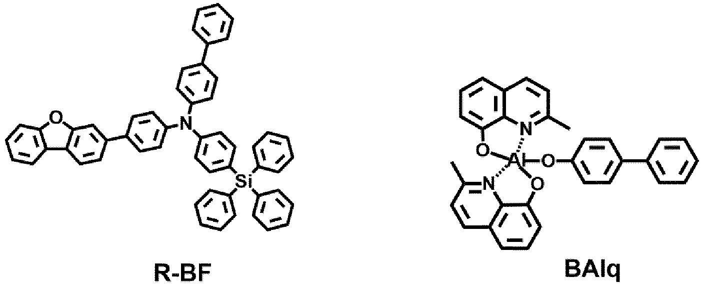

**Table 8**

| electron transport layer material | HOMO energy level (eV) | LUMO energy level (eV) | Hole mobility ( cm²/(Vs)) | Electron mobility ( cm²/(Vs)) |
|---|---|---|---|---|
| ET01 | -5.44 | -2.12 | 1.91 x 10⁻³ | 7.80 x 10⁻⁴ |
| ET02 | -6.03 | -2.12 | 2.03 x 10⁻³ | 2.39 x 10⁻⁴ |
| ET03 | -5.94 | -2.12 | 1.76 x 10⁻³ | 2.01 x 10⁻⁴ |
| ET04 | -6.10 | -2.12 | 2.83 x 10⁻³ | 2.93 x 10⁻⁴ |
| ET05 | -5.99 | -2.12 | 1.56 x 10⁻³ | 1.45 x 10⁻⁴ |
| ET06 | -5.97 | -2.16 | 2.72 x 10⁻³ | 5.17 x 10⁻⁴ |
| ET07 | -6.00 | -2.16 | 2.16 x 10⁻³ | 2.85 x 10⁻⁴ |
| ET08 | -5.48 | -2.17 | 2.38 x 10⁻³ | 1.20 x 10⁻³ |
| ET09 | -6.02 | -2.17 | 1.21 x 10⁻³ | 1.04 x 10⁻⁴ |
| ET10 | -5.59 | -2.17 | 1.53 x 10⁻³ | 4.33 x 10⁻⁴ |
| R-ET | -5.88 | -1.96 | 5.40 x 10⁻⁴ | 1.71 x 10⁻⁵ |
| Bebq₂ | -5.28 | -1.98 | 3.62 x 10⁻³ | 1.77 x 10⁻⁵ |

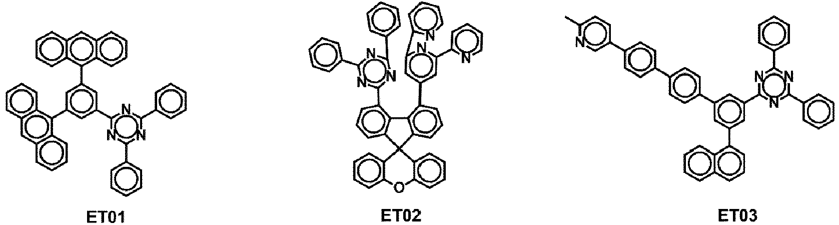

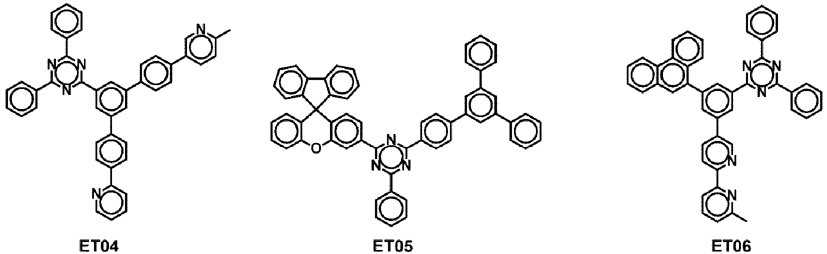

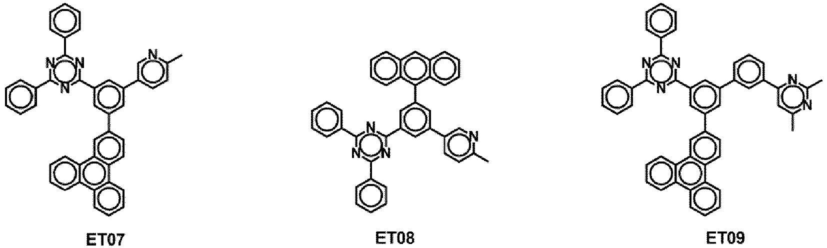

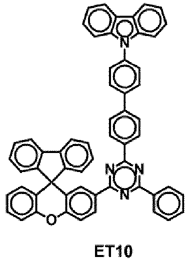

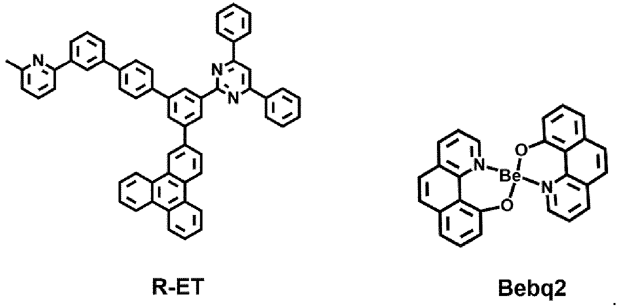

### Evaluation Example 2

Polymethyl methacrylate (PMMA) and Compound RD01 (4 wt% in relative to PMMA) were mixed in CH₂Cl₂ solution, and the resultant mixture was applied to a quartz substrate by utilizing s spin coater followed by heat treatment in an oven at a temperature of 80 °C and cooling to room temperature, so as to prepare Film RD01 having a thickness of 40 nm. Then, Films RD02 to RD04, R-RD, and Ir(piq)₂(acac) were prepared in substantially the same manner as utilized to prepare Film RD01, except that RD02 to RD04, R-RD and Ir(piq)₂(acac) were each respectively utilized instead of RD01.

For each of Films RD01 to RD04, R-RD, and Ir(piq)₂(acac), the emission spectrum was measured by a Quantaurus-QY Absolute PL quantum yield spectrometer manufactured by Hamamatsu Company (equipped with a xenon light source, a monochromator, a photonic multichannel analyzer, and an integrating sphere, and utilizing a PLQY measurement software (Hamamatsu Photonics, Ltd., Shizuoka, Japan)). For the measurement, the excitation wavelength was scanned at the intervals of 10 nm from about 320 nm to about 380 nm, and a spectrum measured at the excitation wavelength of 340 nm was picked therefrom. Then, a maximum emission wavelength (i.e., emission wavelength) of the compounds included in each film was obtained from the picked spectrum, and the results are shown in Table 9.

**Table 9**

| Film No. | Compound included in film (4 wt% in PMMA) | Maximum emission wavelength (nm) |
|---|---|---|
| RD01 | RD01 | 664 |
| RD02 | RD02 | 673 |
| RD03 | RD03 | 615 |
| RD04 | RD04 | 623 |
| R-RD | R-RD | 603 |
| Ir(piq)₂(acac) | Ir(piq)₂(acac) | 614 |

### Example 1

As an anode, a glass substrate (product of Corning Inc.) with a 15 D/ cm² (120 nm) (1,200 Å) ITO formed thereon was cut to a size of 50 mm x 50 mm x 0.7 mm, sonicated with isopropyl alcohol and pure water each for 5 minutes, cleaned by irradiation of ultraviolet rays and exposure of ozone thereto for 30 minutes, and then mounted on a vacuum deposition apparatus.

A third material (HT01) was vacuum deposited on the anode to form a third layer having a thickness of 140 nm (1400 Å), and a second material (R'01) was vacuum deposited on the third layer to form a second layer having a thickness of 75 nm (750 Å), and then, the first material (RI01) was vacuum deposited on the second layer to form a first layer having a thickness of 5 nm (50 Å).

The first host (Host1) and the first emitter (RD01) were vacuum deposited on the first layer in a weight ratio of 98:2 to form an emission layer having a thickness of 41 nm (410 Å).

A buffer layer material (BF03) was vacuum deposited on the emission layer to form a buffer layer having a thickness of 5 nm (50 Å), and a material for an electron transport layer (ET02) was vacuum deposited on the buffer layer to form an electron transport layer having a thickness of 31 nm (310 Å). Next, Yb was vacuum deposited on the electron transport layer to form an electron injection layer having a thickness of 1,5 nm (15 Å), and then Ag and Mg were vacuum deposited to form a cathode with a thickness of 80 nm (800 Å), and then the following compound CP7 was vacuum deposited on the cathode to form a capping layer having a thickness of 60 nm (600 Å).

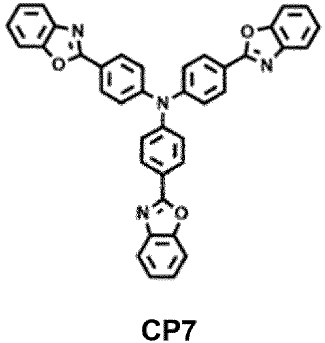

### Examples 2 to 10 and Comparative Example 1

Organic light-emitting devices were each manufactured in substantially the same manner as utilized in Example 1, except that the compounds listed in Table 10 were respectively utilized as the third material, the second material, the first material, the first host, the first emitter, the buffer layer material, and the electron transport layer material.

### Comparative Example 2

An organic light-emitting device was manufactured utilizing the same method as Example 1, except that as a third layer, a 70 nm (700 Å) thick 2-TNATA layer and a 70 nm (700 Å) thick NPB layer were sequentially formed utilizing vacuum deposition, and the compounds shown in Table 10 were utilized as the second material, the first material, the first host, the first emitter, and the material for the buffer layer, and the material for the electron transport layer.

### Evaluation Example 3

The driving voltage, maximum power efficiency, and maximum emission wavelength of the electroluminescence (EL) spectrum of each of the organic light-emitting devices manufactured in Examples 1 to 10 and Comparative Examples 1 to 2 were evaluated utilizing Keithley SMU 236 and a luminance meter (Minolta Cs-1000A). The results are summarized in Table 11. Meanwhile, the numbers in parentheses in Table 10 are the HOMO energy level (eV) values of the corresponding compounds.

**Table 10**

| | Third material | | Second material | First material | First host | First emitter | Buffer layer Material | Electron transport layer Material |
|---|---|---|---|---|---|---|---|---|
| Example 1 | HT01 | | R'01 | RI01 (-5.40) | Host1 (-4.80) | RD01 (-5.06) | BF03 | ET02 |
| Example 2 | HT01 | | R'02 | RI02 (-5.38) | Host1 (-4.80) | RD02 (-4.92) | BF04 | ET03 |
| Example 3 | HT02 | | R'03 | RI01 (-5.40) | Host1 (-4.80) | RD03 (-4.95) | BF01 | ET01 |
| Example 4 | HT02 | | R'04 | RI03 (-5.38) | Host2 (-4.83) | RD03 (-4.95) | BF02 | ET01 |
| Example 5 | HT03 | | R'05 | RI03 (-5.38) | Host2 (-4.83) | RD04 (-4.95) | BF05 | ET04 |
| Example 6 | HT04 | | R'06 | RI03 (-5.38) | Host3 (-4.87) | RD02 (-4.92) | BF06 | ET05 |
| Example 7 | HT05 | | R'07 | RI07 (-5.35) | Host3 (-4.87) | RD03 (-4.95) | BF07 | ET01 |
| Example 8 | HT05 | | R'01 | RI08 (-5.34) | Host4 (-4.84) | RD03 (-4.95) | BF08 | ET01 |
| Example 9 | HT06 | | R'02 | RI09 (-5.34) | Host4 (-4.84) | RD01 (-5.06) | BF09 | ET07 |
| Example 10 | HT07 | | R'09 | RI07 (-5.35) | Host4 (-4.84) | RD02 (-4.92) | BF10 | ET01 |
| Comparative Example 1 | R-HT | | R-R' | R-RI (-4.63) | R-Host (-5.06) | R-RD (-5.21) | R-BF | R-ET |
| Comparative Example 2 | 2-TNA TA | N P B | 1-9 (-5.13) | 1-5 (-5.14) | CBP (-5.59) | Ir(piq)2 (acac) (-4.93) | BAlq | Bebq₂ |

**Table 11**

| | Driving voltage (V) | Maximum power efficiency (cd/W) | Maximum emission wavelength (nm) |
|---|---|---|---|
| Example 1 | 3.11 | 19.69 | 614 |
| Example 2 | 3.18 | 19.69 | 623 |
| Example 3 | 3.20 | 19.66 | 615 |
| Example 4 | 3.28 | 19.44 | 615 |
| Example 5 | 3.07 | 19.44 | 629 |
| Example 6 | 3.01 | 19.37 | 623 |
| Example 7 | 3.10 | 19.33 | 615 |
| Example 8 | 3.21 | 19.24 | 615 |
| Example 9 | 3.28 | 19.21 | 614 |
| Example 10 | 3.17 | 19.17 | 623 |
| Comparative Example 1 | 3.27 | 15.33 | 603 |
| Comparative Example 2 | 3.82 | 12.85 | 613 |

From Table 11, it can be seen that the driving voltage and maximum power efficiency of each of Examples 1 to 10 are improved compared to the driving voltage and maximum power efficiency of Comparative Examples 1 and 2.

Because the light-emitting device has relatively a low driving voltage and high power efficiency, high-quality electronic devices and electronic apparatuses may (each) be manufactured utilizing the light-emitting device.

In the present disclosure, it will be understood that the terms "comprise(s)," "include(s)," or "have/has" specify the presence of stated features, integers, steps, operations, elements, and/or components, but do not preclude the presence or addition of one or more other features, integers, steps, operations, elements, components, and/or groups thereof.

Throughout the present disclosure, when a component such as a layer, a film, a region, or a plate is mentioned to be placed "on" another component, it will be understood that it may be directly on another component or that another component may be interposed therebetween. In some embodiments, "directly on" may refer to that there are no additional layers, films, regions, plates, etc., between a layer, a film, a region, a plate, etc. and the other part. For example, "directly on" may refer to two layers or two members are disposed without utilizing an additional member such as an adhesive member therebetween.

In the present disclosure, although the terms "first," "second," etc., may be utilized herein to describe one or more elements, components, regions, and/or layers, these elements, components, regions, and/or layers should not be limited by these terms. These terms are only utilized to distinguish one component from another component.

As utilized herein, the singular forms "a," "an," "one," and "the" are intended to include the plural forms as well, unless the context clearly indicates otherwise. Further, the use of "may" when describing embodiments of the present disclosure refers to "one or more embodiments of the present disclosure".

As utilized herein, the terms "substantially," "about," or similar terms are used as terms of approximation and not as terms of degree, and are intended to account for the inherent deviations in measured or calculated values that would be recognized by those of ordinary skill in the art. "About" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in the present disclosure is intended to include all higher numerical limitations subsumed therein.

The light-emitting device, the light-emitting apparatus, the display device, the electronic apparatus, the electronic equipment, or any other relevant devices or components according to embodiments of the present invention described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present invention.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the drawings, it will be understood by those of ordinary skill in the art that one or more suitable changes in form and details may be made therein without departing from the scope as defined by the following appended claims.

## Claims

1. A light-emitting device (10) comprising:
a first electrode (110);
a second electrode (150) facing the first electrode (110); and
an interlayer (130) between the first electrode (110) and the second electrode (150), wherein:
the interlayer (130) comprises a hole transport region and an emission layer,
the hole transport region is between the first electrode (110) and the emission layer,
the hole transport region comprises a first layer,
the first layer is in direct contact with the emission layer,
the emission layer comprises a first host and a first emitter,
the first emitter is to emit first light having a first emission spectrum,
a peak emission wavelength of the first light is about 610 nm to about 720 nm
as obtained from an emission spectrum of a film including the first emitter, wherein polymethyl methacrylate (PMMA) and the first emitter (4 wt% in relative to PMMA) were mixed in CH₂Cl₂ solution, and the resultant mixture was applied to a quartz substrate by utilizing a spin coater followed by heat treatment in an oven at a temperature of 80 °C and cooling to room temperature, so as to prepare a film of the first emitter having a thickness of 40 nm,
the first layer comprises a first material,
an absolute value of a highest occupied molecular orbital, HOMO, energy level of the first material is greater than an absolute value of a HOMO energy level of the first host,
an absolute value of a HOMO energy level of the first emitter is greater than the absolute value of the HOMO energy level of the first host, and
the HOMO energy level of each of the first material, the first host and the first emitter is measured by cyclic voltammetry and is a negative value,
wherein the HOMO energy level of the first emitter is about -5.26 eV to about - 4.72 eV,
whereby the HOMO energy level was evaluated as follows:
HOMO energy level evaluation method: By utilizing cyclic voltammetry (CV) (electrolyte: 0.1 M Bu₄NPF₆ / solvent: dimethylformamide (DMF) / electrode: 3-electrode system (working electrode: glassy carbon (GC), reference electrode: Ag/AgCl, and auxiliary electrode: Pt)), the potential (V)-current (A) graph of each compound was obtained, and then, from the oxidation onset of the graph, the HOMO energy level of each compound was calculated.

2. The light-emitting device (10) of claim 1, wherein
an absolute value of a difference between the HOMO energy level of the first material and the HOMO energy level of the first host is about 0.01 eV to about 0.7 eV, and/or,
the HOMO energy level of the first material is about -5.60 eV to about -5.15 eV.

3. The light-emitting device (10) of at least one of claims 1 to 2, wherein
an absolute value of a lowest unoccupied molecular orbital, LUMO, energy level of the first material is smaller than an absolute value of a LUMO energy level of the first host, and
the LUMO energy level of each of the first material and the first host is measured by cyclic voltammetry and is a negative value,
whereby the LUMO energy level was evaluated as follows:
LUMO energy level evaluation method: By utilizing cyclic voltammetry (CV) (electrolyte: 0.1 M Bu₄NPF₆ / solvent: dimethylformamide (DMF) / electrode: 3-electrode system (working electrode: glassy carbon (GC), reference electrode: Ag/AgCl, and auxiliary electrode: Pt)), the potential (V)-current (A) graph of each compound was obtained, and then, from the reduction onset of the graph, the LUMO energy level of each compound was calculated.

4. The light-emitting device (10) of claim 3, wherein
the LUMO energy level of the first material is about -2.40 eV to about -1.00 eV.

5. The light-emitting device (10) of at least one of claims 1 to 4, wherein
the HOMO energy level of the first host is about -5.07 eV to about -4.60 eV.

6. The light-emitting device (10) of at least one of claims 1 to 5, wherein
the hole transport region further comprises a second layer and a third layer,
the second layer is between the first electrode (110) and the first layer,
the third layer is between the first electrode (110) and the second layer,
the second layer comprises a second material,
the third layer comprises a third material, and
the first material, the second material, and the third material are different from each other.

7. The light-emitting device (10) of claim 6, wherein
a condition of a HOMO energy level of the third material > a HOMO energy level of the second material > the HOMO energy level of the first material, or
a condition of the HOMO energy level of the third material > the HOMO energy level of the first material > the HOMO energy level of the second material,
is satisfied, and
wherein the HOMO energy level of each of the second material and the third material is measured by cyclic voltammetry and is a negative value.

8. The light-emitting device (10) of at least one of claims 1 to 7, wherein
a full width at half maximum of the first light is about 15 nm to about 90 nm.

9. The light-emitting device (10) of at least one of claims 1 to 8, further comprising
at least one layer of: a first capping layer located outside the first electrode (110); or a second capping layer located outside the second electrode (150), wherein
the at least one layer comprises a material having a refractive index of 1.6 or more at a wavelength of 589 nm, preferably,
the at least one layer comprises a material having a refractive index of 1.8 or more at a wavelength of 589 nm.

10. The light-emitting device (10) of at least one of claims 1 to 9, wherein
the first emitter is an organometallic compound containing a transition metal,
the transition metal is iridium,
the first emitter comprises a first ligand, a second ligand, and a third ligand, each of which is bonded to the iridium,
the first ligand is a bidentate ligand comprising Y₁-containing ring B₁ and Y₂-containing ring B₂,
the second ligand is a bidentate ligand comprising Y₃-containing ring B₃ and Y₄-containing ring B₄ or is a bidentate ligand bonded to iridium through two oxygens,
the third ligand is a bidentate ligand comprising Y₅-containing ring B₅ and Y₆-containing ring B₆,
each of Y₁, Y₃, and Y₅ is nitrogen, N,
each of Y₂, Y₄, and Y₆ is carbon, C, and
at least one of the Y₁-containing ring B₁ or the Y₅-containing ring B₅ is a polycyclic group in which three or more cyclic groups are condensed with each other.

11. The light-emitting device (10) of claim 10, wherein
at least one of the Y₁-containing ring B₁ or the Y₅-containing ring B₅ is a benzoquinoline group, a benzoisoquinoline group, a naphthoquinoline group, or a naphthoisoquinoline group, and/or
the third ligand is the same as the first ligand, and/or,
the first emitter comprises a fluoro group, deuterium, or a combination thereof.

12. An electronic device (10) or electronic apparatus (1) comprising the light-emitting device (10) of at least one of claims 1 to 11.

13. The electronic device (10) of claim 12, further comprising
a color filter, a color conversion layer, a touch screen layer, a polarizing layer, or one or more combinations thereof.

14. The electronic apparatus (1) of claim 12 comprising the light-emitting device (10) of claim 13.

15. The electronic apparatus (1) of claim 14, further comprising
at least one of a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant, PDA, a wearable device, a laptop computer, a digital camera, a camcorder, a viewfinder, a micro display, a three-dimensional display, a virtual reality or augmented reality display, a vehicle, a video wall with multiple displays tiled together, a theater or stadium screen, a phototherapy device, or a signboard.

## Patentansprüche

1. Lichtemittierende Vorrichtung (10), umfassend:
eine erste Elektrode (110);
eine zweite Elektrode (150), die der ersten Elektrode (110) gegenüberliegt; und
eine Zwischenschicht (130) zwischen der ersten Elektrode (110) und der zweiten Elektrode (150), wobei:
die Zwischenschicht (130) einen Lochtransportbereich und eine Emissionsschicht umfasst,
sich der Lochtransportbereich zwischen der ersten Elektrode (110) und der Emissionsschicht befindet,
der Lochtransportbereich eine erste Schicht umfasst,
die erste Schicht in direktem Kontakt mit der Emissionsschicht steht,
die Emissionsschicht einen ersten Host und einen ersten Emitter umfasst,
der erste Emitter dazu dient, erstes Licht mit einem ersten Emissionsspektrum zu emittieren,
eine Spitzenemissionswellenlänge des ersten Lichts etwa 610 nm bis etwa 720 nm beträgt, wie aus einem Emissionsspektrum eines Films erhalten, der den ersten Emitter enthält,
wobei Polymethylmethacrylat (PMMA) und der erste Emitter (4 Gew.-% bezogen auf PMMA) in einer CH₂Cl₂-Lösung gemischt wurden und die resultierende Mischung unter Verwendung eines Spin-Coaters auf ein Quarzsubstrat aufgebracht wurde, gefolgt von einer Wärmebehandlung in einem Ofen bei einer Temperatur von 80 °C und einer Abkühlung auf Raumtemperatur, um einen Film des ersten Emitters mit einer Dicke von 40 nm herzustellen,
die erste Schicht ein erstes Material umfasst,
ein Absolutwert eines Energieniveaus des höchsten besetzten Molekülorbitals, HOMO, des ersten Materials größer ist als ein Absolutwert eines HOMO-Energieniveaus des ersten Hosts,
ein Absolutwert eines HOMO-Energieniveaus des ersten Emitters größer ist als der Absolutwert des HOMO-Energieniveaus des ersten Hosts, und
das HOMO-Energieniveau von jedem aus dem ersten Material, dem ersten Host und dem ersten Emitter mittels zyklischer Voltammetrie gemessen wird und ein negativer Wert ist,
wobei das HOMO-Energieniveau des ersten Emitters etwa -5,26 eV bis etwa - 4,72 eV beträgt,
wobei das HOMO-Energieniveau wie folgt ermittelt wurde:
Verfahren zur Ermittlung des HOMO-Energieniveaus: unter Verwendung der zyklischen Voltammetrie (CV) (Elektrolyt: 0,1 M Bu₄NPF₆ / Lösungsmittel: Dimethylformamid (DMF) / Elektrode: 3-Elektrodensystem (Arbeitselektrode: Glaskohlenstoff (GC), Referenzelektrode: Ag/AgCl und Hilfselektrode: Pt)) wurde das Potential-(V)-Strom-(A)-Diagramm jeder Verbindung erhalten; und anschließend wurde ausgehend vom Oxidationsbeginn des Diagramms das HOMO-Energieniveau jeder Verbindung berechnet.

2. Lichtemittierende Vorrichtung (10) nach Anspruch 1, wobei
ein Absolutwert einer Differenz zwischen dem HOMO-Energieniveau des ersten Materials und dem HOMO-Energieniveau des ersten Hosts etwa 0,01 eV bis etwa 0,7 eV beträgt und/oder
das HOMO-Energieniveau des ersten Materials etwa -5,60 eV bis etwa -5,15 eV beträgt.

3. Lichtemittierende Vorrichtung (10) nach mindestens einem der Ansprüche 1 bis 2, wobei
ein Absolutwert eines Energieniveaus des tiefsten unbesetzten Molekülorbitals, LUMO, des ersten Materials kleiner ist als ein Absolutwert eines LUMO-Energieniveaus des ersten Hosts, und
das LUMO-Energieniveau von jedem aus dem ersten Material und dem ersten Host mittels zyklischer Voltammetrie gemessen wird und ein negativer Wert ist, wobei das LUMO-Energieniveau wie folgt ermittelt wurde:
Verfahren zur Ermittlung des LUMO-Energieniveaus: unter Verwendung der zyklischen Voltammetrie (CV) (Elektrolyt: 0,1 M Bu₄NPF₆ / Lösungsmittel: Dimethylformamid (DMF) / Elektrode: 3-Elektrodensystem (Arbeitselektrode: Glaskohlenstoff (GC), Referenzelektrode: Ag/AgCl und Hilfselektrode: Pt)) wurde das Potential-(V)-Strom-(A)-Diagramm jeder Verbindung erhalten; und anschließend wurde ausgehend vom Reduktionsbeginn des Diagramms das LUMO-Energieniveau jeder Verbindung berechnet.

4. Lichtemittierende Vorrichtung (10) nach Anspruch 3, wobei das LUMO-Energieniveau des ersten Materials etwa -2,40 eV bis etwa -1,00 eV beträgt.

5. Lichtemittierende Vorrichtung (10) nach mindestens einem der Ansprüche 1 bis 4, wobei das HOMO-Energieniveau des ersten Hosts etwa -5,07 eV bis etwa - 4,60 eV beträgt.

6. Lichtemittierende Vorrichtung (10) nach mindestens einem der Ansprüche 1 bis 5, wobei
der Lochtransportbereich ferner eine zweite Schicht und eine dritte Schicht umfasst,
sich die zweite Schicht zwischen der ersten Elektrode (110) und der ersten Schicht befindet,
sich die dritte Schicht zwischen der ersten Elektrode (110) und der zweiten Schicht befindet,
die zweite Schicht ein zweites Material umfasst,
die dritte Schicht ein drittes Material umfasst und
das erste Material, das zweite Material und das dritte Material voneinander verschieden sind.

7. Lichtemittierende Vorrichtung (10) nach Anspruch 6, wobei
eine Bedingung, wonach ein HOMO-Energieniveau des dritten Materials > ein HOMO-Energieniveau des zweiten Materials > das HOMO-Energieniveau des ersten Materials, oder
eine Bedingung, wonach das HOMO-Energieniveau des dritten Materials > das HOMO-Energieniveau des ersten Materials > das HOMO-Energieniveau des zweiten Materials
erfüllt ist, und
wobei das HOMO-Energieniveau von jedem aus dem zweiten Material und dem dritten Material mittels zyklischer Voltammetrie gemessen wird und ein negativer Wert ist.

8. Lichtemittierende Vorrichtung (10) nach mindestens einem der Ansprüche 1 bis 7, wobei
eine Halbwertsbreite des ersten Lichts etwa 15 nm bis etwa 90 nm beträgt.

9. Lichtemittierende Vorrichtung (10) nach mindestens einem der Ansprüche 1 bis 8, ferner umfassend
mindestens eine Schicht aus: einer ersten Deckschicht, die außerhalb der ersten Elektrode (110) angeordnet ist; oder einer zweiten Deckschicht, die außerhalb der zweiten Elektrode (150) angeordnet ist, wobei
die mindestens eine Schicht ein Material mit einem Brechungsindex von 1,6 oder mehr bei einer Wellenlänge von 589 nm umfasst, vorzugsweise
die mindestens eine Schicht ein Material mit einem Brechungsindex von 1,8 oder mehr bei einer Wellenlänge von 589 nm umfasst.

10. Lichtemittierende Vorrichtung (10) nach mindestens einem der Ansprüche 1 bis 9, wobei
der erste Emitter eine metallorganische Verbindung ist, die ein Übergangsmetall enthält,
das Übergangsmetall Iridium ist,
der erste Emitter einen ersten Liganden, einen zweiten Liganden und einen dritten Liganden umfasst, von denen jeder an das Iridium gebunden ist,
der erste Ligand ein zweizähniger Ligand ist, der einen Y₁-haltigen Ring B₁ und einen Y₂-haltigen Ring B₂ umfasst,
der zweite Ligand ein zweizähniger Ligand ist, der einen Y₃-haltigen Ring B₃ und einen Y₄-haltigen Ring B₄ umfasst, oder ein zweizähniger Ligand ist, der durch zwei Sauerstoffatome an Iridium gebunden ist,
der dritte Ligand ein zweizähniger Ligand ist, der einen Y₅-haltigen Ring B₅ und einen Y₆-haltigen Ring B₆ umfasst,
jedes aus Y₁, Y₃ und Y₅ Stickstoff, N, ist,
jedes aus Y₂, Y₄ und Y₆ Kohlenstoff, C, ist und
mindestens einer aus dem Y₁-haltigen Ring B₁ oder dem Y₅-haltigen Ring B₅ eine polycyclische Gruppe ist, in der drei oder mehr cyclische Gruppen miteinander kondensiert sind.

11. Lichtemittierende Vorrichtung (10) nach Anspruch 10, wobei
mindestens einer aus dem Y₁-haltigen Ring B₁ oder dem Y₅-haltigen Ring B₅ eine Benzochinolin-Gruppe, eine Benzoisochinolin-Gruppe, eine Naphthochinolin-Gruppe oder eine Naphthoisochinolin-Gruppe ist, und/oder der dritte Ligand der gleiche ist wie der erste Ligand, und/oder
der erste Emitter eine Fluorgruppe, Deuterium oder eine Kombination davon umfasst.

12. Elektronische Vorrichtung (10) oder elektronisches Gerät (1), umfassend die lichtemittierende Vorrichtung (10) nach mindestens einem der Ansprüche 1 bis 11.

13. Elektronische Vorrichtung (10) nach Anspruch 12, ferner umfassend:
einen Farbfilter, eine Farbkonversionsschicht, eine Touchscreen-Schicht, eine Polarisationsschicht oder eine oder mehrere Kombinationen davon.

14. Elektronisches Gerät (1) nach Anspruch 12, umfassend die lichtemittierende Vorrichtung (10) nach Anspruch 13.

15. Elektronisches Gerät (1) nach Anspruch 14, ferner umfassend:
mindestens eines aus einem Flachbildschirm, einem gekrümmten Display, einem Computermonitor, einem medizinischen Monitor, einem Fernseher, einer Werbetafel, einer Innen- oder Außenbeleuchtung und/oder einer Signalleuchte, einem Head-up-Display, einem vollständig oder teilweise transparenten Display, einem flexiblen Display, einem aufrollbaren Display, einem faltbaren Display, einem dehnbaren Display, einem Laserdrucker, einem Telefon, einem Mobiltelefon, einem Tablet-PC, einem Phablet, einem Personal Digital Assistant, PDA, einem Wearable, einem Laptop-Computer, einer Digitalkamera, einem Camcorder, einem Sucher, einem Mikrodisplay, einem dreidimensionalen Display, einem Virtual-Reality- oder Augmented-Reality-Display, einem Fahrzeug, einer Videowand mit mehreren aneinandergefügten Displays, einer Kino- oder Stadionleinwand, einer Phototherapie-Vorrichtung oder einem Schild.

## Revendications

1. Dispositif électroluminescent (10) comprenant :
une première électrode (110) ;
une deuxième électrode (150) faisant face à la première électrode (110) ; et
une couche intermédiaire (130) entre la première électrode (110) et la deuxième électrode (150), dans lequel :
la couche intermédiaire (130) comprend une région de transport de trous et une couche d'émission,
la région de transport de trous est entre la première électrode (110) et la couche d'émission,
la région de transport de trous comprend une première couche,
la première couche est en contact direct avec la couche d'émission,
la couche d'émission comprend un premier hôte et un premier émetteur,
le premier émetteur est destiné à émettre une première lumière ayant un premier spectre d'émission,
une longueur d'onde d'émission maximale de la première lumière est d'environ 610 nm à environ 720 nm, telle qu'obtenue à partir d'un spectre d'émission d'un film incluant le premier émetteur,
dans lequel du polyméthacrylate de méthyle (PMMA) et le premier émetteur (4 % en poids par rapport au PMMA) ont été mélangés dans une solution de CH₂Cl₂, et le mélange résultant a été appliqué sur un substrat en quartz à l'aide d'un enduiseur par centrifugation, puis soumis à un traitement thermique dans un four à une température de 80 °C et refroidi à température ambiante, de façon à préparer un film du premier émetteur ayant une épaisseur de 40 nm,
la première couche comprend un premier matériau,
une valeur absolue d'un niveau d'énergie de l'orbitale moléculaire occupée de plus haute énergie, HOMO, du premier matériau est supérieure à une valeur absolue du niveau d'énergie HOMO du premier hôte,
une valeur absolue du niveau d'énergie HOMO du premier émetteur est supérieure à la valeur absolue du niveau d'énergie HOMO du premier hôte, et
le niveau d'énergie HOMO de chacun du premier matériau, du premier hôte et du premier émetteur est mesuré par voltamétrie cyclique et est une valeur négative,
dans lequel le niveau d'énergie HOMO du premier émetteur est d'environ - 5,26 eV à environ -4,72 eV,
moyennant quoi le niveau d'énergie HOMO a été évalué comme suit :
méthode d'évaluation de niveau d'énergie HOMO : en utilisant la voltamétrie cyclique (CV) (électrolyte : 0,1 M Bu₄NPF₆/solvant : diméthylformamide (DMF)/électrode : système à 3 électrodes (électrode de travail : carbone vitreux (GC), électrode de référence : Ag/AgCl, et électrode auxiliaire : Pt)), la courbe potentiel (V)-courant (A) de chaque composé a été obtenue, puis, à partir du début de l'oxydation sur la courbe, le niveau d'énergie HOMO de chaque composé a été calculé.

2. Dispositif électroluminescent (10) selon la revendication 1, dans lequel
une valeur absolue d'une différence entre le niveau d'énergie HOMO du premier matériau et le niveau d'énergie HOMO du premier hôte est d'environ 0,01 eV à environ 0,7 eV, et/ou,
le niveau d'énergie HOMO du premier matériau est d'environ -5,60 eV à environ -5,15 eV.

3. Dispositif électroluminescent (10) selon au moins l'une des revendications 1 et 2, dans lequel
une valeur absolue du niveau d'énergie de l'orbitale moléculaire inoccupée de plus basse énergie (LUMO) du premier matériau est inférieure à une valeur absolue d'un niveau d'énergie LUMO du premier hôte, et
le niveau d'énergie LUMO de chacun du premier matériau et du premier hôte est mesuré par voltamétrie cyclique et est une valeur négative,
moyennant quoi le niveau d'énergie LUMO a été évalué comme suit :
méthode d'évaluation de niveau d'énergie LUMO : en utilisant la voltamétrie cyclique (CV) (électrolyte : 0,1 M Bu₄NPF₆/solvant : diméthylformamide (DMF)/électrode : système à 3 électrodes (électrode de travail : carbone vitreux (GC), électrode de référence : Ag/AgCl, et électrode auxiliaire : Pt)), la courbe potentiel (V)-courant (A) de chaque composé a été obtenue, puis, à partir du début de la réduction sur la courbe, le niveau d'énergie LUMO de chaque composé a été calculé.

4. Dispositif électroluminescent (10) selon la revendication 3, dans lequel
le niveau d'énergie LUMO du premier matériau est d'environ -2,40 eV à environ - 1,00 eV.

5. Dispositif électroluminescent (10) selon au moins l'une des revendications 1 à 4, dans lequel le niveau d'énergie HOMO du premier hôte est d'environ -5,07 eV à environ -4,60 eV.

6. Dispositif électroluminescent (10) selon au moins l'une des revendications 1 à 5, dans lequel
la région de transport des trous comprend en outre une deuxième couche et une troisième couche,
la deuxième couche est entre la première électrode (110) et la première couche,
la troisième couche est entre la première électrode (110) et la deuxième couche,
la deuxième couche comprend un deuxième matériau,
la troisième couche comprend un troisième matériau, et
le premier matériau, le deuxième matériau et le troisième matériau sont différents les uns des autres.

7. Dispositif électroluminescent (10) selon la revendication 6, dans lequel
une condition selon laquelle un niveau d'énergie HOMO du troisième matériau > un niveau d'énergie HOMO du deuxième matériau > le niveau d'énergie HOMO du premier matériau, ou
une condition selon laquelle le niveau d'énergie HOMO du troisième matériau > le niveau d'énergie HOMO du premier matériau > le niveau d'énergie HOMO du deuxième matériau,
est satisfaite, et
dans lequel le niveau d'énergie HOMO de chacun du deuxième matériau et du troisième matériau est mesuré par voltamétrie cyclique et est une valeur négative.

8. Dispositif électroluminescent (10) selon au moins l'une des revendications 1 à 7, dans lequel
une largeur à mi-hauteur de la première lumière est d'environ 15 nm à environ 90 nm.

9. Dispositif électroluminescent (10) selon au moins l'une des revendications 1 à 8, comprenant en outre
au moins une couche parmi : une première couche de coiffage située à l'extérieur de la première électrode (110) ; ou une deuxième couche de coiffage située à l'extérieur de la deuxième électrode (150), dans lequel
l'au moins une couche comprend un matériau ayant un indice de réfraction de 1,6 ou plus à une longueur d'onde de 589 nm, de préférence,
l'au moins une couche comprend un matériau ayant un indice de réfraction de 1,8 ou plus à une longueur d'onde de 589 nm.

10. Dispositif électroluminescent (10) selon au moins l'une des revendications 1 à 9, dans lequel
le premier émetteur est un composé organométallique contenant un métal de transition,
le métal de transition est l'iridium,
le premier émetteur comprend un premier ligand, un deuxième ligand et un troisième ligand, dont chacun est lié à l'iridium,
le premier ligand est un ligand bidentate comprenant un cycle B₁ contenant Y₁ et un cycle B₂ contenant Y₂,
le deuxième ligand est un ligand bidentate comprenant un cycle B₃ contenant Y₃ et un cycle B₄ contenant Y₄, ou est un ligand bidentate lié à l'iridium par l'intermédiaire de deux oxygènes,
le troisième ligand est un ligand bidentate comprenant un cycle B₅ contenant Y₅ et un cycle B₆ contenant Y₆,
chacun de Y₁, Y₃ et Y₅ est un azote, N,
chacun de Y₂, Y₄ et Y₆ est un carbone, C, et
au moins l'un parmi le cycle B₁ contenant Y₁ ou le cycle B₅ contenant Y₅ est un groupe polycyclique dans lequel trois groupes cycliques ou plus sont condensés les uns aux autres.

11. Dispositif électroluminescent (10) selon la revendication 10, dans lequel
au moins l'un parmi le cycle B₁ contenant Y₁ ou le cycle B₅ contenant Y₅ est un groupe benzoquinoléine, un groupe benzoisoquinoléine, un groupe naphtoquinoléine ou un groupe naphtoisoquinoléine, et/ou
le troisième ligand est identique au premier ligand, et/ou,
le premier émetteur comprend un groupe fluoro, du deutérium ou leur combinaison.

12. Dispositif électronique (10) ou appareil électronique (1) comprenant le dispositif électroluminescent (10) d'au moins l'une des revendications 1 à 11.

13. Dispositif électronique (10) selon la revendication 12, comprenant en outre
un filtre coloré, une couche de conversion de couleur, une couche d'écran tactile, une couche polarisante, ou une ou plusieurs de leurs combinaisons.

14. Appareil électronique (1) selon la revendication 12, comprenant le dispositif électroluminescent (10) de la revendication 13.

15. Appareil électronique (1) selon la revendication 14, comprenant en outre
au moins l'un des éléments suivants : un afficheur à écran plat, un afficheur incurvé, un moniteur d'ordinateur, un moniteur médical, un téléviseur, un panneau publicitaire, un éclairage intérieur ou extérieur et/ou un éclairage de signalisation, un afficheur tête haute, un afficheur entièrement ou partiellement transparent, un afficheur flexible, un afficheur enroulable, un afficheur pliable, un afficheur extensible, une imprimante laser, un téléphone, un téléphone portable, un ordinateur personnel de type tablette, une phablette, un assistant numérique personnel (PDA), un dispositif habitronique, un ordinateur portable, un appareil photo numérique, un caméscope, un viseur, un microafficheur, un afficheur tridimensionnel, un afficheur de réalité virtuelle ou de réalité augmentée, un véhicule, un mur d'images constitué de plusieurs afficheurs juxtaposés, un écran de cinéma ou de stade, un dispositif de photothérapie ou un panneau d'affichage.
